# EUROPEAN PATENT APPLICATION

(11) **EP 4 779 406 A1**
(43) Date of publication of application: **22.07.2026**
(21) Application number: 26152519.0
(22) Date of filing: 19.01.2026
(51) Int. Cl.: G03F 7/075, G03F 7/09

(54) **SILICON-CONTAINING COMPOSITION AND PATTERNING PROCESS**

(30) Priority: 20.01.2025 JP 2025008089
(71) Applicant: SHIN-ETSU CHEMICAL CO., LTD., Tokyo 100-0005 (JP)
(72) Inventor: Harada, Yuji, Niigata (JP); Tachibana, Seiichiro, Niigata (JP); Satoh, Hironori, Niigata (JP); Mashita, Takato, Niigata (JP)
(74) Representative: Schicker, Silvia

(57) **Abstract**

The present invention is a silicon-containing composition, containing: (A) a thermosetting silicon-containing resin having a weight-average molecular weight of 1,000 to 3,000; (B) a polymer having one or both of repeating units represented by the following general formulae (1) and (2); and (C) a solvent. This can provide: a silicon-containing composition excellent in properties of forming a film in and filling a pattern of a stepped substrate; and a patterning process using the silicon-containing composition. The present invention can also provide a silicon-containing composition that can minimize the effect on the human body and the environment by the use of a surfactant to which the PFAS regulations of the European REACH do not apply.

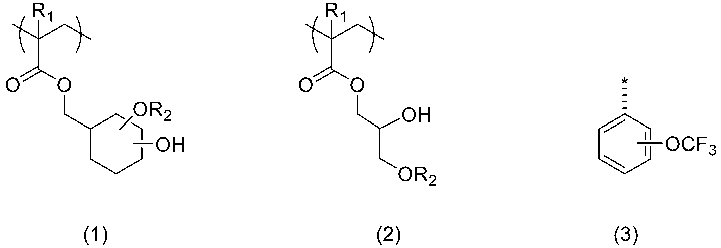

## Description

### TECHNICAL FIELD

The present invention relates to: a silicon-containing composition; and a patterning process using the composition.

### BACKGROUND ART

Recently, along with advancements toward higher integration and higher processing speed of semiconductor devices, a finer pattern rule has been required.

In fine processing which is a commonly-employed technique at present, a photoresist film is subjected to exposure via a mask followed by development, and a substrate to be processed is etched while using the obtained resist pattern. In this event, a g-line (436 nm) or an i-line (365 nm) of a mercury lamp, a KrF excimer laser (248 nm), or an ArF excimer laser (193 nm) is used as a light source, and furthermore, in the most-advanced generation, extreme ultraviolet ray (EUV, 13.5 nm) has been put to practical use.

In association with the thinning of resist patterns, the ratio of a pattern height to a pattern line width (aspect ratio) is increased, causing pattern collapse due to the surface tension of a developer during development, and this is regarded as a problem. To resolve this problem, a multilayer resist method, in which a pattern is formed by laminating films having different dry etching properties, has been developed.

As multilayer resist methods, there have been developed: a two-layer resist method in which a photoresist layer constituted by a silicon-containing photosensitive polymer is combined with an underlayer made of an organic polymer containing carbon, hydrogen, and oxygen as main constituent elements (e. g., a novolak polymer) (Patent Document 1); and a three-layer resist method in which a photoresist layer made of an organic photosensitive polymer used in a monolayer resist method is combined with a middle layer made of a silicon-based polymer or a silicon-based CVD film, and an underlayer made of an organic polymer (Patent Document 2).

In a three-layer resist method, a resist underlayer film (e. g., an organic film made of a novolak or the like) is formed uniformly on a substrate to be processed; a silicon-containing film is formed thereon as a resist middle layer film; an ordinary organic photoresist film is formed thereon as a resist upper layer film; and a resist pattern is formed by exposure.

In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma.

Meanwhile, in dry etching using an oxygen-based gas plasma, an organic resist underlayer film has favorable etching selectivity to a silicon-containing resist middle layer film, and therefore, a pattern of the silicon-containing resist middle layer film is transferred to the organic resist underlayer film by dry etching using an oxygen-based gas plasma.

According to this method, it is possible to obtain a pattern of an organic resist underlayer film having sufficient dry etching resistance for substrate processing, even when using a resist composition that causes difficulties in forming a pattern having a sufficient film thickness for directly processing the substrate to be processed or when using a resist composition that does not have sufficient dry etching resistance for processing the substrate.

In addition, as a technique for the fine processing of a substrate, there have been developed techniques that employ reverse patterning processes fully using lithography and etching (Patent Documents 3 and 4). In such a method, firstly, an antireflective film and a resist film are formed on a film to be processed, and then a resist pattern is formed by exposure, followed by development. Subsequently, an insulator film is formed by applying an insulator film material to the opening, and then baking. After that, the coating-type insulator film except in the opening is removed, and the resist and the antireflective film are removed. Thus, a pattern of the coating-type insulator film is formed in the predetermined region. Then, the film to be processed is processed while using the pattern of the coating-type insulator film as a mask.

In the above-described processing, surfactants make a great contribution from the viewpoint of ensuring coatability of insulator film materials. Generally, a surfactant containing an organic group having a substituent which is a fluorine atom exemplified by a perfluoroalkyl group is often applied for exerting the surface active effect of the surfactant sufficiently. However, in recent years, it has been pointed out that perfluoroalkyl-group-containing compounds (PFAS) have an adverse effect on the human body and the environment, and there is a movement in the European REACH to restrict the production and sale of PFAS compounds. Accordingly, there have been proposed surfactants having a trifluoromethoxy group, which has a structure to which the regulations do not apply, or a pentafluorosulfanyl group, which does not have a PFAS structure (Patent Document 5).

### CITATION LIST

### PATENT LITERATURE

Patent Document 1: JPH6-118651A
Patent Document 2: JP2005-128509A
Patent Document 3: JP2002-110510A
Patent Document 4: JP2004-363371A
Patent Document 5: JP2008-526792A

### SUMMARY OF INVENTION

### TECHNICAL PROBLEM

The present invention has been made in view of the above-described circumstances. An object of the present invention is to provide: a silicon-containing composition excellent in properties of forming a film in and filling a pattern of a stepped substrate; and a patterning process using the silicon-containing composition. In addition, an object of the present invention is to provide a silicon-containing composition that can minimize the effect on the human body and the environment by the use of a surfactant to which the PFAS regulations of the European REACH do not apply.

### SOLUTION TO PROBLEM

To achieve the object, the present invention provides a silicon-containing composition, comprising:
(A) a thermosetting silicon-containing resin having a weight-average molecular weight of 1,000 to 3,000; (B) a polymer having one or both of repeating units represented by the following general formulae (1) and (2); and (C) a solvent, 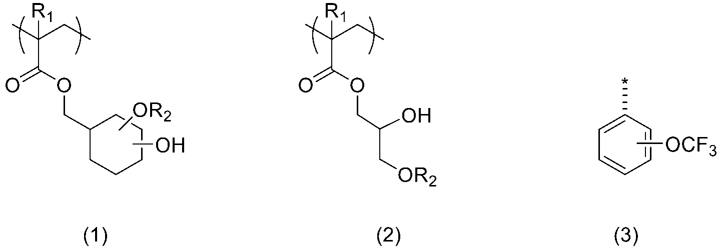
   wherein in the formula (1), R₁ represents a hydrogen atom or a methyl group, R₂ represents a saturated or unsaturated monovalent organic group having 2 to 50 carbon atoms and has at least one benzene ring structure represented by the formula (3) containing a trifluoromethoxy group as a substituent, and the substituents OR₂ and OH group on the cyclohexane ring are on adjacent carbon atoms on the cyclohexane ring,
   in the formula (2), R₁ represents a hydrogen atom or a methyl group, and R₂ represents a saturated or unsaturated monovalent organic group having 2 to 50 carbon atoms and has at least one benzene ring structure represented by the formula (3) including a trifluoromethoxy group as a substituent, and
   the formula (3) is a partial structure contained in the R₂ and optionally contains a substituent besides the trifluoromethoxy group, "*" represents an attachment point in a structure in the R₂, and two or more kinds of structures represented by the formula (3) or two or more identical structures represented by the formula (3) are optionally contained in the R₂.

When a silicon-containing composition containing (B) a polymer having one or both of repeating units represented by the general formulae (1) and (2) is applied, it is possible to impart the surface active effect necessary when forming a silicon-containing film, and film-formability at the time of application can be improved. Moreover, the trifluoromethoxybenzene structure represented by the formula (3) does not belong to the category of PFAS in the European REACH, and therefore, is also advantageous from the viewpoint of preventing environmental pollution.

In the above-described silicon-containing composition, the R₂ in the general formulae (1) and (2) preferably contains any of structures represented by the following formulae (4), 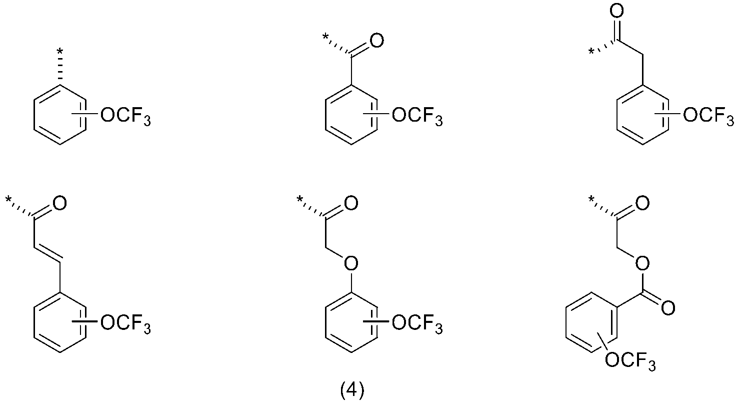 wherein "*" and a broken line represent an attachment point in a structure in the R₂.

In a polymer including such a structure (hereinafter, referred to as a polymer (B1)), the trifluoromethoxybenzene structure is introduced in a position separated from the main chain by a linker of a few carbon atoms. An agglomerate structure is easily formed by the interaction between the trifluoromethoxy group and the benzene ring, and behavior as a hydrophobic group is emphasized. As a result, an excellent surface active effect can be exhibited, and film-formability when the silicon-containing composition is applied can be improved.

Furthermore, (B) the polymer is preferably a copolymer (B2) having repeating units of one or both of the general formulae (1) and (2) and the following (5), 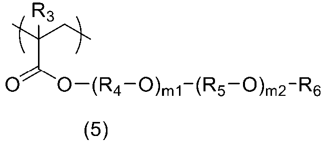 wherein R₃ represents a hydrogen atom or a methyl group; R₄ and R₅ each represent a linear or branched divalent alkylene group having 1 to 4 carbon atoms; R₆ represents a hydrogen atom, an alkyl group having 1 to 4 carbon atoms, or a phenyl group; and "m1" and "m2" each represent an integer of 0 to 23 and satisfy 23 ≥ m1+m2 ≥ 2.

Such a polymer (B2) is a copolymer having a linking group in the repeating unit (5), and the surface activating ability can be adjusted by the repeating unit contributing as an appropriate alleviation unit of the agglomerate structure. Therefore, it is possible to provide a silicon-containing composition adapted to various film thicknesses (not dependent on the solution concentration) and having both filling property and film-formability.

(B) the polymer preferably has a weight-average molecular weight of 1,500 to 30,000.

When the weight-average molecular weight is in such a range, it is possible to form a silicon-containing film excellent in film-formability and filling property. Furthermore, the contact angle on the surface of a film after film formation can be controlled to be in an appropriate range, and it is possible to form a silicon-containing film suitable for use in a reverse patterning process or a nanoimprinting process.

A weight percentage of (B) the polymer relative to (A) the thermosetting silicon-containing resin is preferably 0.01 to 2%.

When (B) the polymer is contained in such an amount, it is possible to obtain a silicon-containing film excellent in in-plane uniformity after film formation.

The inventive silicon-containing composition preferably further comprises (D) a curing catalyst.

When the silicon-containing composition contains (D) the curing catalyst, the formation of siloxane bonds can be promoted when the thermosetting silicon-containing resin cures. Thus, a dense silicon-containing film that is densely crosslinked can be formed efficiently.

The inventive silicon-containing composition can further comprise (E) an organic compound having a boiling point of 150°C or higher.

When the silicon-containing composition contains (E) the organic compound having a boiling point of 150°C or higher, sufficient thermal flowability can be achieved at the time of film formation with the silicon-containing composition, and a silicon-containing film excellent in filling and planarizing properties can be formed. At the same time, the organic compound does not remain in the film after baking, and there is no risk of adversely affecting the physical properties of the film.

A weight percentage of (E) the organic compound having a boiling point of 150°C or higher relative to (A) the thermosetting silicon-containing resin is preferably 50 to 300%.

When the silicon-containing composition contains (E) the organic compound having a boiling point of 150°C or higher in such an amount, sufficient thermal flowability can be achieved at the time of film formation with the silicon-containing composition, and a silicon-containing film excellent in filling and planarizing properties can be formed.

In the inventive silicon-containing composition, (C) the solvent may contain water.

When water is contained, the electric charge of the silanol groups in the thermosetting silicon-containing resin is stabilized, and it is possible to suppress the condensation reaction of silanol groups. As a result, reactions, such as gelation, and change in performance can be suppressed from production until actual use, and a silicon-containing composition having favorable storage stability can be provided.

Furthermore, the present invention provides a patterning process comprising the steps of:
(I) forming an organic underlayer film on a body to be processed;
(II) forming a silicon-containing resist middle layer film on the organic underlayer film by using a composition for forming a silicon-containing resist middle layer film;
(III) forming a resist upper layer film on the silicon-containing resist middle layer film by using a resist upper layer film composition comprising a photoresist composition;
(IV) forming a circuit pattern in the resist upper layer film;
(V) transferring the pattern to the silicon-containing resist middle layer film by etching while using the resist upper layer film having the formed circuit pattern as a mask;
(VI) transferring the pattern to the organic underlayer film by etching while using the silicon-containing resist middle layer film having the transferred pattern as a mask;
(VII) coating and filling the organic underlayer film having the transferred pattern by using the above-described silicon-containing composition; and
(VIII) removing unnecessary portions from a silicon-containing film formed in the step (VII), and then removing the organic underlayer film by etching to form a silicon-containing pattern.

The inventive silicon-containing composition can be used suitably for such a reverse patterning process according to a multilayer resist process. Moreover, it is possible to form, on a body to be processed, a fine pattern that is difficult to form by an ordinary lithography process, and as a result, a fine pattern can be transferred to a body to be processed.

Furthermore, the present invention provides a patterning process comprising the steps of:
(I) forming an organic underlayer film on a body to be processed;
(II) forming a silicon-containing resist middle layer film on the organic underlayer film by using a CVD method;
(III) forming a resist upper layer film by using a resist upper layer film composition comprising a photoresist composition applied to the silicon-containing resist middle layer film;
(IV) forming a circuit pattern in the resist upper layer film;
(V) transferring the pattern to the silicon-containing resist middle layer film by etching while using the resist upper layer film having the formed circuit pattern as a mask;
(VI) transferring the pattern to the organic underlayer film by dry etching while using the silicon-containing resist middle layer film having the transferred pattern as a mask;
(VII) coating and filling the organic underlayer film having the transferred pattern by using the above-described silicon-containing composition; and
(VIII) removing unnecessary portions from a silicon-containing film formed in the step (VII), and then removing the organic underlayer film by etching to form a silicon-containing pattern.

The inventive silicon-containing composition can be used suitably for a multilayer resist process in which a middle layer film is formed using a CVD method.

Furthermore, the present invention provides a patterning process comprising the steps of:
(I) coating and filling a pattern of a body to be processed covered with a metal nitride film by using the above-described silicon-containing composition;
(II) partially removing unnecessary portions from a silicon-containing film formed in the step (I);
(III) processing the body to be processed covered with the metal nitride film while using the silicon-containing film remaining as a mask; and
(IV) removing the silicon-containing film remaining after substrate processing.

The inventive silicon-containing composition can be used suitably for a patterning process to which such a metal nitride film is applied.

The present invention provides a patterning process comprising the steps of:
(I) forming a pattern of an organic film by a nanoimprinting method on a body to be processed;
(II) coating and filling the organic film having the pattern transferred by using the above-described silicon-containing composition;
(III) removing unnecessary portions from a silicon-containing film formed in the step (II); and
(IV) removing the organic film by etching to form a silicon-containing pattern on the body to be processed.

The inventive silicon-containing composition can be used suitably for such a reverse patterning process according to a nanoimprinting method.

Furthermore, the body to be processed can be a semiconductor device substrate, a metal film, a metal carbide film, a metal oxide film, a metal nitride film, a metal oxycarbide film, or a metal oxynitride film.

In the inventive patterning processes, it is preferable to use such a body to be processed.

Furthermore, the metal constituting the body to be processed can be silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

As the metal constituting the body to be processed, it is preferable to use such metal.

Furthermore, the present invention provides the patterning process, wherein, in the step of forming the pattern in the resist upper layer film, the pattern is formed by using a lithography using light having a wavelength of 10 nm or more and 300 nm or less, a direct writing with electron beam, nanoimprinting, or a combination thereof.

In the present invention, such a patterning process can be used.

### ADVANTAGEOUS EFFECTS OF INVENTION

As described above, the inventive silicon-containing composition is excellent in properties of forming a film in and filling a pattern of a stepped substrate. Furthermore, according to a patterning process using the inventive silicon-containing composition, it is possible to form, on a body to be processed, a fine pattern that is difficult to form by an ordinary lithography process. Furthermore, the silicon-containing composition contains a surfactant to which the PFAS regulations of the European REACH do not apply, and therefore, it is also possible to minimize the effect on the human body and the environment.

### BRIEF DESCRIPTION OF DRAWINGS

FIG. 1 is a flow diagram of a reverse patterning process, being a first embodiment of the present invention, according to a multilayer resist process.
FIG. 2 is a flow diagram of a first step (Ia), in which a pattern of an organic underlayer film is formed on a body to be processed, out of the reverse patterning process, being the first embodiment of the present invention, according to a multilayer resist process.
FIG. 3 is a flow diagram of a patterning process, being a second embodiment of the present invention, where a metal nitride film is applied.
FIG. 4 is a flow diagram of a reverse patterning process, being a third embodiment of the present invention, according to a nanoimprinting method.
FIG. 5 is a flow diagram of a first step (Ic), in which a pattern of an organic film is formed by a nanoimprinting method on a body to be processed, out of the reverse patterning process, being the third embodiment of the present invention, according to a nanoimprinting method.

### DESCRIPTION OF EMBODIMENTS

As stated above, there have been demands for the development of a silicon-containing composition and a patterning process that allow excellent properties of forming a film in and filling a pattern of a stepped substrate.

The present inventors have studied earnestly the above-described problems and found out that a silicon-containing composition containing the following components (A) to (C) can solve the problems, and completed the present invention.

That is, the present invention is a silicon-containing composition, comprising:
(A) a thermosetting silicon-containing resin having a weight-average molecular weight of 1,000 to 3,000; (B) a polymer having one or both of repeating units represented by the following general formulae (1) and (2); and (C) a solvent, 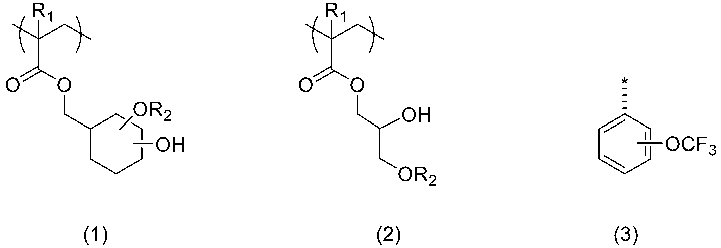
   wherein in the formula (1), R₁ represents a hydrogen atom or a methyl group, R₂ represents a saturated or unsaturated monovalent organic group having 2 to 50 carbon atoms and has at least one benzene ring structure represented by the formula (3) containing a trifluoromethoxy group as a substituent, and the substituents OR₂ and OH group on the cyclohexane ring are on adjacent carbon atoms on the cyclohexane ring,
   in the formula (2), R₁ represents a hydrogen atom or a methyl group, and R₂ represents a saturated or unsaturated monovalent organic group having 2 to 50 carbon atoms and has at least one benzene ring structure represented by the formula (3) including a trifluoromethoxy group as a substituent, and
   the formula (3) is a partial structure contained in the R₂ and optionally contains a substituent besides the trifluoromethoxy group, "*" represents an attachment point in a structure in the R₂, and two or more kinds of structures represented by the formula (3) or two or more identical structures represented by the formula (3) are optionally contained in the R₂.

Hereinafter, the present invention will be described in detail, but the present invention is not limited thereto.

### [(A) Thermosetting Silicon-Containing Resin]

The inventive silicon-containing composition contains (A) a thermosetting silicon-containing resin (polysiloxane, Sx) having a weight-average molecular weight of 1,000 to 3,000. (A) the thermosetting silicon-containing resin preferably includes any one or more of the partial structures represented by the following general formulae (Sx-1), (Sx-2), (Sx-3), and the following general formula (Sx-4). (A) the thermosetting silicon-containing resin is synthesized by the hydrolysis condensation of a hydrolysable monomer (Sm) described below.

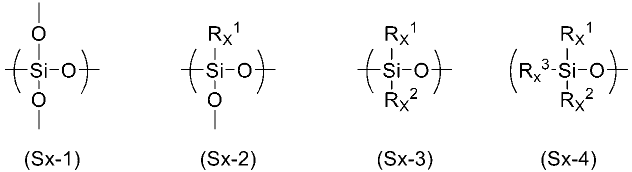

In the formulae, R_{X}¹, R_{X}², and R_{X}³ may be identical to or different from each other, and each represent a monovalent organic group having 1 to 30 carbon atoms.

### <<Hydrolysable Monomer (Sm)>>

(A) the thermosetting silicon-containing resin (Sx) is synthesized by the hydrolysis condensation of a hydrolysable monomer (Sm). Specifically, the resin can be produced by subjecting compounds represented by the following hydrolysable monomers (Sm-1), (Sm-2), (Sm-3), and (Sm-4) to hydrolysis condensation.

Si-(OR_{Y})₄ (Sm-1)

R_{X}¹-Si-(OR_{Y})₃ (Sm-2)

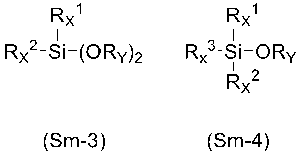

In the formulae, R_{X}¹, R_{X}², and R_{X}³ each represent a hydrogen atom or a monovalent organic group having 1 to 30 carbon atoms, and may be identical to or different from each other. The R_{Y}s may be identical to or different from each other, and each represent a monovalent organic group having 1 to 30 carbon atoms.

Specific examples of the hydrolysable monomer (Sm-1) include tetramethoxysilane, tetraethoxysilane, tetrapropoxysilane, and tetraisopropoxysilane, but are not limited thereto. Among these, tetramethoxysilane and tetraethoxysilane can be used particularly suitably.

Specific examples of the hydrolysable monomer (Sm-2) include trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, allyltrimethoxysilane, allyltriethoxysilane, allyltripropoxysilane, allyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, and naphthyltriisopropoxysilane, but are not limited thereto. Among these, the following can be particularly suitably used: methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, sec-butyltrimethoxysilane, sec-butyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, and phenethyltriethoxysilane.

Specific examples of the hydrolysable monomer (Sm-3) include dimethyldimethoxysilane, dimethyldiethoxysilane, dimethyldipropoxysilane, dimethyldiisopropoxysilane, diethyldimethoxysilane, diethyldiethoxysilane, diethyldipropoxysilane, diethyldiisopropoxysilane, methylethyldimethoxysilane, methylethyldiethoxysilane, methylethyldipropoxysilane, methylethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, diphenyldipropoxysilane, diphenyldiisopropoxysilane, methylphenyldimethoxysilane, methylphenyldiethoxysilane, methylphenyldipropoxysilane, and methylphenyldiisopropoxysilane, but are not limited thereto. Among these, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, and methylphenyldiethoxysilane can be used particularly suitably.

Specific examples of the hydrolysable monomer (Sm-4) include trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, and dimethylphenethylethoxysilane, but are not limited thereto. Among these, trimethylmethoxysilane, dimethylethylmethoxysilane, dimethylphenylmethoxysilane, dimethylbenzylmethoxysilane, and dimethylphenethylmethoxysilane can be used particularly suitably.

The R_{X}¹, R_{X}², and R_{X}³ in the hydrolysable monomer (Sm), that is, the compounds represented by (Sm-1), (Sm-2), (Sm-3), and (Sm-4) may each be an organic group having one or more carbon-oxygen single bonds or carbon-oxygen double bonds, and specifically, may each be an organic group having one or more groups selected from the group consisting of ether bonds, ester bonds, alkoxy groups, a hydroxy group, etc., further specifically, a substituent represented by the following general formula (Sm-R).

(P-Q₁-(S₁)ᵥ₁-Q₂-)ᵤ-(T)ᵥ₂-Q₃-(S₂)ᵥ₃-Q₄- (Sₘ-R)

In the formula, P represents a hydrogen atom, a cyclic ether group, a hydroxy group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent a substituent represented by - C_{q}H_{(2q-p)}Pₚ-; S₁ and S₂ each independently represent -O-, - CO-, -OCO-, -COO-, or OCOO; T represents a divalent atom other than carbon or a divalent group of an alicyclic, aromatic, or heterocyclic ring, each optionally containing a heteroatom such as an oxygen atom. "p" represents an integer of 0 to 3 and "q" represents an integer of 0 to 10, and when q=0, Q₁, Q₂, Q₃, and Q₄ each represent a single bond. "u" represents an integer of 0 to 3, and "v1", "v2", and "v3" each independently represent 0 or 1.

In the group represented by T, positions bonded to Q₂ and Q₃ are not particularly limited, and can be selected appropriately in consideration of reactivity dependent on steric factors, availability of commercial reagents used in the reaction, and so on.

Specific examples of the group represented by T include the following.

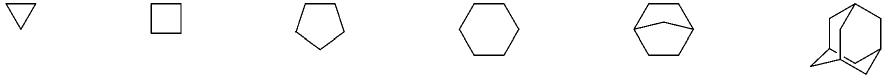

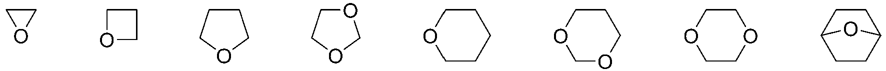

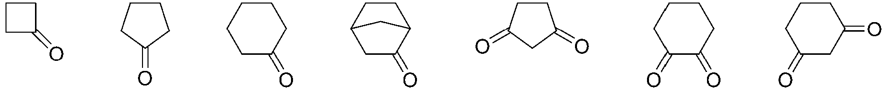

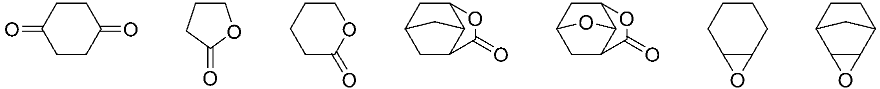

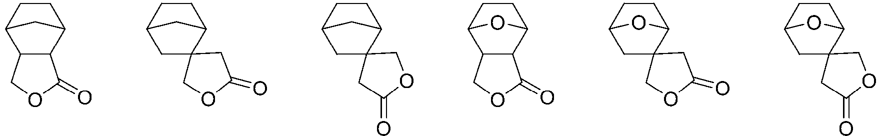

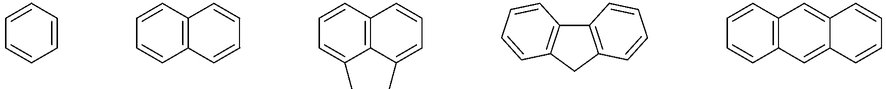

Preferable examples of the organic groups having one or more carbon-oxygen single bonds or carbon-oxygen double bonds in the general formula (Sm-R) include the following. Note that, in the following formulae, (Si) is depicted to show a bonding site to Si.

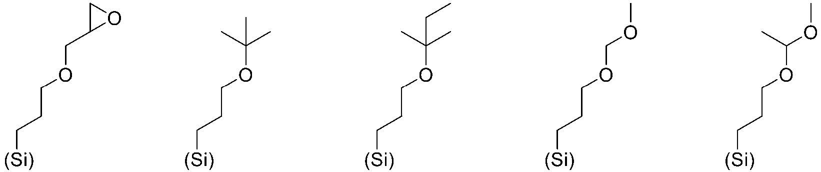

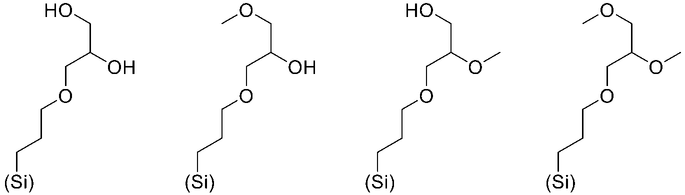

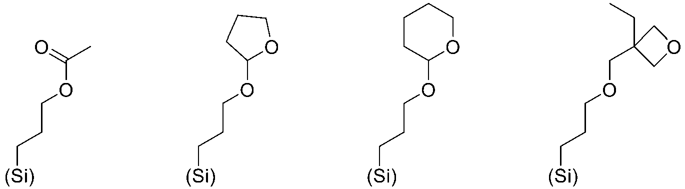

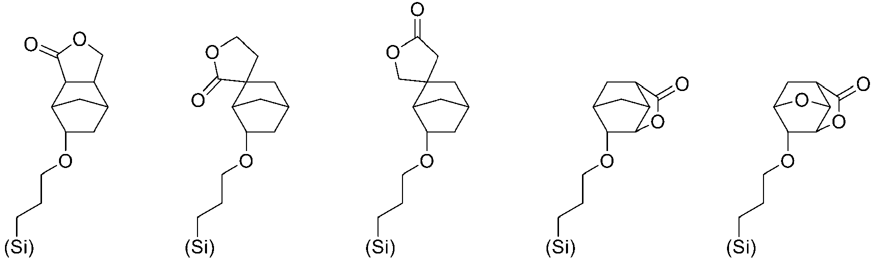

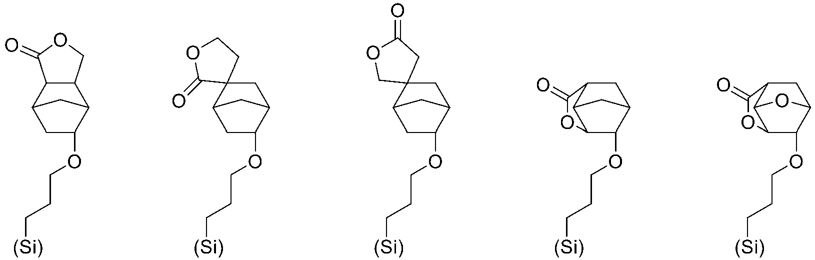

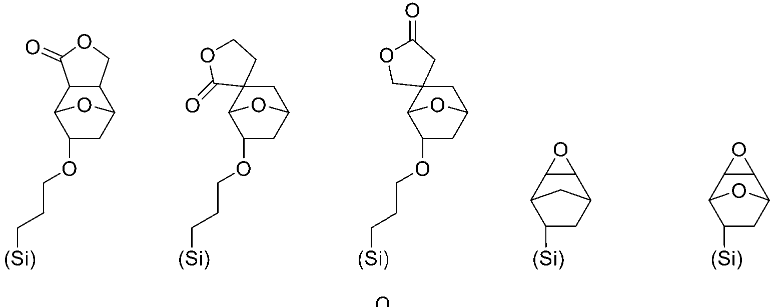

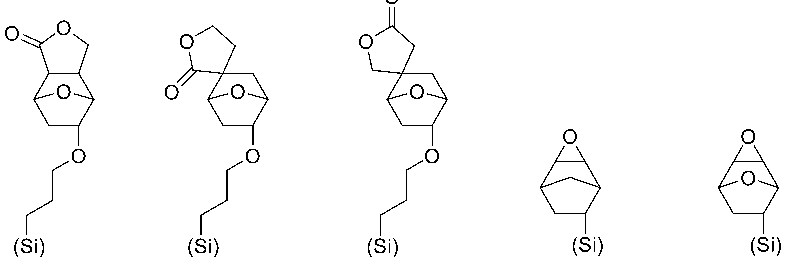

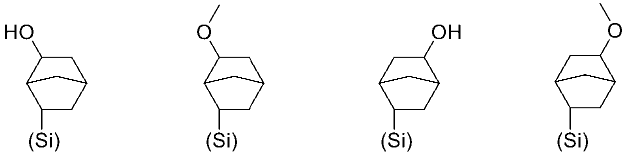

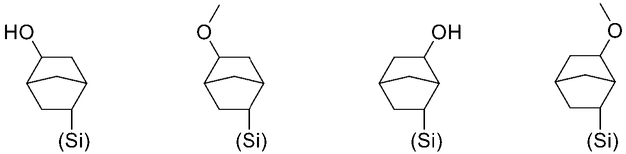

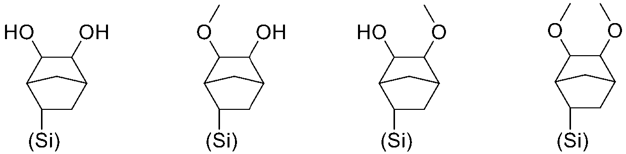

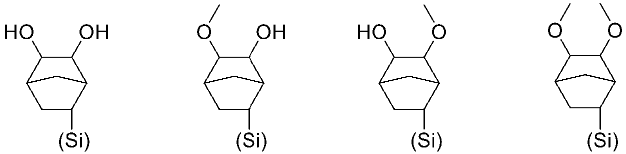

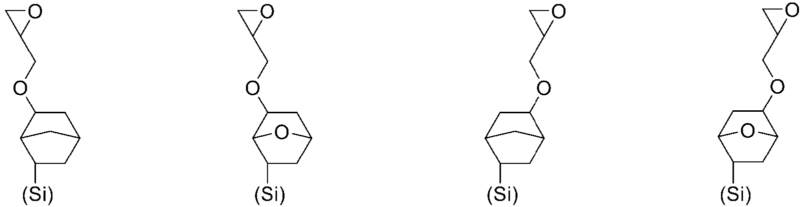

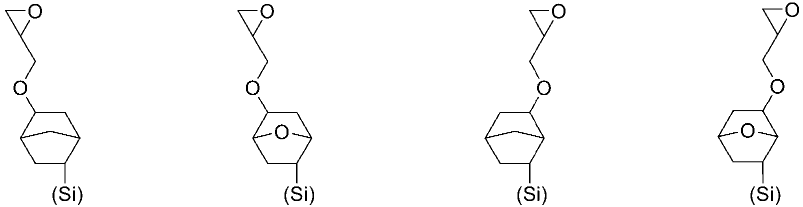

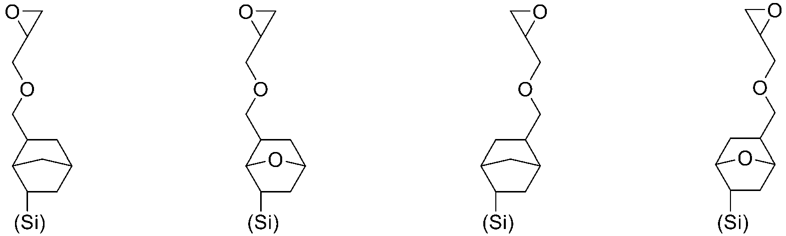

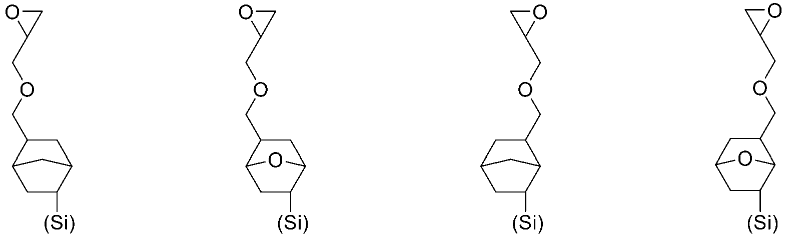

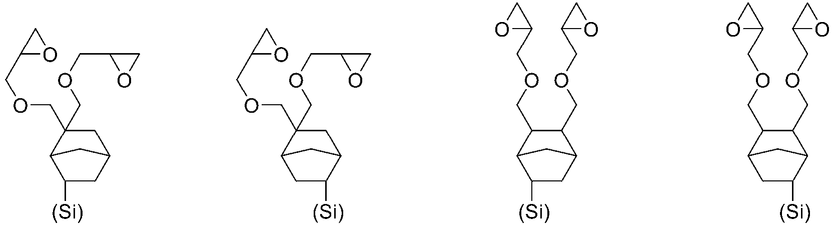

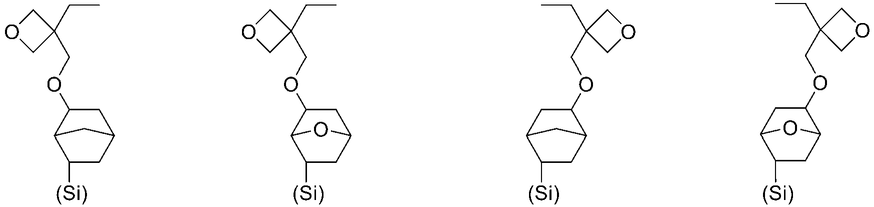

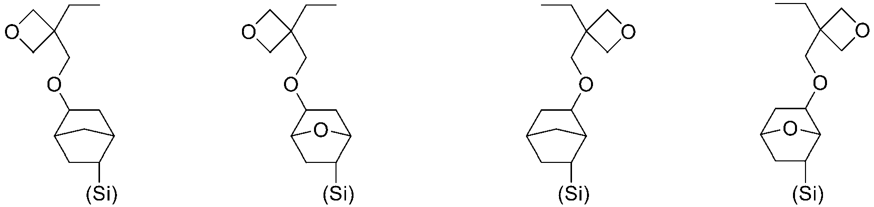

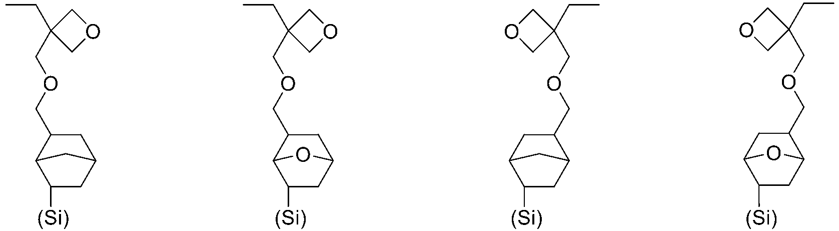

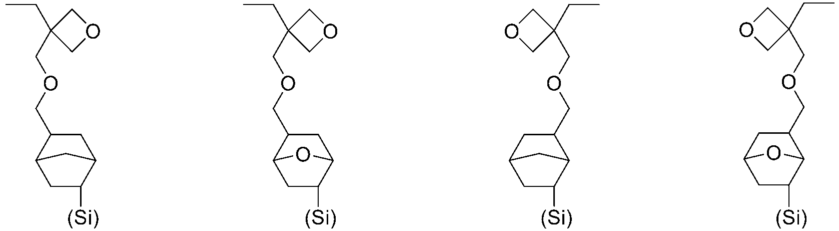

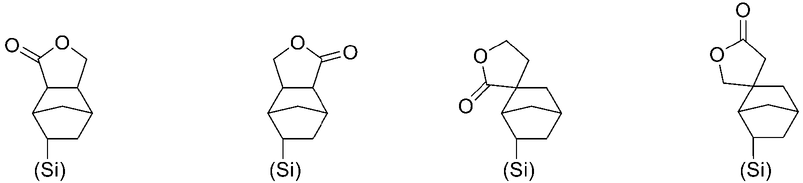

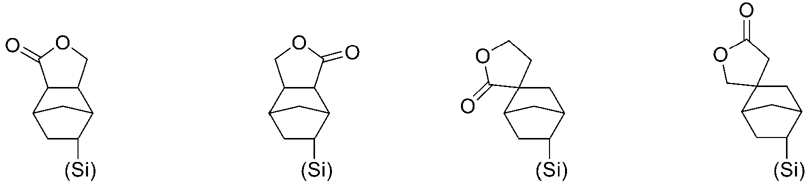

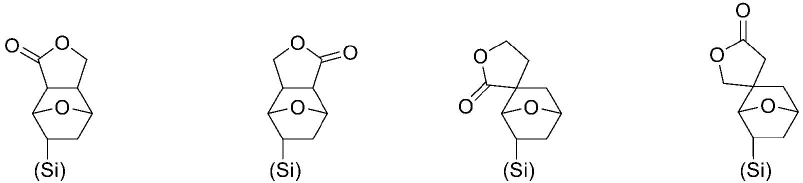

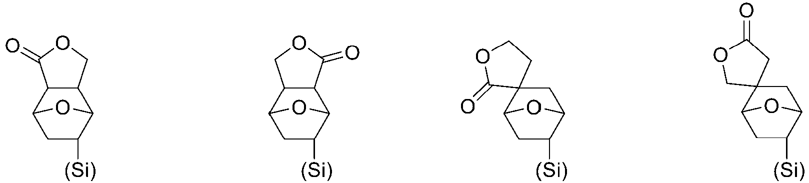

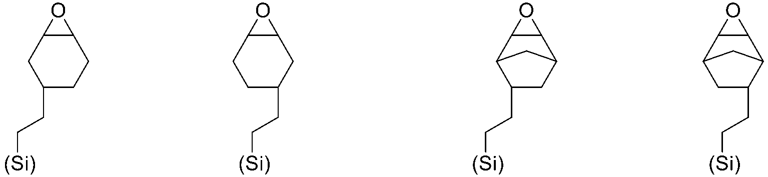

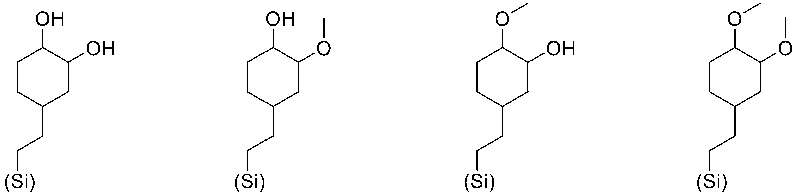

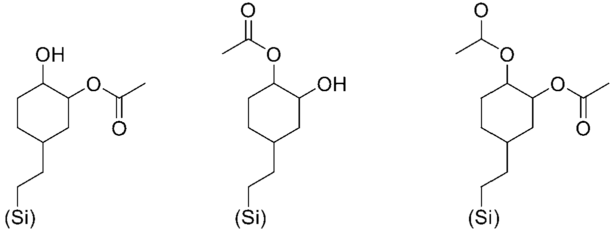

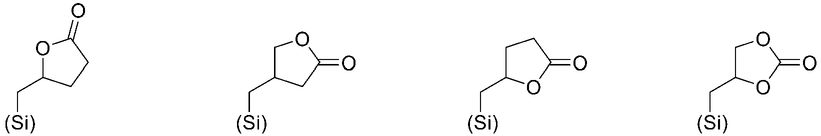

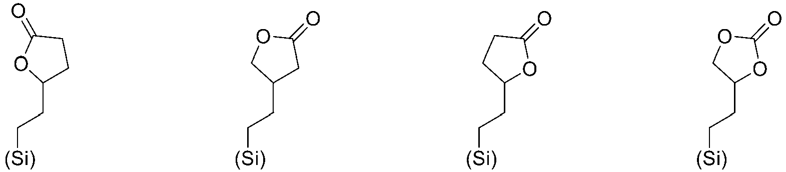

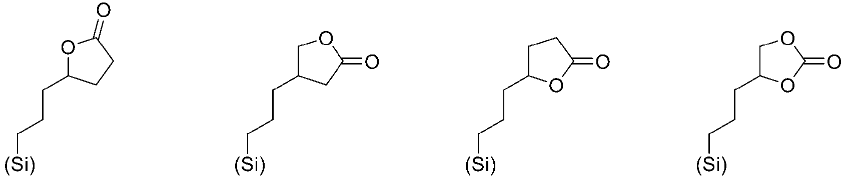

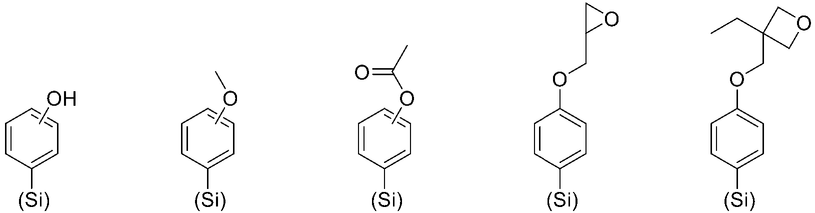

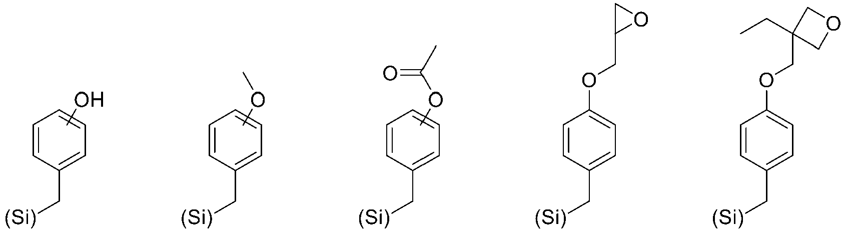

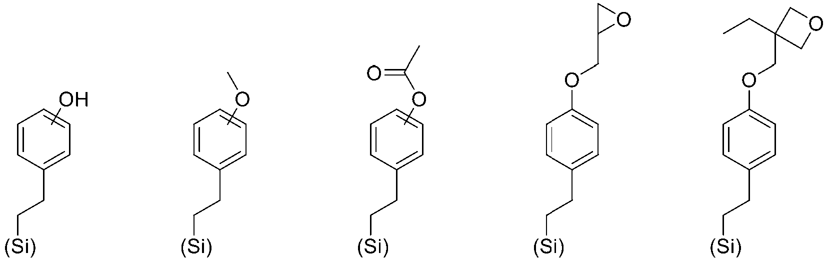

As examples of the organic groups of R_{X}¹, R_{X}², and R_{X}³, organic groups containing a silicon-silicon bond can also be used, and specific examples include the following.

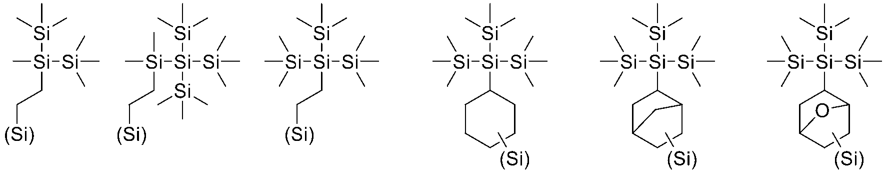

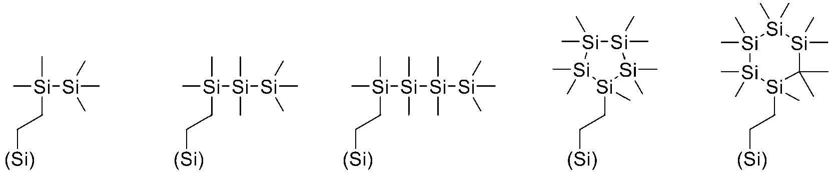

As an example of the organic groups of R_{X}¹, R_{X}², and R_{X}³, an organic group having a protective group that is decomposed with an acid can also be used. Specific examples thereof include organic groups shown from paragraph (0043) to paragraph (0048) of JP2013-167669A; and organic groups obtained from silicon compounds shown in paragraph (0056) of JP2013-224279A.

As an example of the organic groups of R_{X}¹, R_{X}², and R_{X}³, an organic group having a fluorine atom can also be used. Specific examples thereof include organic groups obtained from silicon compounds shown from paragraph (0059) to paragraph (0065) of JP2012-53253A.

The hydrolysable monomer (Sm) may contain, on the silicon atom represented by (Si) in the partial structure, 1 to 3 halogen atoms, such as a chlorine, bromine, or iodine atom, besides the hydrolysable group (e. g., a methoxy group, an ethoxy group, a propoxy group, a butoxy group, or an acetoxy group) represented by (OR_{Y}).

### <<Method for Synthesizing (A) Thermosetting Silicon-Containing Resin (Sx)>>

The physical properties of (A) the thermosetting silicon-containing resin (Sx) of the present invention varies depending on the type of the acid or alkali catalyst used at the time of hydrolysis condensation and on reaction conditions, and can be selected appropriately in accordance with the target performance of the resist underlayer film. In the following, a synthesis method using an acid catalyst and a synthesis method using an alkali catalyst will be described.

### (Synthesis Method 1: Synthesis Method Using Acid Catalyst)

(A) the thermosetting silicon-containing resin (Sx) used in the present invention can be synthesized by performing hydrolysis condensation of one kind of the hydrolysable monomer (Sm) or a mixture of two or more kinds of the hydrolysable monomer (Sm) in the presence of an acid catalyst.

Examples of the acid catalyst used in this event include: organic acids, such as formic acid, acetic acid, oxalic acid, maleic acid, methanesulfonic acid, benzenesulfonic acid, and toluenesulfonic acid; and inorganic acids such as hydrofluoric acid, hydrochloric acid, hydrobromic acid, sulfuric acid, nitric acid, perchloric acid, and phosphoric acid. However, the acid catalyst is not limited thereto. The catalyst can be used in an amount of 1×10⁻⁶ to 10 mol, preferably 1×10⁻⁵ to 5 mol, more preferably 1×10⁻⁴ to 1 mol, relative to 1 mol of the monomer.

When the hydrolysis condensation is performed, water to be used is preferably added in an amount of 0.01 to 100 mol, more preferably 0.05 to 50 mol, further preferably 0.1 to 30 mol, per mol of the hydrolysable substituent bonded to the monomer. When the amount is 100 mol or less, a reaction device can be made small and economical.

As the operation method, the monomer is added to an aqueous catalyst solution to initiate the hydrolysis condensation reaction. In this event, an organic solvent may be added to the aqueous catalyst solution, or the monomer may be diluted with an organic solvent, or both of these operations may be performed. The reaction temperature may be 0 to 100°C, preferably 5 to 80°C. As a preferable method, when the monomer is added dropwise, the temperature is maintained at 5 to 80°C, and then the mixture is aged at 20 to 80°C.

The organic solvent for adding to the aqueous catalyst solution or for diluting the monomer with is preferably methanol, ethanol, 1-propanol, 2-propanol, 1-butanol, 2-butanol, 2-methyl-1-propanol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, mixtures thereof, etc. However, the organic solvent is not limited thereto.

Among these solvents, water-soluble solvents are preferable. Examples thereof include: alcohols, such as methanol, ethanol, 1-propanol, and 2-propanol; polyhydric alcohols, such as ethylene glycol and propylene glycol; polyhydric alcohol condensate derivatives, such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; and acetone, acetonitrile, and tetrahydrofuran. Among these, ones having a boiling point of 100°C or lower can be used suitably.

The organic solvent is used in an amount of preferably 0 to 1,000 mL, particularly preferably 0 to 500 mL, relative to 1 mol of the monomer. The smaller the amount of the organic solvent used, the smaller the reaction vessel can be, and this is economical.

After the hydrolysis condensation reaction has been completed, neutralization reaction of the catalyst is carried out as necessary to obtain an aqueous reaction mixture solution. In this event, the amount of an alkaline substance usable for the neutralization is preferably 0.1 to 2 equivalents relative to the acid used as the catalyst. As this alkaline substance, any substance may be used as long as it shows alkalinity in water.

After the hydrolysis condensation reaction has been completed, by-products, such as alcohol produced by the hydrolysis condensation reaction, are preferably removed from the reaction mixture by a procedure such as removal under reduced pressure. In this event, the reaction mixture is heated at a temperature of preferably 0 to 100°C, more preferably 10 to 90°C, further preferably 15 to 80°C, although the temperature depends on the kinds of the added organic solvent, the alcohol produced in the reaction, etc. Additionally, in this event, the degree of vacuum is preferably atmospheric pressure or less, more preferably 80 kPa or less in absolute pressure, further preferably 50 kPa or less in absolute pressure, although the degree of vacuum varies depending on the kinds of the organic solvent, alcohol, etc. to be removed, as well as exhausting equipment, condensation equipment, and heating temperature. In this case, it is difficult to accurately know the amount of alcohol to be removed, but it is desirable to remove about 80 mass% or more of the produced alcohol etc.

Next, the acid catalyst used in the hydrolysis condensation may be removed from the reaction mixture. As a method for removing the acid catalyst, a solution of the thermosetting silicon-containing resin (Sx) is mixed with water, and the thermosetting silicon-containing resin (Sx) is extracted with an organic solvent.

Preferably, the organic solvent used for the extraction is capable of dissolving the thermosetting silicon-containing resin (Sx), and achieves two-layer separation when mixed with water. Examples of the organic solvent include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, mixtures thereof, etc. However, the organic solvent is not limited thereto.

Further, it is also possible to use a mixture of a water-soluble organic solvent and a slightly-water-soluble organic solvent. Preferable examples of the mixture include the mixture of methanol and ethyl acetate, the mixture of ethanol and ethyl acetate, the mixture of 1-propanol and ethyl acetate, the mixture of 2-propanol and ethyl acetate, the mixture of butanediol monomethyl ether and ethyl acetate, the mixture of propylene glycol monomethyl ether and ethyl acetate, the mixture of ethylene glycol monomethyl ether and ethyl acetate, the mixture of butanediol monoethyl ether and ethyl acetate, the mixture of propylene glycol monoethyl ether and ethyl acetate, the mixture of ethylene glycol monoethyl ether and ethyl acetate, the mixture of butanediol monopropyl ether and ethyl acetate, the mixture of propylene glycol monopropyl ether and ethyl acetate, the mixture of ethylene glycol monopropyl ether and ethyl acetate, the mixture of methanol and methyl isobutyl ketone, the mixture of ethanol and methyl isobutyl ketone, the mixture of 1-propanol and methyl isobutyl ketone, the mixture of 2-propanol and methyl isobutyl ketone, the mixture of propylene glycol monomethyl ether and methyl isobutyl ketone, the mixture of ethylene glycol monomethyl ether and methyl isobutyl ketone, the mixture of propylene glycol monoethyl ether and methyl isobutyl ketone, the mixture of ethylene glycol monoethyl ether and methyl isobutyl ketone, the mixture of propylene glycol monopropyl ether and methyl isobutyl ketone, the mixture of ethylene glycol monopropyl ether and methyl isobutyl ketone, the mixture of methanol and cyclopentyl methyl ether, the mixture of ethanol and cyclopentyl methyl ether, the mixture of 1-propanol and cyclopentyl methyl ether, the mixture of 2-propanol and cyclopentyl methyl ether, the mixture of propylene glycol monomethyl ether and cyclopentyl methyl ether, the mixture of ethylene glycol monomethyl ether and cyclopentyl methyl ether, the mixture of propylene glycol monoethyl ether and cyclopentyl methyl ether, the mixture of ethylene glycol monoethyl ether and cyclopentyl methyl ether, the mixture of propylene glycol monopropyl ether and cyclopentyl methyl ether, the mixture of ethylene glycol monopropyl ether and cyclopentyl methyl ether, the mixture of methanol and propylene glycol methyl ether acetate, the mixture of ethanol and propylene glycol methyl ether acetate, the mixture of 1-propanol and propylene glycol methyl ether acetate, the mixture of 2-propanol and propylene glycol methyl ether acetate, the mixture of propylene glycol monomethyl ether and propylene glycol methyl ether acetate, the mixture of ethylene glycol monomethyl ether and propylene glycol methyl ether acetate, the mixture of propylene glycol monoethyl ether and propylene glycol methyl ether acetate, the mixture of ethylene glycol monoethyl ether and propylene glycol methyl ether acetate, the mixture of propylene glycol monopropyl ether and propylene glycol methyl ether acetate, and the mixture of ethylene glycol monopropyl ether and propylene glycol methyl ether acetate. However, the combination is not limited thereto.

Although the mixing ratio of the water-soluble organic solvent and the slightly-water-soluble organic solvent is appropriately selected, the amount of the water-soluble organic solvent may be 0.1 to 1,000 parts by mass, preferably 1 to 500 parts by mass, further preferably 2 to 100 parts by mass, based on 100 parts by mass of the slightly-water-soluble organic solvent.

Subsequently, the thermosetting silicon-containing resin solution may be washed with neutral water. As the water used in this event, what is commonly called deionized water or ultrapure water may be used. The amount of the water to be used may be 0.01 to 100 L, preferably 0.05 to 50 L, and more preferably 0.1 to 5 L, relative to 1 L of the solution of the thermosetting silicon-containing resin (Sx). This washing procedure may be performed by putting both the solution of the thermosetting silicon-containing resin (Sx) and neutral water into the same container, followed by stirring and then leaving to stand to separate the aqueous layer. The washing may be performed once or more, preferably once to approximately five times, since washing ten times or more does not always produce the full washing effects thereof.

In the water-washing operation, part of the thermosetting silicon-containing resin (Sx) escapes into the aqueous layer, so that substantially the same effect as a fractionation operation is obtained in some cases. Hence, the number of water-washing operations and the amount of washing water may be appropriately selected in view of the catalyst removal effect and the fractionation effect.

Other methods for removing the acid catalyst include a method using an ion-exchange resin, and a method in which the acid catalyst is removed after a reaction using an epoxy compound such as ethylene oxide and propylene oxide. These methods can be appropriately selected in accordance with the acid catalyst used in the reaction.

To either of a solution of the thermosetting silicon-containing resin (Sx) with the acid catalyst still remaining or a solution of the thermosetting silicon-containing resin (Sx) with the acid catalyst having been removed, a final solvent may be added for solvent exchange under reduced pressure to obtain a desired solution of the thermosetting silicon-containing resin (Sx). In this event, the temperature during the solvent exchange is preferably 0 to 100°C, more preferably 10 to 90°C, further preferably 15 to 80°C, depending on the kinds of the reaction solvent and the extraction solvent to be removed. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the extraction solvent to be removed, exhausting equipment, condensation equipment, and heating temperature.

The thermosetting silicon-containing resin (Sx) may become unstable due to the solvent exchange. To prevent this phenomenon, a monohydric, dihydric, or polyhydric alcohol having cyclic ether as a substituent as shown in paragraphs (0181) and (0182) of JP2009-126940A may be added as a stabilizer. The alcohol may be added in an amount of 0 to 25 parts by mass, preferably 0 to 15 parts by mass, more preferably 0 to 5 parts by mass, based on 100 parts by mass of the thermosetting silicon-containing resin (Sx) in the solution before the solvent exchange. When the alcohol is added, the amount is preferably 0.5 parts by mass or more. If necessary, the monohydric, dihydric, or polyhydric alcohol having cyclic ether as a substituent may be added to the solution before the solvent exchange, and then the solvent exchange operation may be performed.

If the thermosetting silicon-containing resin (Sx) is concentrated above a certain concentration, the condensation reaction may further progress, so that the thermosetting silicon-containing resin (Sx) becomes no longer soluble in an organic solvent. Therefore, it is preferable to maintain the solution state with a proper concentration. Meanwhile, if the concentration is too low, the amount of solvent is excessive. Hence, the solution state with a proper concentration is economical and preferable. The concentration in this state is preferably 0.1 to 20 mass%.

The final solvent added to the solution of the thermosetting silicon-containing resin (Sx) is preferably an alcohol-based solvent. Particularly preferable examples include monoalkyl ether derivatives of ethylene glycol, diethylene glycol, triethylene glycol, propylene glycol, dipropylene glycol, butanediol, etc. Specifically, preferable are ethylene glycol monomethyl ether, ethylene glycol monoethyl ether, ethylene glycol monopropyl ether, propylene glycol monomethyl ether, propylene glycol monoethyl ether, propylene glycol monopropyl ether, butanediol monomethyl ether, butanediol monoethyl ether, butanediol monopropyl ether, diacetone alcohol, etc.

When these solvents are used as the main component, a non-alcohol-based solvent can also be added as an adjuvant solvent. Examples of the adjuvant solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, and cyclopentyl methyl ether. However, the adjuvant solvent is not limited thereto.

As a method for initiating the hydrolysis condensation reaction, besides the above-described method of adding the monomer to an aqueous catalyst solution, there is also a method of adding water or a water-containing organic solvent to the monomer or an organic solution of the monomer. In this event, the catalyst may be added to the monomer or the organic solution of the monomer, or may be added to the water or the water-containing organic solvent. The reaction temperature may be 0 to 100°C, preferably 10 to 80°C. As a preferable method, when the water is added dropwise, the mixture is heated to 10 to 50°C, and then further heated to 20 to 80°C for aging.

When the organic solvent is used, a water-soluble solvent is preferable. Examples thereof include methanol, ethanol, 1-propanol, 2-propanol, 1-butanol, 2-butanol, 2-methyl-1-propanol, acetone, tetrahydrofuran, and acetonitrile; polyhydric alcohol condensate derivatives, such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof, etc. However, the organic solvent is not limited thereto.

The organic solvent is used in an amount of preferably 0 to 1,000 mL, particularly preferably 0 to 500 mL, relative to 1 mol of the monomer. When the organic solvent is used in a small amount, only a small reaction vessel is required, and this is economical. The obtained reaction mixture may be subjected to posttreatment by the same procedure as described above to obtain a thermosetting silicon-containing resin (Sx).

### (Synthesis Method 2: Synthesis Method Using Alkali Catalyst)

(A) the thermosetting silicon-containing resin (Sx) of the present invention can be synthesized by performing hydrolysis condensation of one kind of the hydrolysable monomer (Sm) or a mixture of two or more kinds of the hydrolysable monomer (Sm) in the presence of an alkali catalyst.

Examples of the alkali catalyst used in this event include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclooctane, diazabicyclocyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, etc. However, the alkali catalyst is not limited thereto. The catalyst can be used in an amount of 1×10⁻⁶ to 10 mol, preferably 1×10⁻⁵ to 5 mol, more preferably 1×10⁻⁴ to 1 mol, relative to 1 mol of the monomer.

When the hydrolysis condensation is performed, water to be used is preferably added in an amount of 0.1 to 50 mol per mol of the hydrolysable substituent bonded to the monomer. When the amount is 50 mol or less, a reaction device can be made small and economical.

As the operation method, the monomer is added to an aqueous catalyst solution to initiate the hydrolysis condensation reaction. In this event, an organic solvent may be added to the aqueous catalyst solution, or the monomer may be diluted with an organic solvent, or both of these operations may be performed. The reaction temperature may be 0 to 100°C, preferably 5 to 80°C. As a preferable method, when the monomer is added dropwise, the temperature is maintained at 5 to 80°C, and then the mixture is aged at 20 to 80°C.

As the organic solvent for adding to the aqueous catalyst solution or for diluting the monomer with, the same organic solvents as those given as examples of the organic solvents which can be added to the aqueous acid catalyst solution are preferably used. The organic solvent is used in an amount of preferably 0 to 1,000 mL relative to 1 mol of the monomer because the reaction can be performed economically.

After the hydrolysis condensation reaction has been completed, as necessary, neutralization reaction of the catalyst is carried out to obtain an aqueous solution of the reaction mixture. In this event, the amount of an acidic substance usable for the neutralization is preferably 0.1 to 2 equivalents relative to the alkaline substance used as the catalyst. As this acidic substance, any substance may be used as long as it exhibits acidity in water.

After the hydrolysis condensation reaction has been completed, by-products, such as alcohol produced by the hydrolysis condensation reaction, are preferably removed from the reaction mixture by a procedure such as removal under reduced pressure. In this event, the reaction mixture is heated at a temperature of preferably 0 to 100°C, more preferably 10 to 90°C, further preferably 15 to 80°C, although the temperature depends on the kinds of the added organic solvent, the alcohol produced in the reaction, etc. Additionally, in this event, the degree of vacuum is preferably atmospheric pressure or less, more preferably 80 kPa or less in absolute pressure, further preferably 50 kPa or less in absolute pressure, although the degree of vacuum varies depending on the kinds of the organic solvent, alcohol, etc. to be removed, as well as exhausting equipment, condensation equipment, and heating temperature. In this case, it is difficult to accurately know the amount of alcohol to be removed, but it is desirable to remove about 80 mass% or more of the produced alcohol etc.

Next, the alkali catalyst used in the hydrolysis condensation may be removed from the reaction mixture. As a method for removing the alkali catalyst, a solution of the thermosetting silicon-containing resin (Sx) is mixed with water, and the thermosetting silicon-containing resin (Sx) is extracted with an organic solvent.

Examples of the organic solvent used for the extraction include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, mixtures thereof, etc. However, the organic solvent is not limited thereto.

Further, it is also possible to use a mixture of a water-soluble organic solvent and a slightly-water-soluble organic solvent, and specific examples include the organic solvents and the mixtures of the water-soluble organic solvents and the slightly-water-soluble organic solvents given above as specific examples of organic solvents used when removing the acid catalyst.

Although the mixing ratio of the water-soluble organic solvent and the slightly-water-soluble organic solvent is appropriately selected, the amount of the water-soluble organic solvent may be 0.1 to 1,000 parts by mass, preferably 1 to 500 parts by mass, further preferably 2 to 100 parts by mass, based on 100 parts by mass of the slightly-water-soluble organic solvent.

Subsequently, the thermosetting silicon-containing resin solution may be washed with neutral water. As the water used in this event, what is commonly called deionized water or ultrapure water may be used. The amount of the water to be used may be 0.01 to 100 L, preferably 0.05 to 50 L, and more preferably 0.1 to 5 L, relative to 1 L of the solution of the thermosetting silicon-containing resin (Sx). This washing procedure may be performed by putting both the solution of the thermosetting silicon-containing resin (Sx) and neutral water into the same container, followed by stirring and then leaving to stand to separate the aqueous layer. The washing may be performed once or more, preferably once to approximately five times, since washing ten times or more does not always produce the full washing effects thereof.

In the water-washing operation, part of the thermosetting silicon-containing resin (Sx) escapes into the aqueous layer, so that substantially the same effect as a fractionation operation is obtained in some cases. Hence, the number of water-washing operations and the amount of washing water may be appropriately selected in view of the catalyst removal effect and the fractionation effect.

To either of a solution of the thermosetting silicon-containing resin (Sx) with the alkali catalyst still remaining or a solution of the thermosetting silicon-containing resin (Sx) with the alkali catalyst having been removed, a final solvent may be added for solvent exchange under reduced pressure to obtain a desired solution of the thermosetting silicon-containing resin (Sx). In this event, the temperature during the solvent exchange is preferably 0 to 100°C, more preferably 10 to 90°C, further preferably 15 to 80°C, depending on the kind of the extraction solvent to be removed. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the extraction solvent to be removed, exhausting equipment, condensation equipment, and heating temperature.

In the same manner as when an acid catalyst is used, a monohydric, dihydric, or polyhydric alcohol having cyclic ether as a substituent as shown in paragraphs (0181) and (0182) of JP2009-126940A may be added as a stabilizer for the thermosetting silicon-containing resin (Sx). The alcohol may be added in an amount of 0 to 25 parts by mass, preferably 0 to 15 parts by mass, more preferably 0 to 5 parts by mass, based on 100 parts by mass of the thermosetting silicon-containing resin (Sx) in the solution before the solvent exchange. When the alcohol is added, the amount is preferably 0.5 parts by mass or more. If necessary, the monohydric, dihydric, or polyhydric alcohol having cyclic ether as a substituent may be added to the solution before the solvent exchange, and then the solvent exchange operation may be performed.

In addition, after concentration, the solution state with a proper concentration is economical and preferable, and a concentration of 0.1 to 20 mass% is preferable.

The final solvent added to the solution of the thermosetting silicon-containing resin (Sx) is preferably an alcohol-based solvent. Particularly preferable examples include monoalkyl ether derivatives of ethylene glycol, diethylene glycol, triethylene glycol, propylene glycol, dipropylene glycol, butanediol, etc. Specifically, preferable are ethylene glycol monomethyl ether, ethylene glycol monoethyl ether, ethylene glycol monopropyl ether, propylene glycol monomethyl ether, propylene glycol monoethyl ether, propylene glycol monopropyl ether, butanediol monomethyl ether, butanediol monoethyl ether, butanediol monopropyl ether, diacetone alcohol, etc.

When these solvents are used as the main component, a non-alcohol-based solvent can also be added as an adjuvant solvent. Examples of the adjuvant solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, and cyclopentyl methyl ether. However, the adjuvant solvent is not limited thereto.

As a method for initiating the hydrolysis condensation reaction, besides the above-described method of adding the monomer to an aqueous catalyst solution, there is also a method of adding water or a water-containing organic solvent to the monomer or an organic solution of the monomer. In this event, the catalyst may be added to the monomer or the organic solution of the monomer, or may be added to the water or the water-containing organic solvent. The reaction temperature may be 0 to 100°C, preferably 10 to 80°C. As a preferable method, when the water is added dropwise, the mixture is heated to 10 to 50°C, and then further heated to 20 to 80°C for aging.

When the organic solvent is used, a water-soluble solvent is preferable. Examples thereof include methanol, ethanol, 1-propanol, 2-propanol, 1-butanol, 2-butanol, 2-methyl-1-propanol, acetone, tetrahydrofuran, and acetonitrile; polyhydric alcohol condensate derivatives, such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof, etc. However, the organic solvent is not limited thereto.

The organic solvent is used in an amount of preferably 0 to 1,000 mL, particularly preferably 0 to 500 mL, relative to 1 mol of the monomer. When the organic solvent is used in a small amount, only a small reaction vessel is required, and this is economical. The obtained reaction mixture may be subjected to posttreatment by the same procedure as described above to obtain a thermosetting silicon-containing resin (Sx).

### <<Third Component of (A) Thermosetting Silicon-Containing Resin (Sx)>>

For (A) the thermosetting silicon-containing resin (Sx) used in the present invention, it is possible to use, as a component of a silicon-containing composition, a polysiloxane derivative obtained by a reaction of a hydrolysable metal compound represented by the following general formula (Mm) under the conditions using an acid or alkali catalyst mentioned above, in addition to one or more kinds of the hydrolysable monomer (Sm).

U(ORₘ¹)ₘ₁(ORₘ²)ₘ₂ (Mₘ)

In the formula, Rₘ¹ and Rₘ² each represent an organic group having 1 to 30 carbon atoms; m1+m2 is the same number as a valence determined by the kind of U; "m1" and "m2" each represent an integer of 0 or more; and U represents an element belonging to the group III, IV, or V in the periodic table, except for carbon and silicon.

Examples of the hydrolysable metal compound represented by the general formula (Mm) used in this event include the following.

When U is boron, examples of the monomer compound shown by the general formula (Mm) include boron methoxide, boron ethoxide, boron propoxide, boron butoxide, boron amyloxide, boron hexyloxide, boron cyclopentoxide, boron cyclohexyloxide, boron allyloxide, boron phenoxide, boron methoxyethoxide, boric acid, boron oxide, etc.

When U is aluminum, examples of the monomer compound shown by the general formula (Mm) include aluminum methoxide, aluminum ethoxide, aluminum propoxide, aluminum butoxide, aluminum amyloxide, aluminum hexyloxide, aluminum cyclopentoxide, aluminum cyclohexyloxide, aluminum allyloxide, aluminum phenoxide, aluminum methoxyethoxide, aluminum ethoxyethoxide, aluminum dipropoxy(ethyl acetoacetate), aluminum dibutoxy(ethyl acetoacetate), aluminum propoxy bis(ethyl acetoacetate), aluminum butoxy bis(ethyl acetoacetate), aluminum 2,4-pentanedionate, aluminum 2,2,6,6-tetramethyl-3,5-heptanedionate, etc.

When U is gallium, examples of the monomer compound shown by the general formula (Mm) include gallium methoxide, gallium ethoxide, gallium propoxide, gallium butoxide, gallium amyloxide, gallium hexyloxide, gallium cyclopentoxide, gallium cyclohexyloxide, gallium allyloxide, gallium phenoxide, gallium methoxyethoxide, gallium ethoxyethoxide, gallium dipropoxy(ethyl acetoacetate), gallium dibutoxy(ethyl acetoacetate), gallium propoxy bis(ethyl acetoacetate), gallium butoxy bis(ethyl acetoacetate), gallium 2,4-pentanedionate, gallium 2,2,6,6-tetramethyl-3,5-heptanedionate, etc.

When U is yttrium, examples of the monomer compound shown by the general formula (Mm) include yttrium methoxide, yttrium ethoxide, yttrium propoxide, yttrium butoxide, yttrium amyloxide, yttrium hexyloxide, yttrium cyclopentoxide, yttrium cyclohexyloxide, yttrium allyloxide, yttrium phenoxide, yttrium methoxyethoxide, yttrium ethoxyethoxide, yttrium dipropoxy(ethyl acetoacetate), yttrium dibutoxy(ethyl acetoacetate), yttrium propoxy bis(ethyl acetoacetate), yttrium butoxy bis(ethyl acetoacetate), yttrium 2,4-pentanedionate, yttrium 2,2,6,6-tetramethyl-3,5-heptanedionate, etc.

When U is germanium, examples of the monomer compound shown by the general formula (Mm) include germanium methoxide, germanium ethoxide, germanium propoxide, germanium butoxide, germanium amyloxide, germanium hexyloxide, germanium cyclopentoxide, germanium cyclohexyloxide, germanium allyloxide, germanium phenoxide, germanium methoxyethoxide, germanium ethoxyethoxide, etc.

When U is tin, examples of the monomer compound shown by the general formula (Mm) include methoxy tin, ethoxy tin, propoxy tin, butoxy tin, phenoxy tin, methoxyethoxy tin, ethoxyethoxy tin, tin 2,4-pentanedionate, tin 2,2,6,6-tetramethyl-3,5-heptanedionate, etc.

When U is titanium, examples of the monomer compound shown by the general formula (Mm) include titanium methoxide, titanium ethoxide, titanium propoxide, titanium butoxide, titanium amyloxide, titanium hexyloxide, titanium cyclopentoxide, titanium cyclohexyloxide, titanium allyloxide, titanium phenoxide, titanium methoxyethoxide, titanium ethoxyethoxide, titanium dipropoxy bis(ethyl acetoacetate), titanium dibutoxy bis(ethyl acetoacetate), titanium dipropoxy bis(2,4-pentanedionate), titanium dibutoxy bis(2,4-pentanedionate), etc.

When U is zirconium, examples of the monomer compound shown by the general formula (Mm) include methoxy zirconium, ethoxy zirconium, propoxy zirconium, butoxy zirconium, phenoxy zirconium, zirconium dibutoxide bis(2,4-pentanedionate), zirconium dipropoxide bis(2,2,6,6-tetramethyl-3,5-heptanedionate), etc.

When U is hafnium, examples of the monomer compound shown by the general formula (Mm) include hafnium methoxide, hafnium ethoxide, hafnium propoxide, hafnium butoxide, hafnium amyloxide, hafnium hexyloxide, hafnium cyclopentoxide, hafnium cyclohexyloxide, hafnium allyloxide, hafnium phenoxide, hafnium methoxyethoxide, hafnium ethoxyethoxide, hafnium dipropoxy bis(ethyl acetoacetate), hafnium dibutoxy bis(ethyl acetoacetate), hafnium dipropoxy bis(2,4-pentanedionate), hafnium dibutoxy bis(2,4-pentanedionate), etc.

When U is phosphorus, examples of the monomer compound shown by the general formula (Mm) include trimethyl phosphate, triethyl phosphate, tripropyl phosphate, trimethyl phosphite, triethyl phosphite, tripropyl phosphite, diphosphorous pentaoxide, etc.

When U is arsenic, examples of the monomer compound shown by the general formula (Mm) include methoxy arsenic, ethoxy arsenic, propoxy arsenic, butoxy arsenic, phenoxy arsenic, etc.

When U is antimony, examples of the monomer compound shown by the general formula (Mm) include methoxy antimony, ethoxy antimony, propoxy antimony, butoxy antimony, phenoxy antimony, antimony acetate, antimony propionate, etc.

When U is bismuth, examples of the monomer compound shown by the general formula (Mm) include methoxy bismuth, ethoxy bismuth, propoxy bismuth, butoxy bismuth, phenoxy bismuth, etc.

When U is vanadium, examples of the monomer compound shown by the general formula (Mm) include vanadium oxide bis(2,4-pentanedionate), vanadium 2,4-pentanedionate, vanadium tributoxide oxide, vanadium tripropoxide oxide, etc.

When U is niobium, examples of the monomer compound shown by the general formula (Mm) include methoxy niobium, ethoxy niobium, propoxy niobium, butoxy niobium, phenoxy niobium, etc.

When U is tantalum, examples of the monomer compound shown by the general formula (Mm) include methoxy tantalum, ethoxy tantalum, propoxy tantalum, butoxy tantalum, phenoxy tantalum, etc.

### <<Molecular Weight of (A) Thermosetting Silicon-Containing Resin (Sx)>>

The molecular weight of the thermosetting silicon-containing resin (Sx) obtained by the above synthesis method 1 or 2 can be adjusted not only by the choice of monomers but also by controlling the reaction conditions at the time of polymerization, and is preferably 100,000 or less, more preferably 200 to 50,000, and further preferably 300 to 30,000. When the weight-average molecular weight is 100,000 or less, the generation of foreign matters or coating spots does not occur, and this is preferable. Note that, regarding data on the weight-average molecular weight, the molecular weight is expressed in terms of polystyrene and is obtained by gel permeation chromatography (GPC) using a refractive index (RI) detector, tetrahydrofuran as an eluent, and polystyrene as a reference substance.

### <<Filtration of (A) Thermosetting Silicon-Containing Resin>>

The thermosetting silicon-containing resin (Sx) is preferably filtered using a filter. Filtration using a filter can remove foreign matters and gel, which may cause film-formation failure, and is effective in terms of quality stabilization.

Examples of the material of the filter to be used include a fluorocarbon, cellulose, nylon, polyester, and hydrocarbon. Besides the above, a filter formed with a fluorocarbon, so-called Teflon(R), a hydrocarbon, such as polyethylene and polypropylene, or nylon can be suitably used.

A pore size of the filter can be appropriately selected depending on target cleanliness, and is preferably 100 nm or smaller, and more preferably 20 nm or smaller. One of these filters may be used alone, or a plurality of these filters may be used in combination. As for the filtration method, the solution may be passed through the filter once, but the solution is preferably circulated to be filtered a plurality of times.

### [(B) Polymer]

The inventive silicon-containing composition contains (B) a polymer having one or both of repeating units represented by the following general formulae (1) and (2) (hereinafter, abbreviated to polymer (B)).

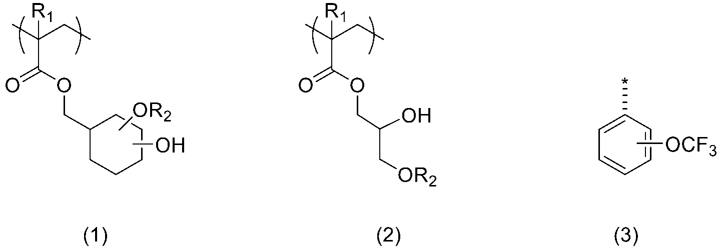

In the formula (1), R₁ represents a hydrogen atom or a methyl group, R₂ represents a saturated or unsaturated monovalent organic group having 2 to 50 carbon atoms and has at least one benzene ring structure represented by the formula (3) containing a trifluoromethoxy group as a substituent, and the substituents OR₂ and OH group on the cyclohexane ring are on adjacent carbon atoms on the cyclohexane ring,
in the formula (2), R₁ represents a hydrogen atom or a methyl group, and R₂ represents a saturated or unsaturated monovalent organic group having 2 to 50 carbon atoms and has at least one benzene ring structure represented by the formula (3) including a trifluoromethoxy group as a substituent, and
the formula (3) is a partial structure contained in the R₂ and optionally contains a substituent besides the trifluoromethoxy group, "*" represents an attachment point in a structure in the R₂, and two or more kinds of structures represented by the formula (3) or two or more identical structures represented by the formula (3) are optionally contained in the R₂.

When a polymer (B) having one or both of repeating units represented by the general formulae (1) and (2) is contained in the inventive silicon-containing composition, it is possible to impart the surface active effect necessary when forming a silicon-containing film, and film-formability at the time of application can be improved. Moreover, the trifluoromethoxybenzene structure represented by the formula (3) does not belong to the category of PFAS in the European REACH, and therefore, is also advantageous from the viewpoint of preventing environmental pollution.

The R₂ in the repeating units represented by the general formulae (1) and (2) preferably contains any of structures represented by the following formulae (4).

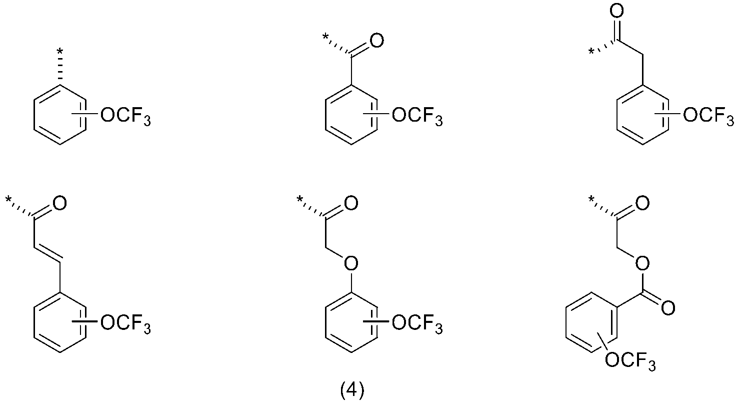

In the formulae (4), "*" and a broken line represent an attachment point in a structure in the R₂.

In the polymer (B1), the trifluoromethoxybenzene structure is introduced in a position separated from the main chain by a linker of a few carbon atoms. An agglomerate structure is easily formed by the interaction between the trifluoromethoxy group and the benzene ring, and behavior as a hydrophobic group is emphasized. As a result, an excellent surface active effect can be exhibited, and film-formability when the silicon-containing composition is applied can be improved.

Furthermore, the polymer (B) is preferably a copolymer (B2) having repeating units of one or both of the general formulae (1) and (2) and the following (5).

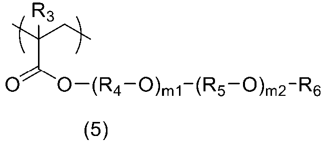

In the formula, R₃ represents a hydrogen atom or a methyl group; R₄ and R₅ each represent a linear or branched divalent alkylene group having 1 to 4 carbon atoms; R₆ represents a hydrogen atom, an alkyl group having 1 to 4 carbon atoms, or a phenyl group; and "m1" and "m2" each represent an integer of 0 to 23 and satisfy 23 ≥ m1+m2 ≥ 2.

The polymer (B2) is a copolymer having a linking group in the repeating unit (5), and the surface activating ability can be adjusted by the repeating unit contributing as an appropriate alleviation unit of the agglomerate structure. Therefore, it is possible to provide a silicon-containing composition adapted to various film thicknesses (not dependent on the solution concentration) and having both filling property and film-formability.

### <<Monomer>>

The polymer (B) or the polymer (B1) can be synthesized using a monomer represented by the following general formula (1') or (2').

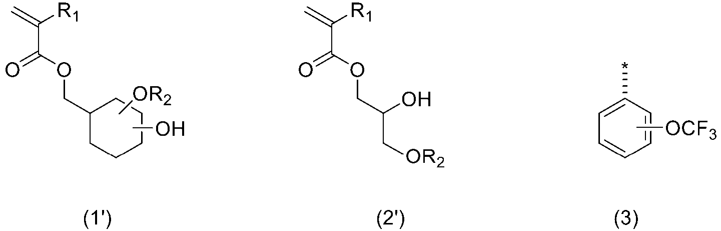

In the formula (1'), R₁ represents a hydrogen atom or a methyl group, R₂ represents a saturated or unsaturated monovalent organic group having 2 to 50 carbon atoms and has at least one benzene ring structure represented by the formula (3) containing a trifluoromethoxy group as a substituent, and the substituents OR₂ and OH group on the cyclohexane ring are on adjacent carbon atoms on the cyclohexane ring.

In the formula (2'), R₁ represents a hydrogen atom or a methyl group, and R₂ represents a saturated or unsaturated monovalent organic group having 2 to 50 carbon atoms and has at least one benzene ring structure represented by the formula (3) including a trifluoromethoxy group as a substituent.

The formula (3) is a partial structure contained in the R₂ and optionally contains a substituent besides the trifluoromethoxy group, "*" represents an attachment point in a structure in the R₂, and two or more kinds of structures represented by the formula (3) or two or more identical structures represented by the formula (3) are optionally contained in the R₂.

Specifically, the structures represented by the formula (3) are represented by the following formulae (3-1), (3-2), and (3-3).

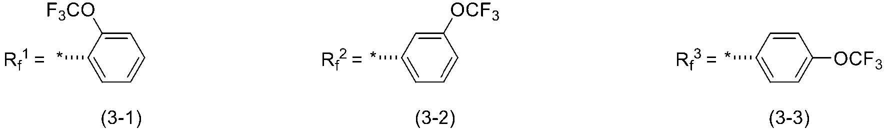

In the formulae, "*" and a broken line represent an attachment point in a structure in the R₂.

Preferable examples of the monomer represented by the general formula (1') include the following, but are not limited thereto.

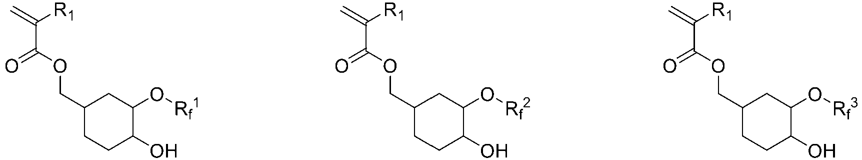

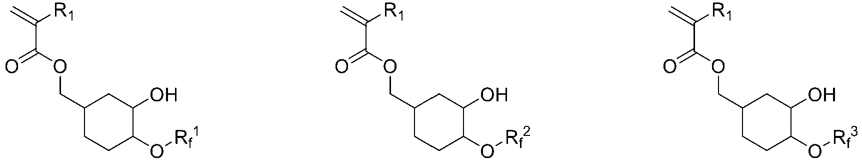

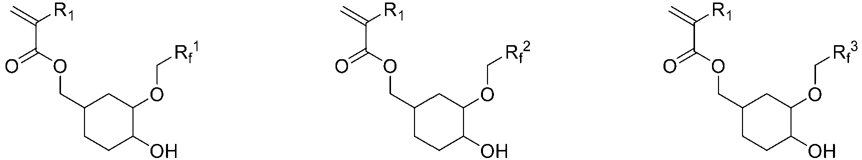

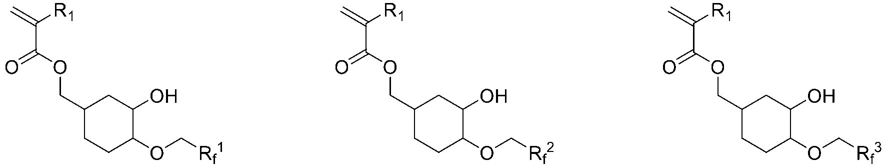

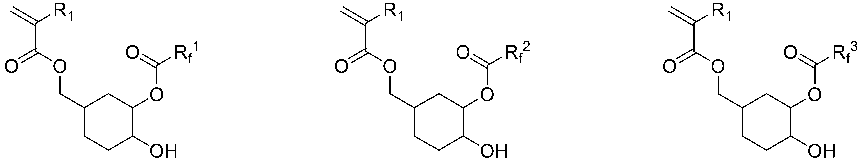

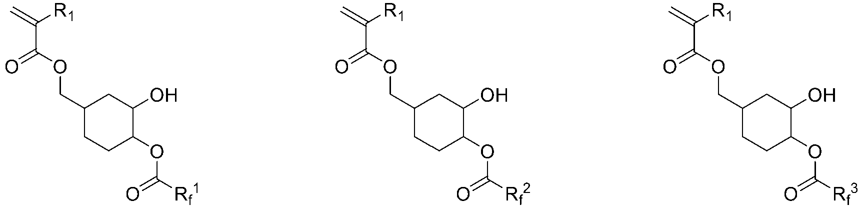

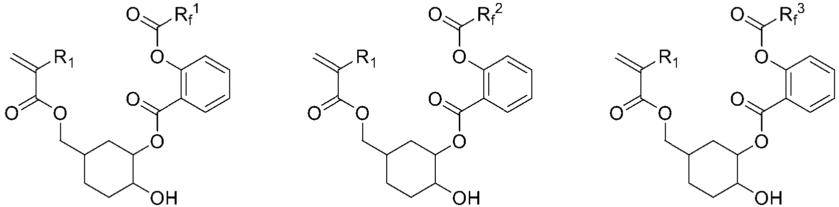

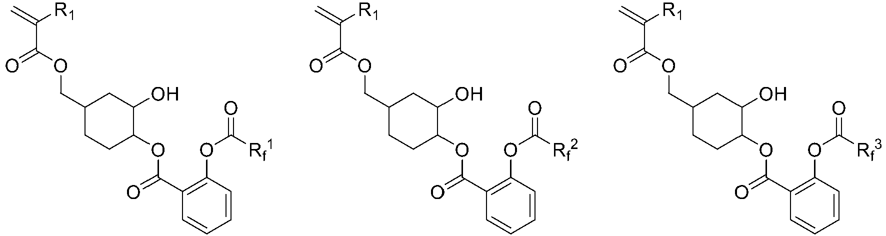

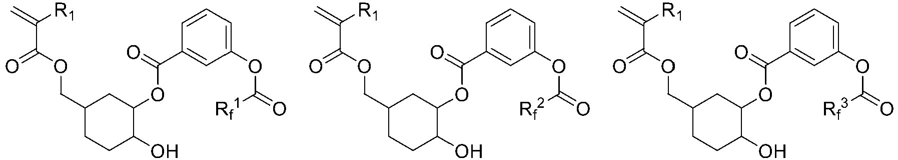

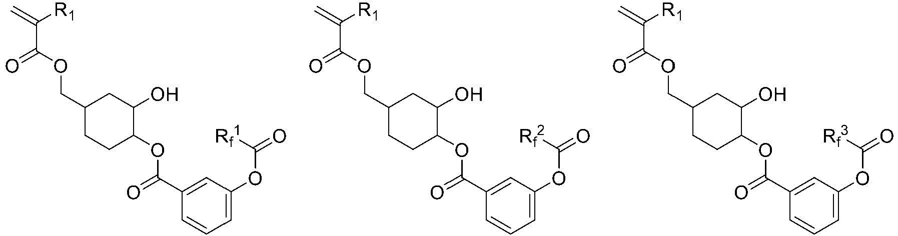

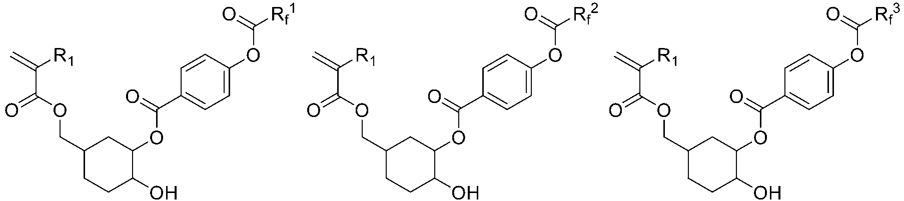

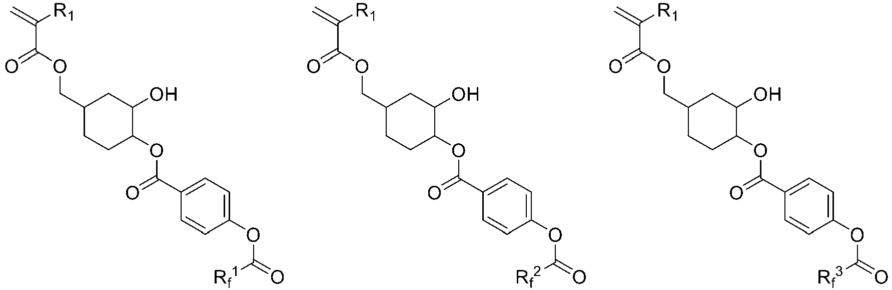

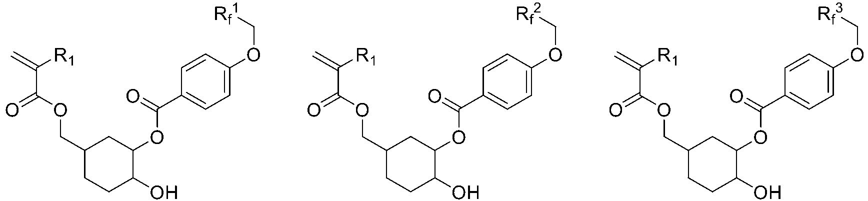

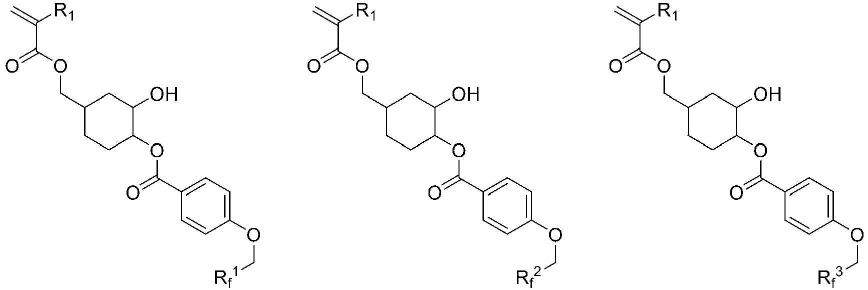

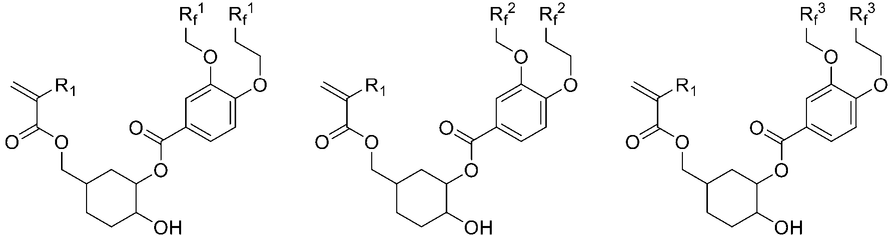

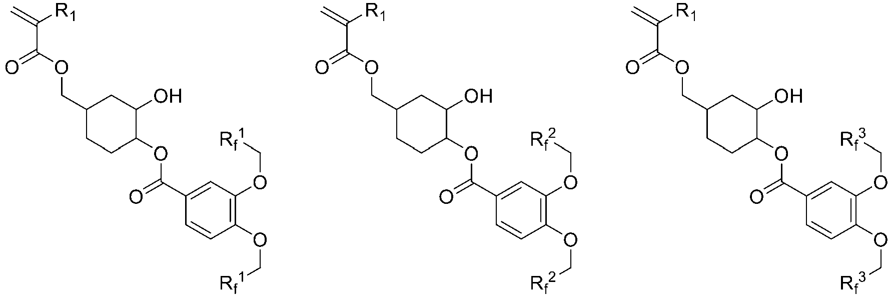

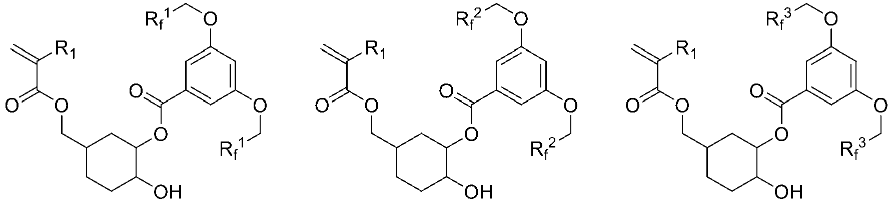

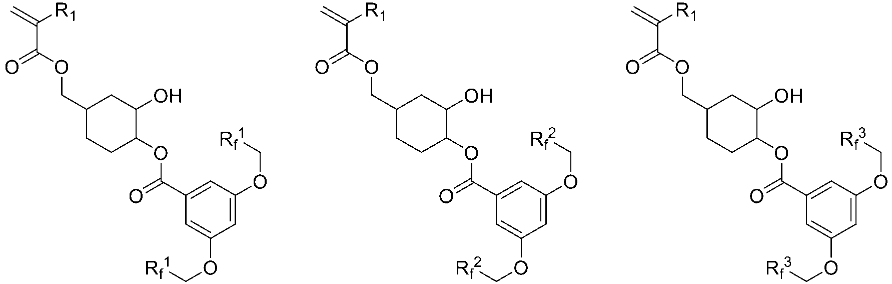

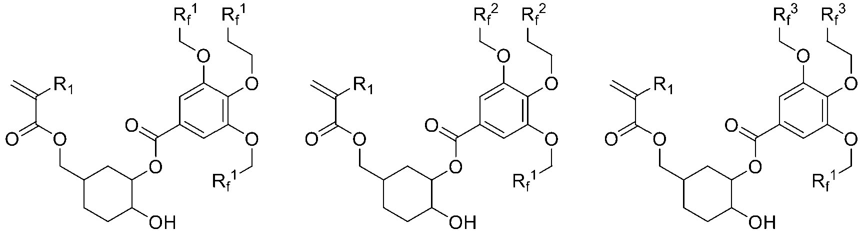

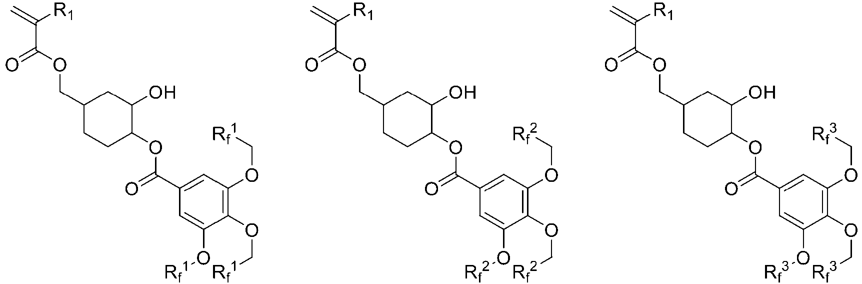

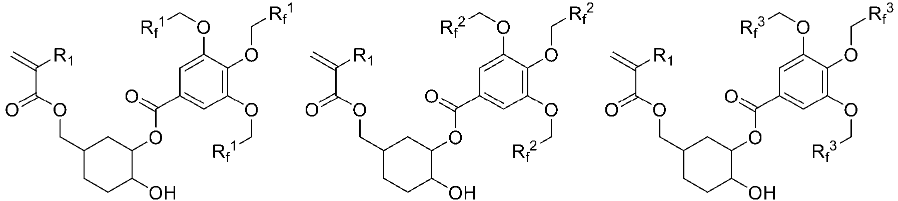

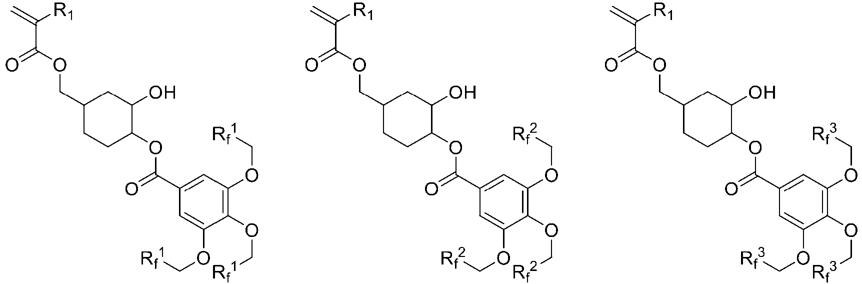

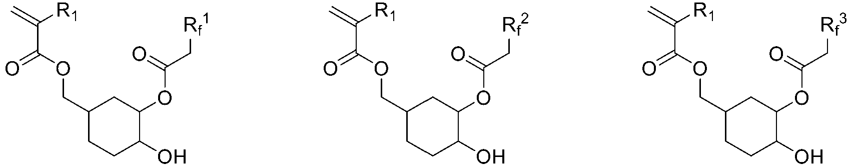

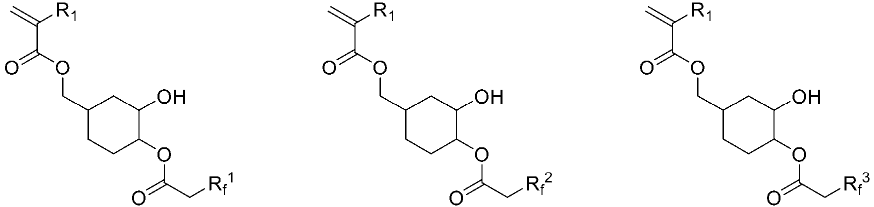

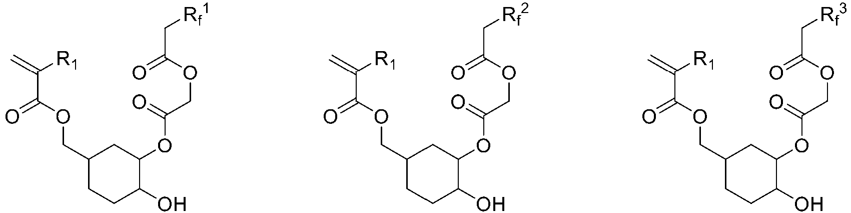

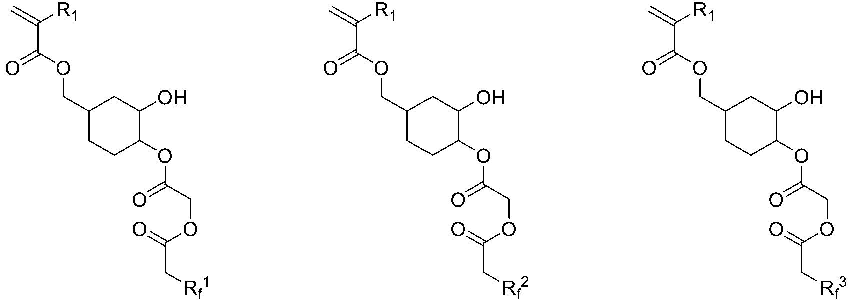

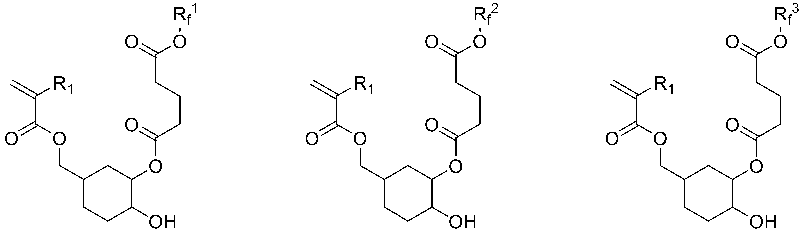

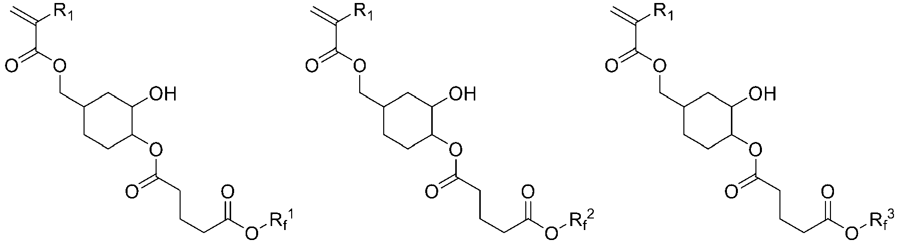

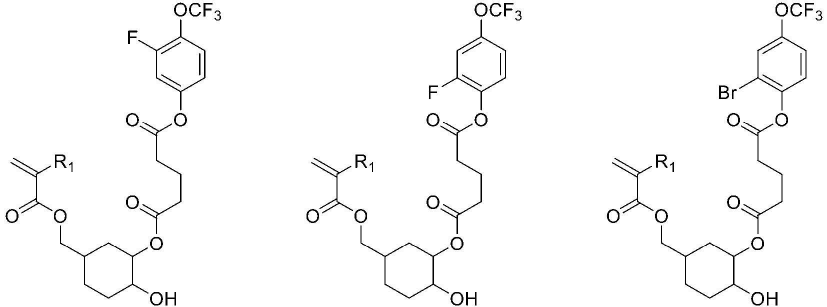

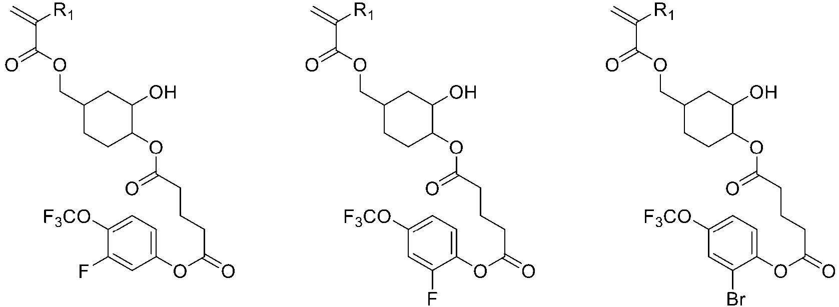

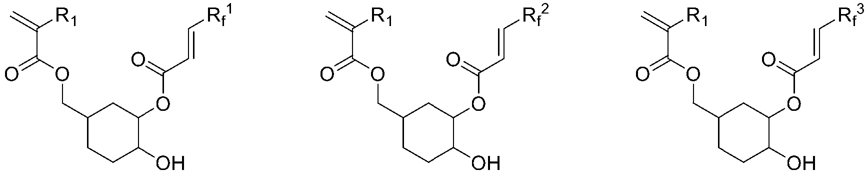

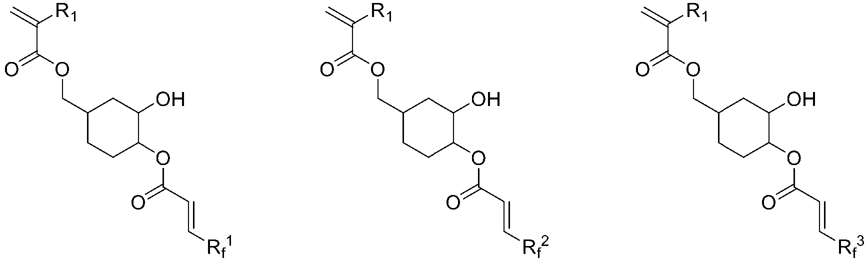

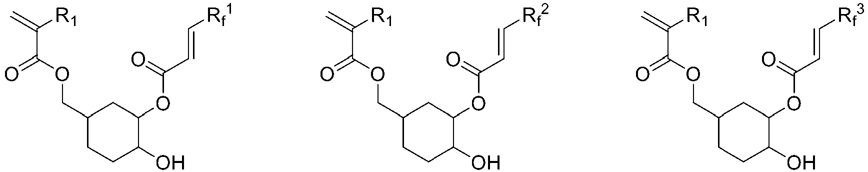

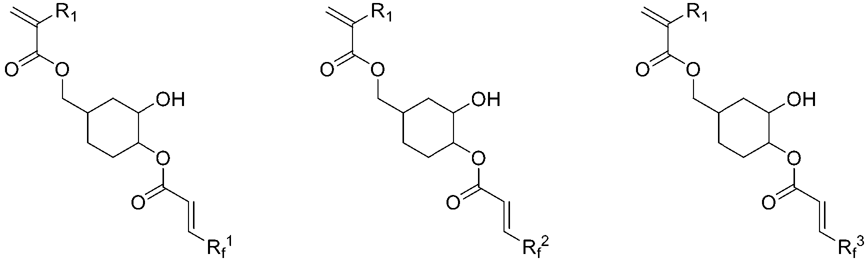

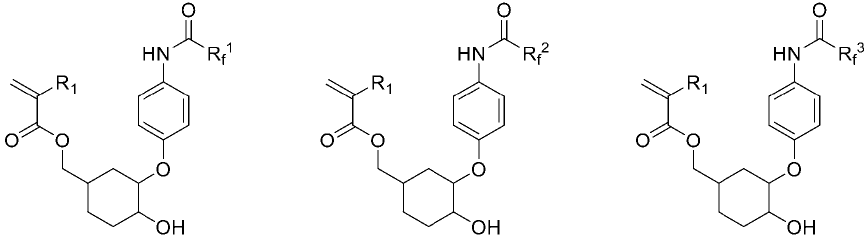

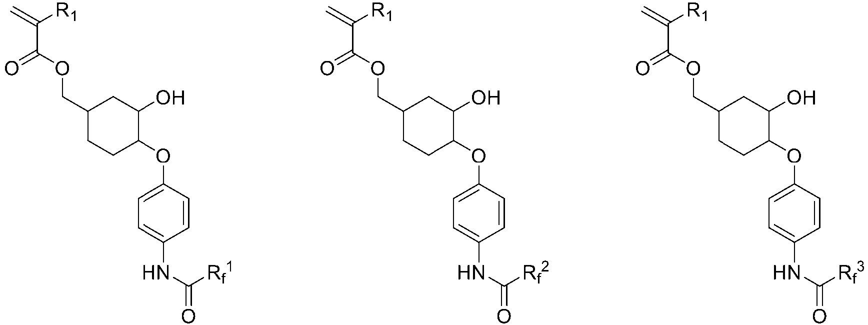

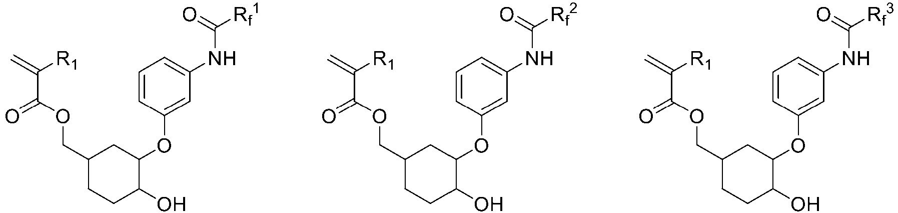

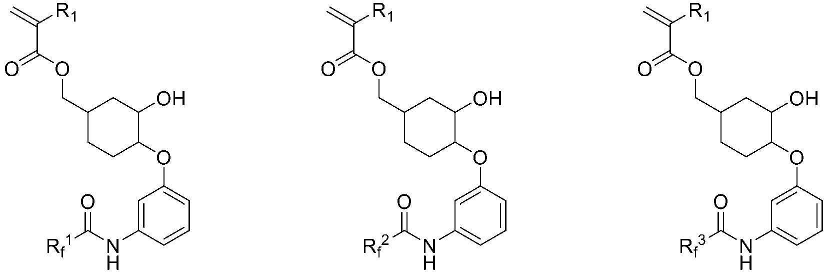

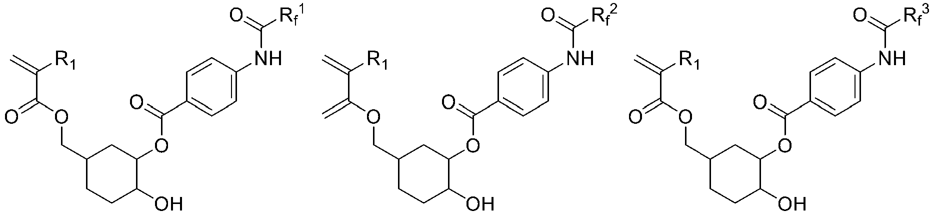

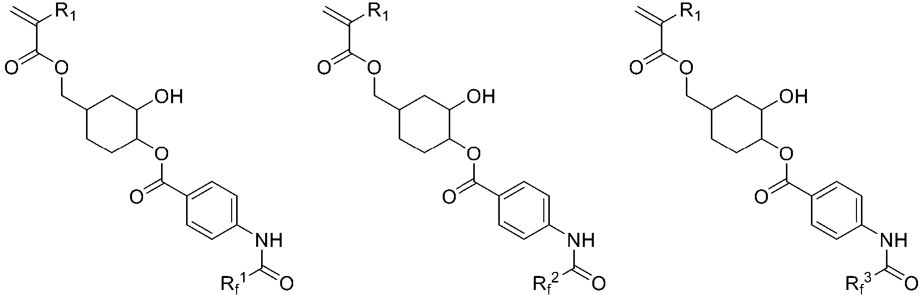

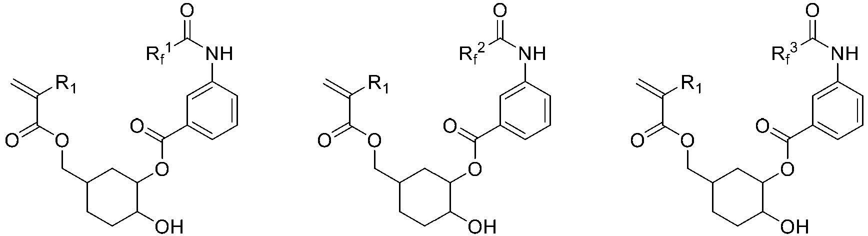

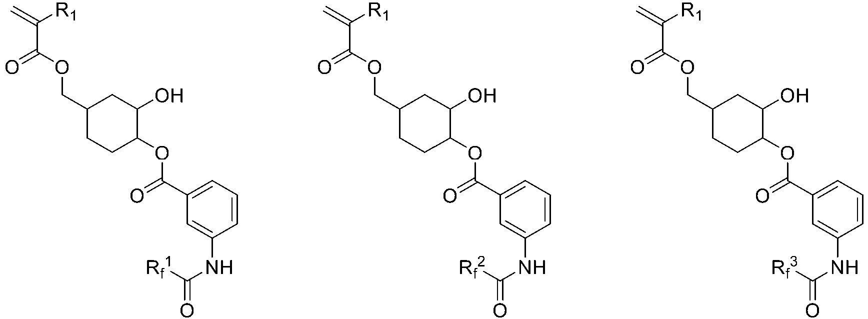

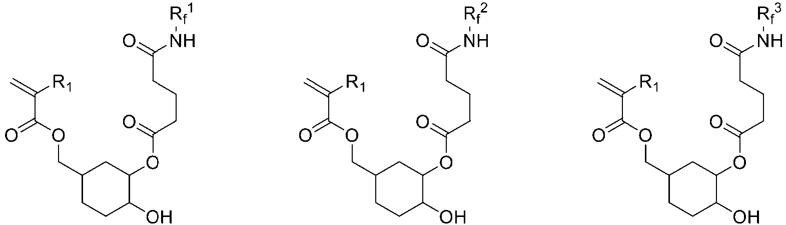

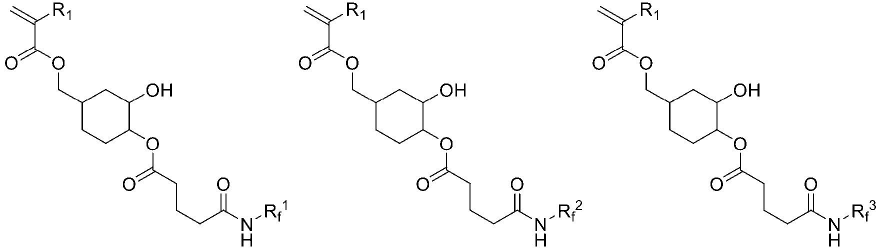

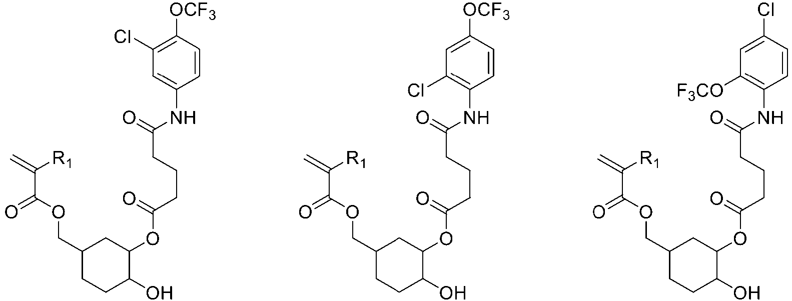

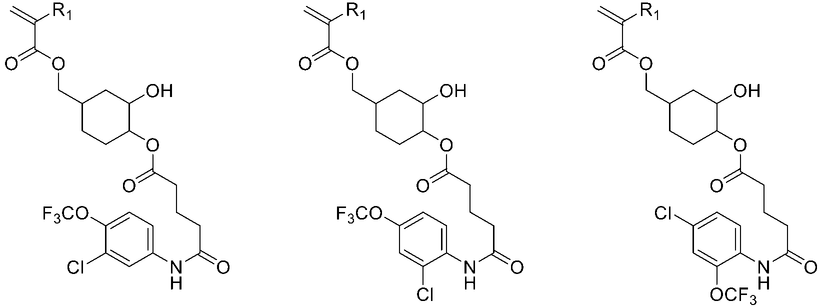

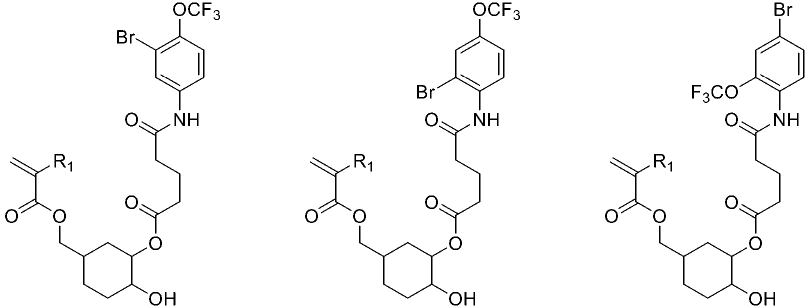

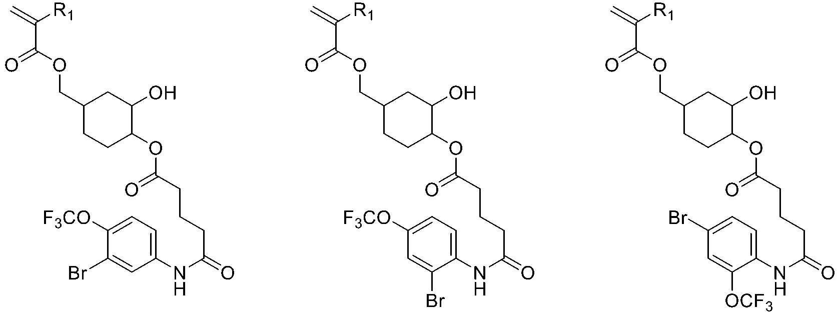

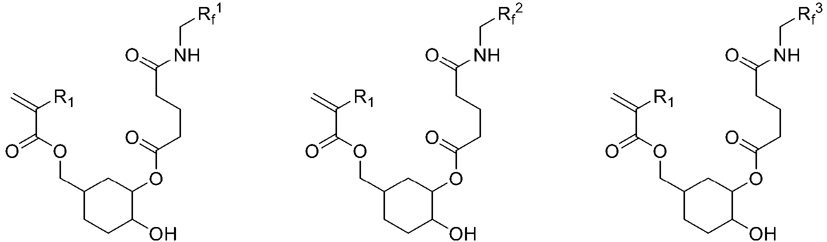

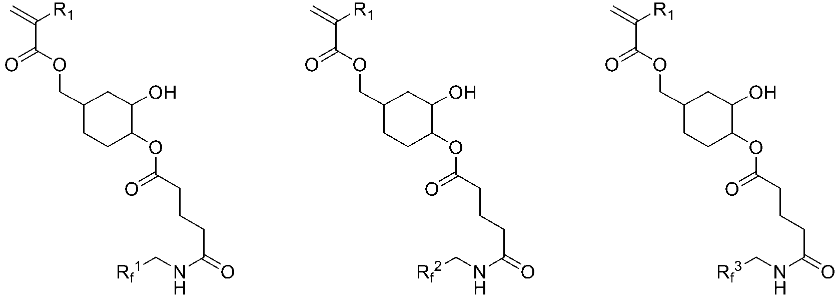

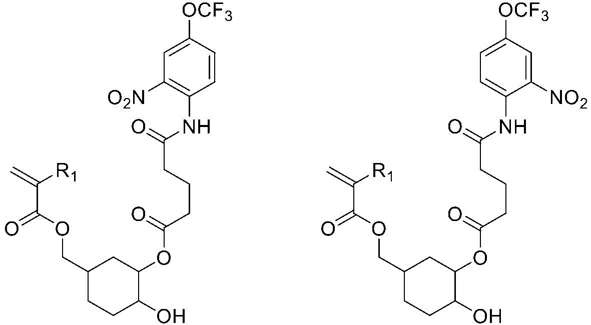

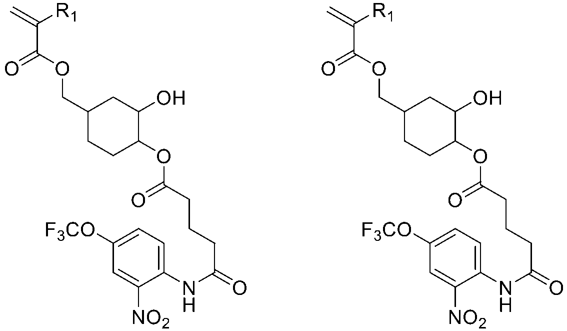

In the formulae, R₁, R_{f}¹, R_{f}², and R_{f}³ are as defined above.

Preferable examples of the monomer represented by the general formula (2') include the following, but are not limited thereto.

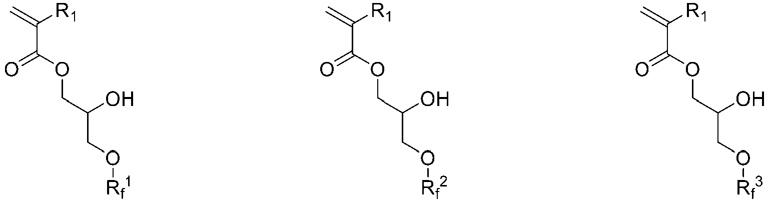

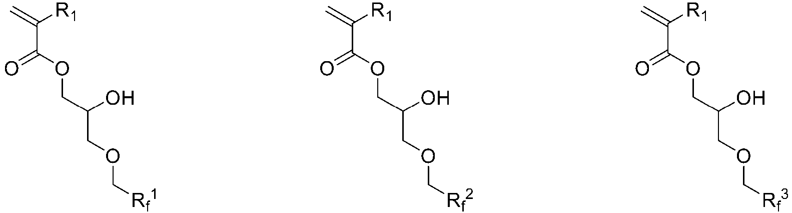

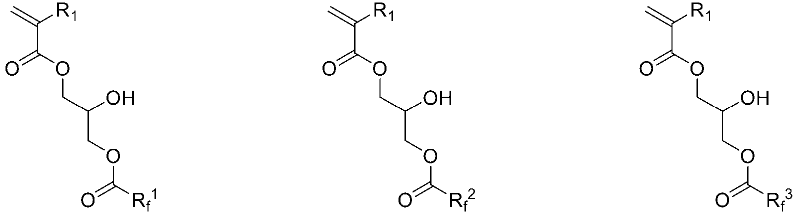

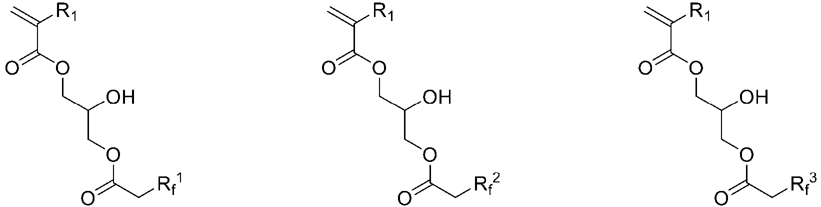

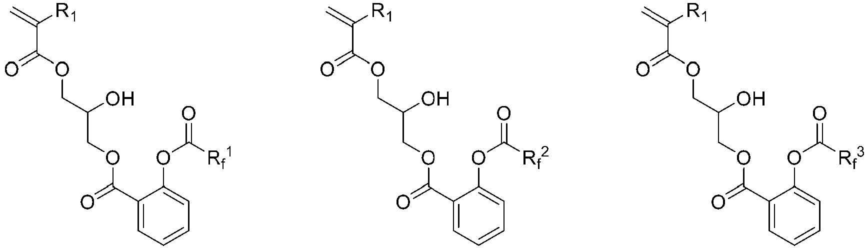

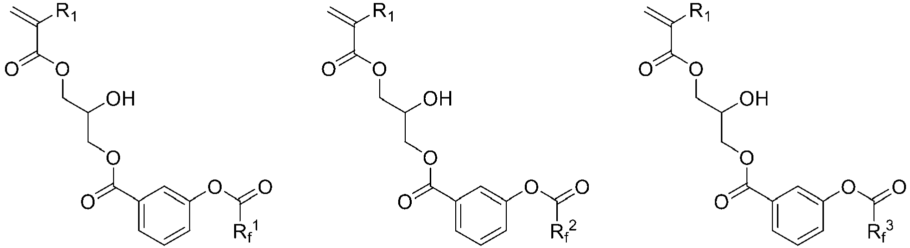

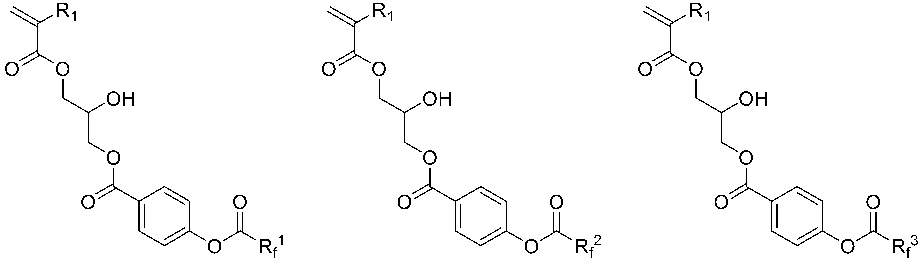

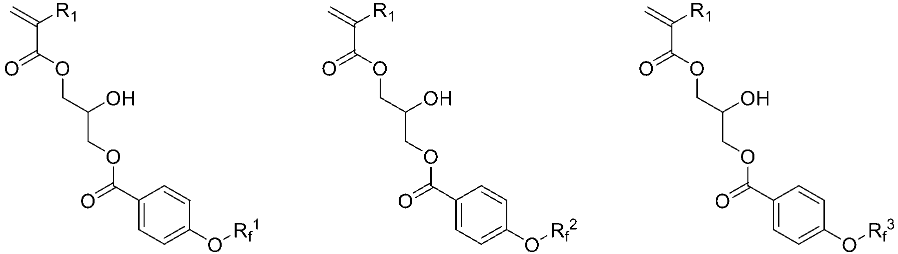

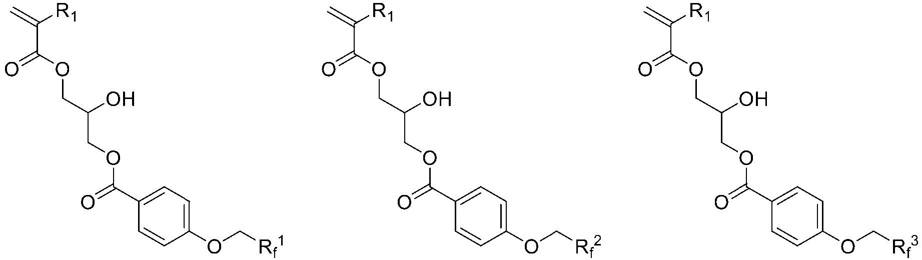

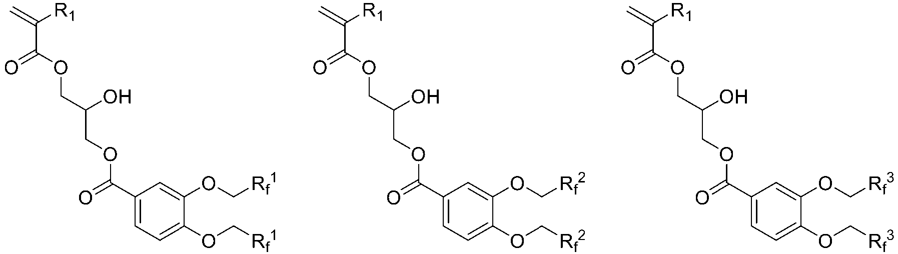

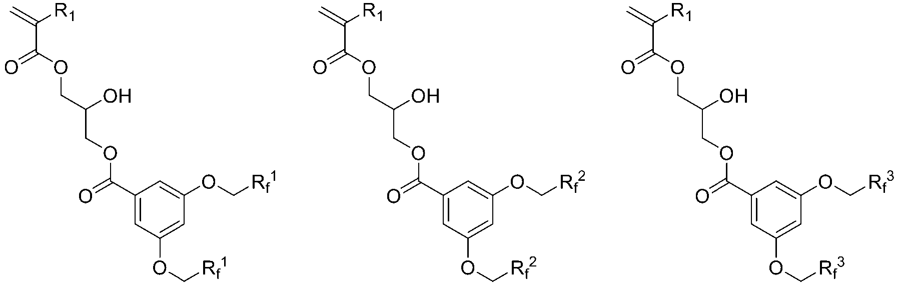

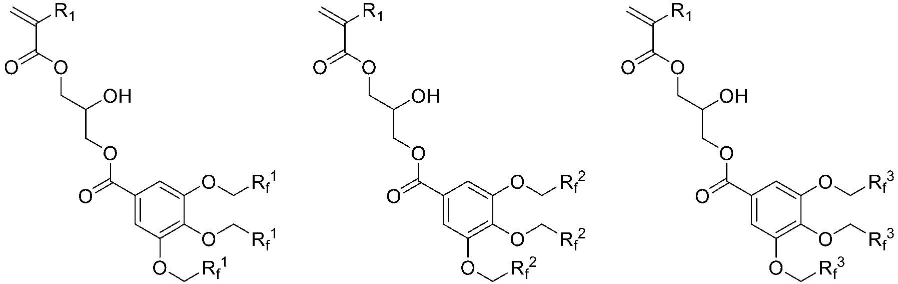

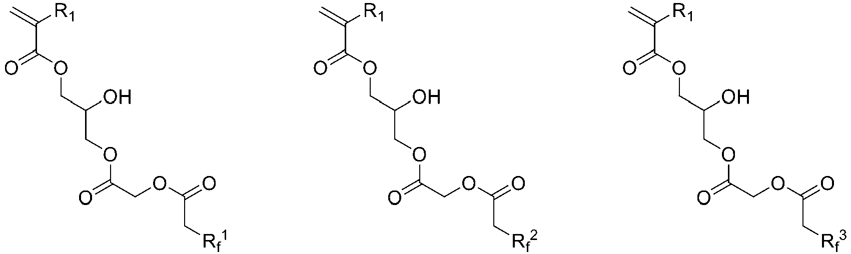

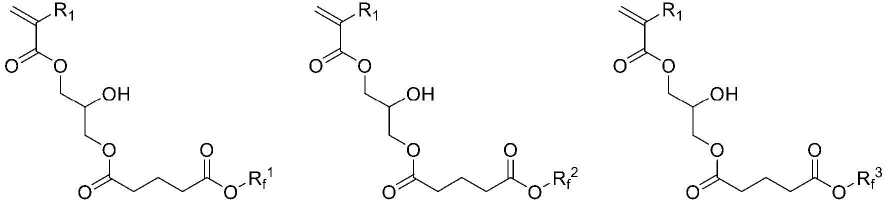

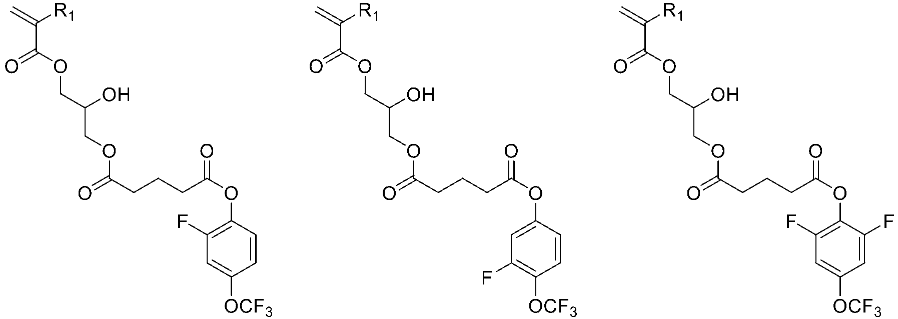

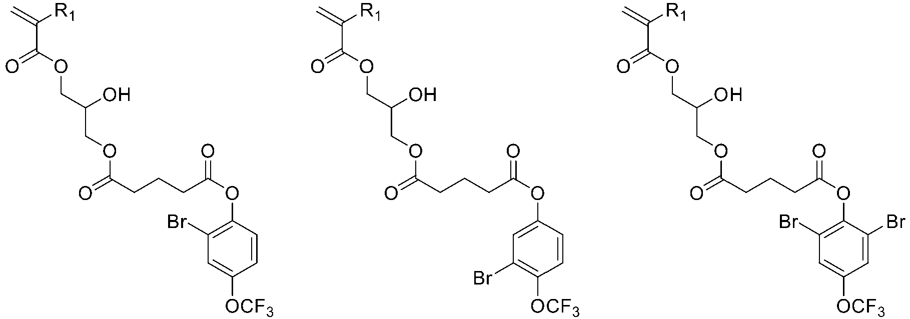

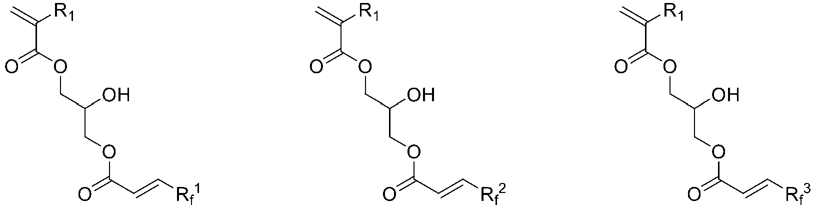

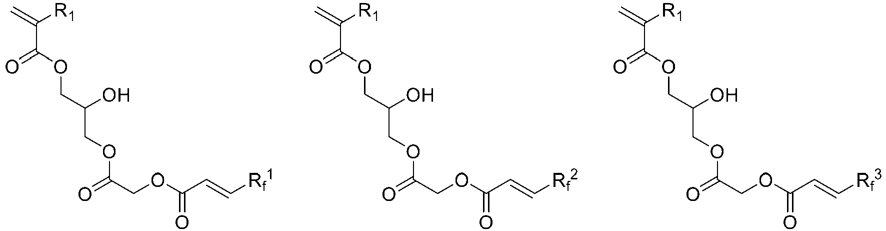

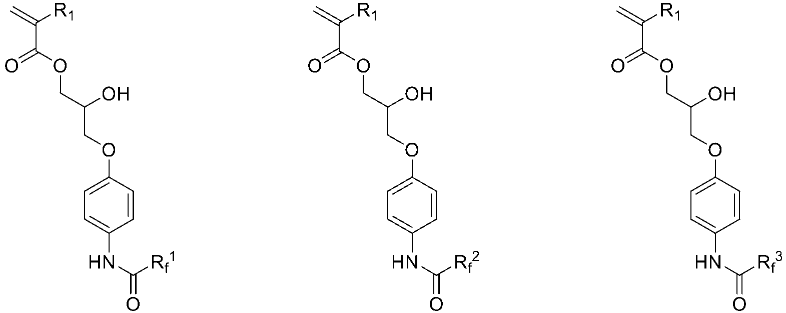

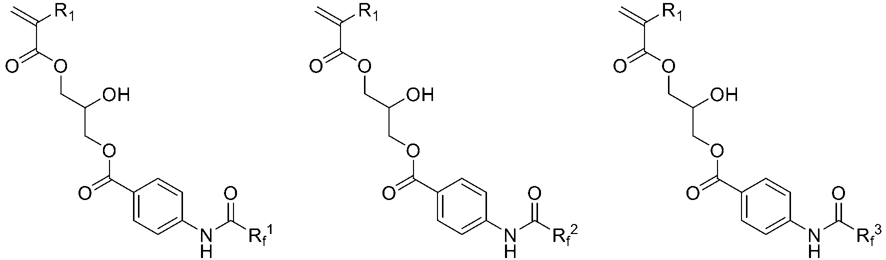

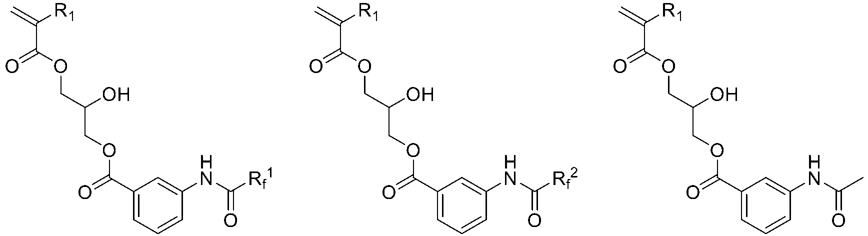

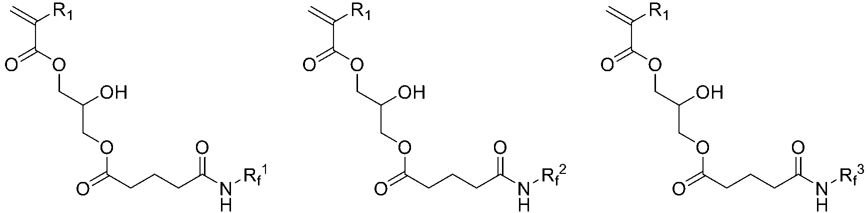

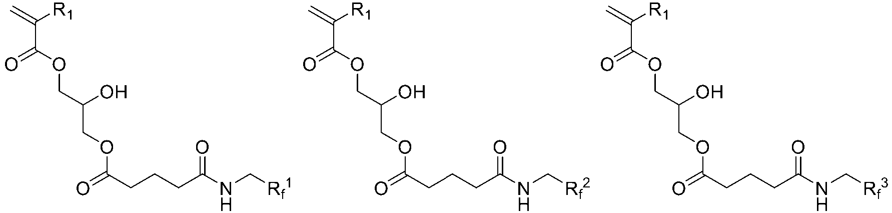

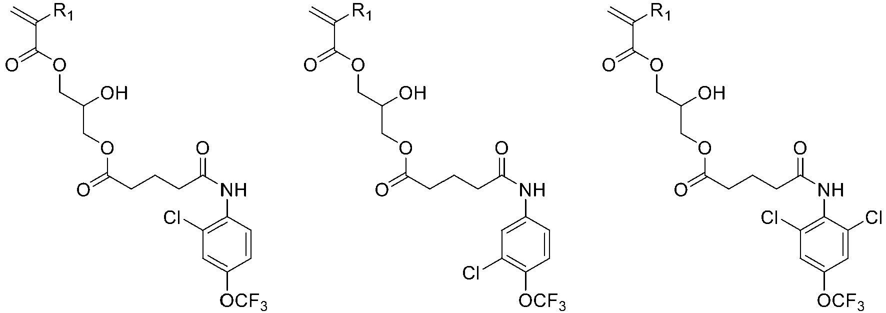

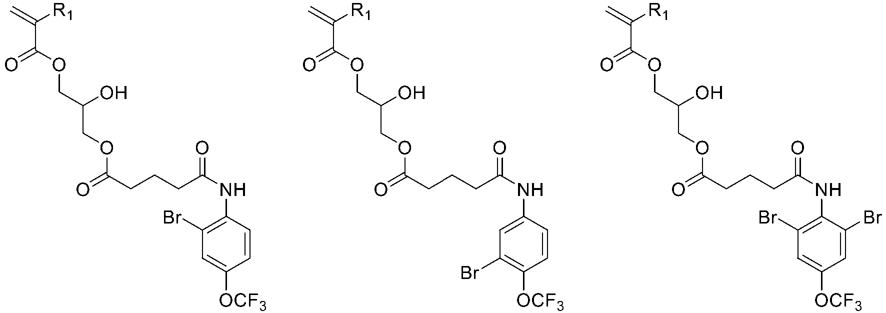

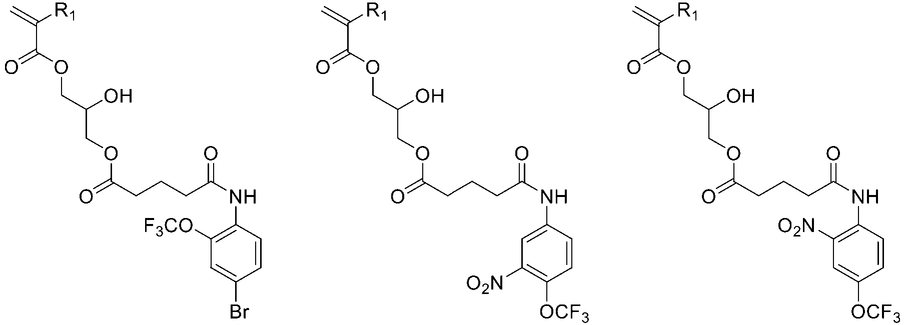

In the formulae, R₁, R_{f}¹, R_{f}², and R_{f}³ are as defined above.

The monomers represented by the general formulae (1') and (2') are extremely useful as monomers for polymers to be used as surfactants for forming an organic film. These monomers can realize high surface tension control by a hydroxy group, being a polar group, and trifluoromethoxybenzene, being a hydrophobic group, being positioned in a linking group and a terminal group of the monomer.

In the monomers represented by the general formulae (1') and (2'), it is preferable that a partial structure of R₂ contains any of the structures represented by the following general formulae (4).

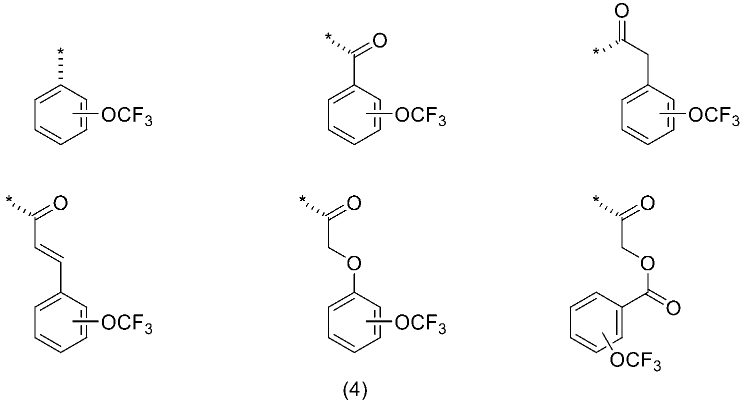

In the formulae (4), "*" and a broken line represent an attachment point in a structure in the R₂.

Preferable examples of monomers having such structures include the following, but are not limited thereto.

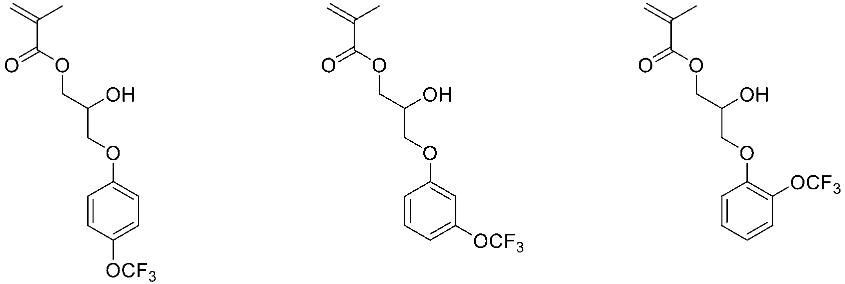

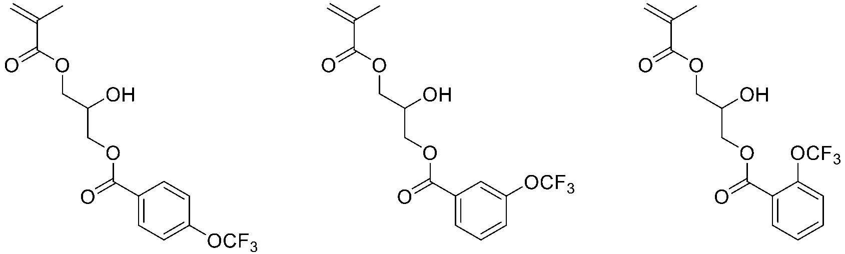

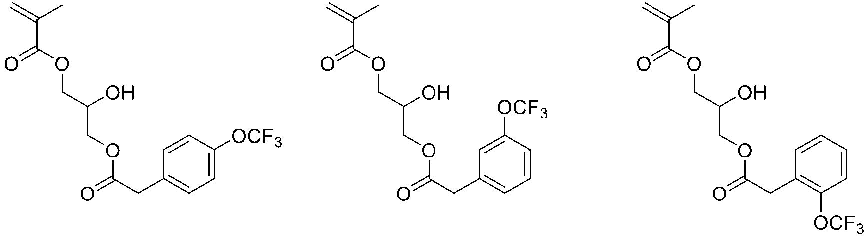

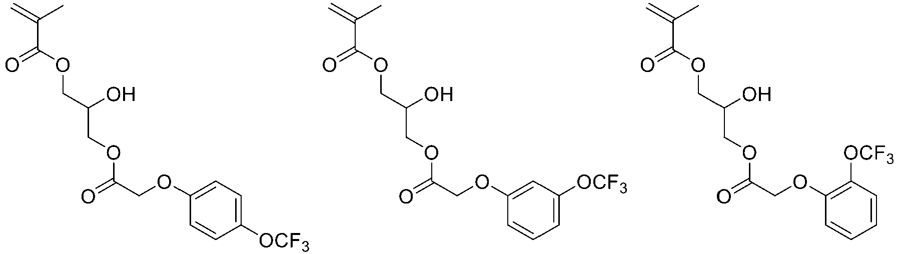

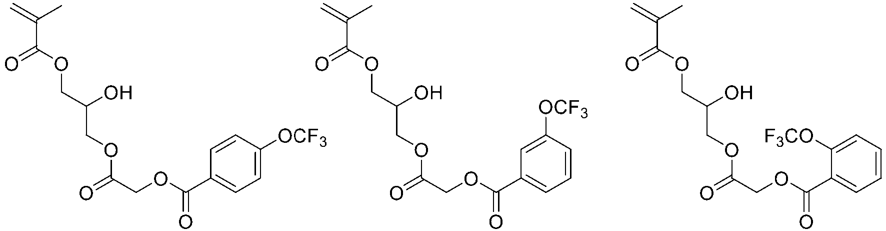

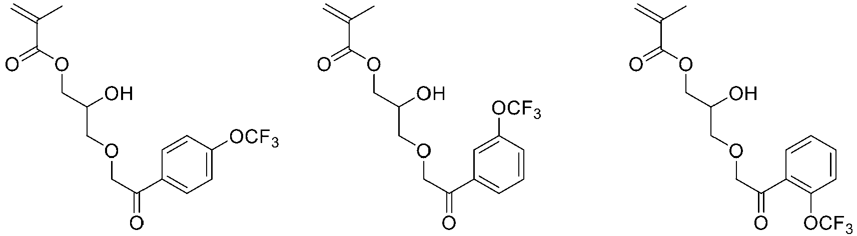

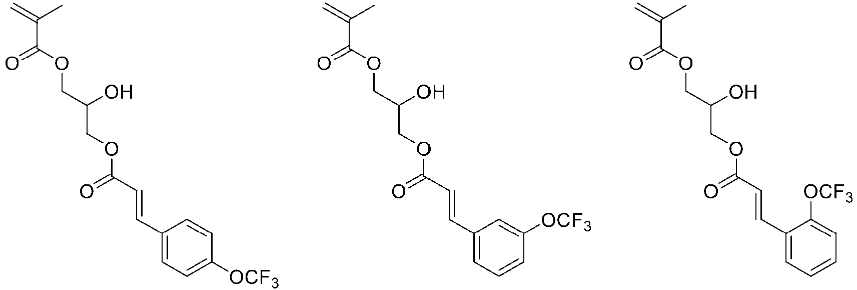

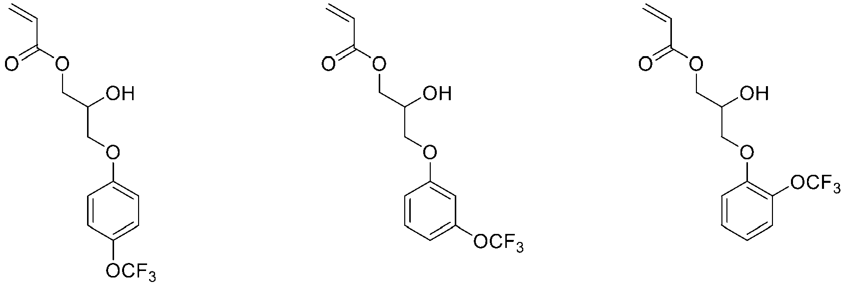

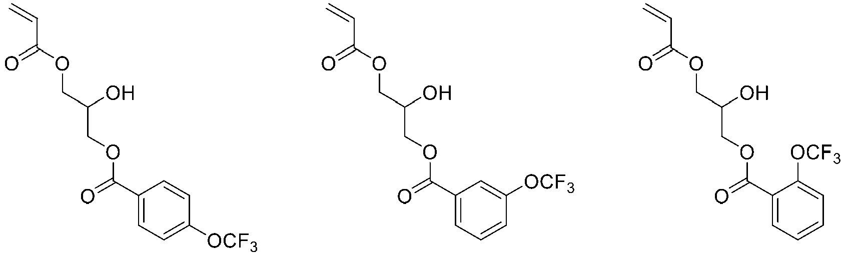

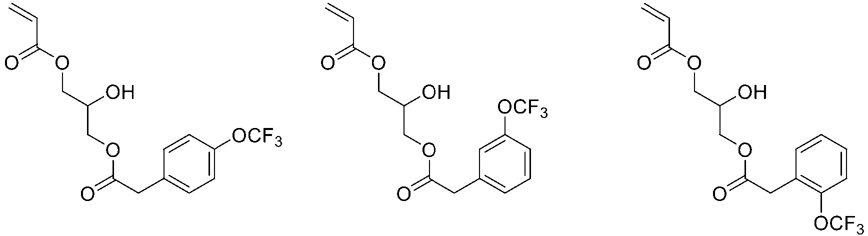

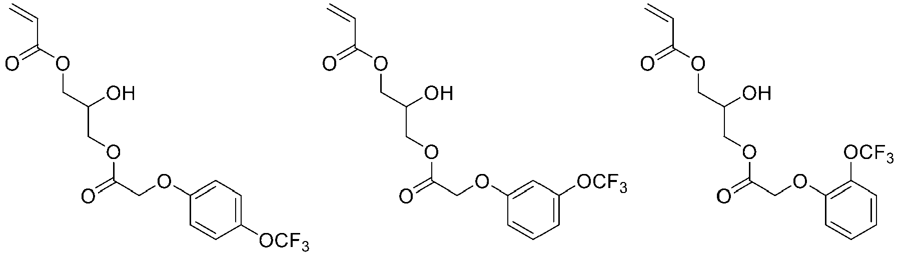

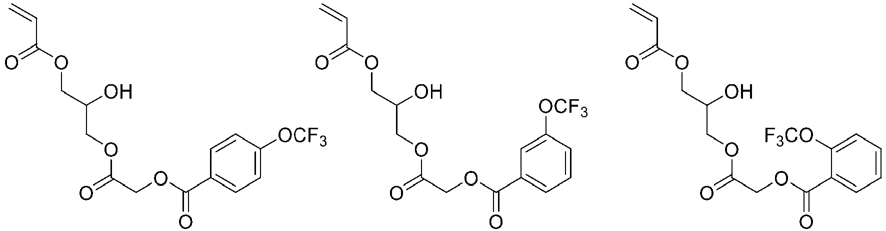

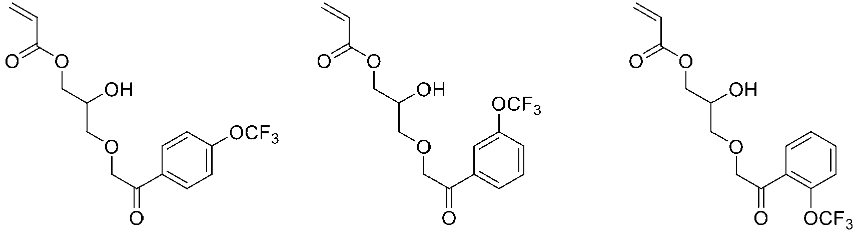

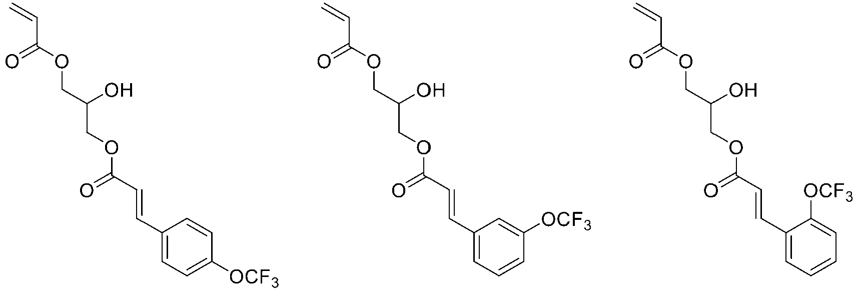

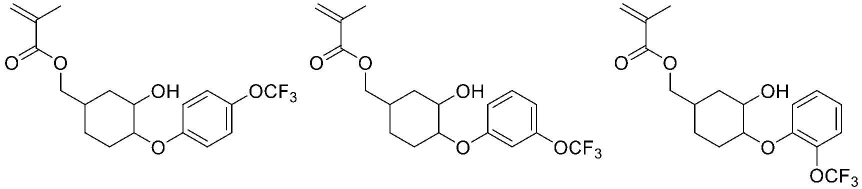

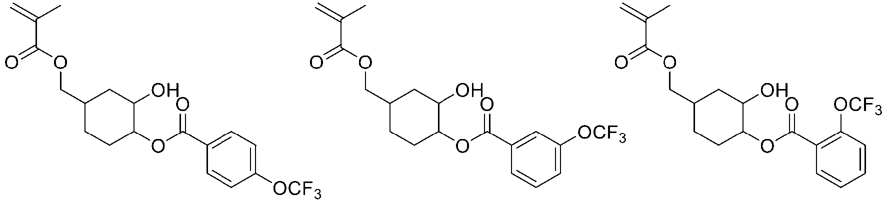

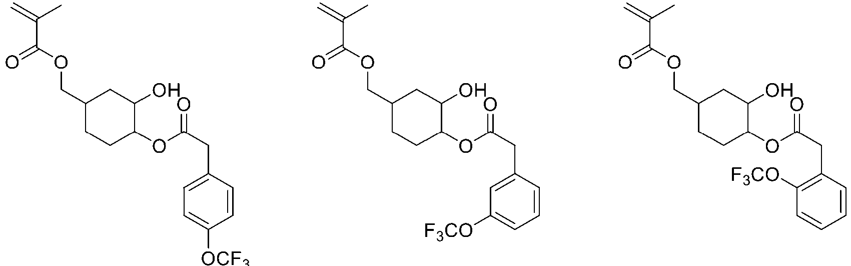

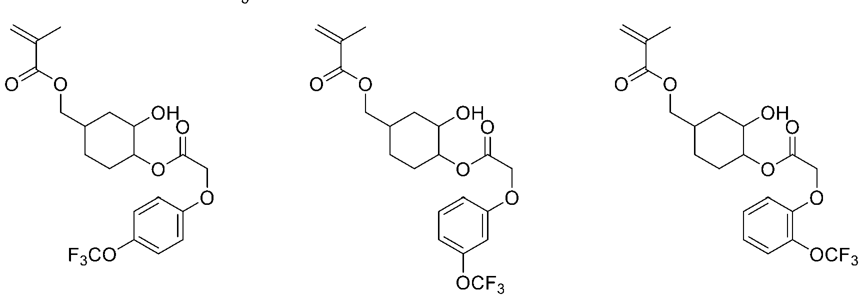

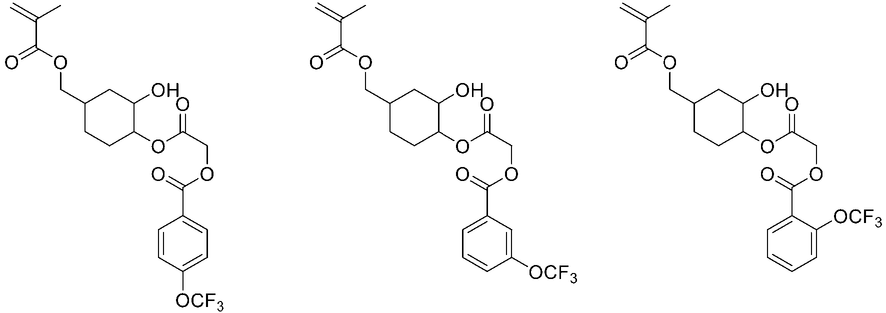

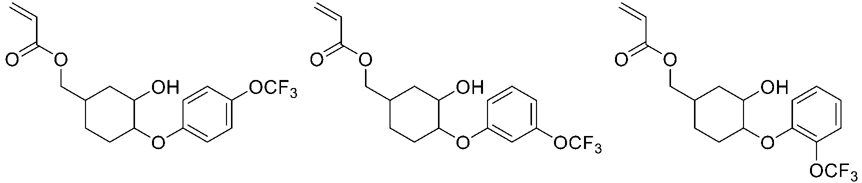

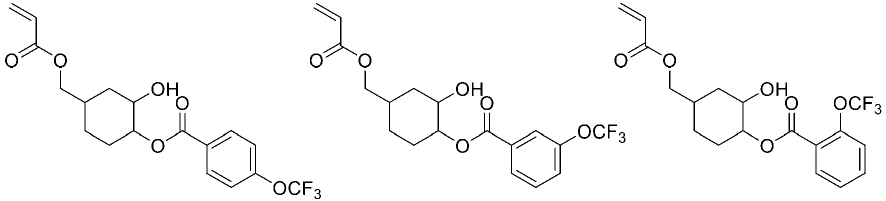

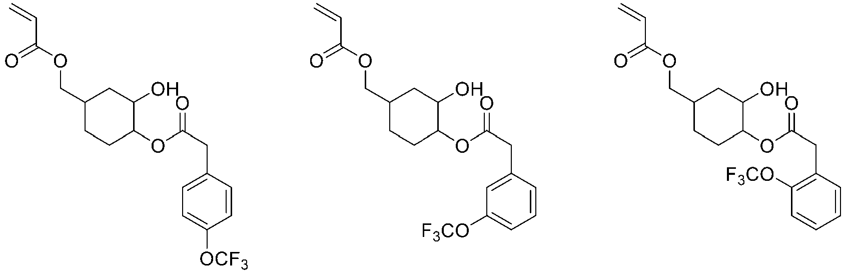

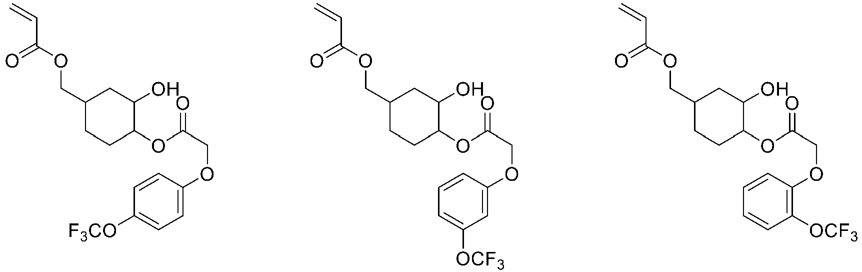

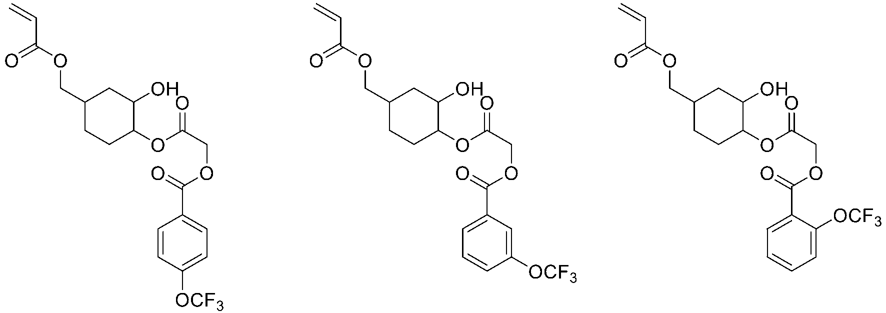

In a polymer synthesized using these monomers, surface tension can be reduced by efficient interaction between hydroxy groups or between the aromatic ring and the trifluoromethoxy group of the trifluoromethoxybenzene, and as a result, enhancement of surface active effect and improvement in film-formability can be expected.

In particular, polymers having the partial structure represented by the general formula (2) are more preferable from the viewpoint of hump suppression, and polymers in which R₁ is a methyl group are further preferable from the viewpoint of the toxicity of starting materials. Furthermore, polymers in which the trifluoromethoxy group is a substituent in the para position relative to the substituent in which the "*" is an attachment point are particularly preferable from the viewpoint of surface active effect.

The polymer (B2) can be synthesized using one or both of the monomers represented by the formula (1') or (2') and the monomer represented by the following general formula (5').

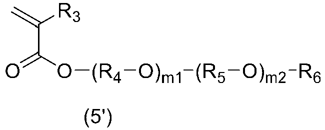

In the formula (5'), R₃ represents a hydrogen atom or a methyl group; R₄ and R₅ each represent a linear or branched divalent alkylene group having 1 to 4 carbon atoms; R₆ represents a hydrogen atom, an alkyl group having 1 to 4 carbon atoms, or a phenyl group; and "m1" and "m2" each represent an integer of 0 to 23 and satisfy 23 ≥ m1+m2 ≥ 2.

When the polymer (B2) is a copolymer having such a partial structure, a surfactant that makes it possible to form a film without dependence on film thickness can be realized.

The above-described R₄ and R₅ each represent a linear or branched divalent alkylene group having 1 to 4 carbon atoms. Specific examples of the linear or branched divalent alkylene group having 1 to 4 carbon atoms include a methylene group, an ethylene group, a propylene group, a butylene group, a trimethylene group, and a tetramethylene group. Among these, an ethylene group is more preferable from the viewpoint of void-elimination in film formation. The array of (R₄-O) and (R₅-O) in the formula may be any of random, block, or multiblock.

The above-described R₆ represents a hydrogen atom, an alkyl group having 1 to 4 carbon atoms, or a phenyl group. Specific examples of the alkyl group having 1 to 4 carbon atoms include a methyl group, an ethyl group, a propyl group, an isopropyl group, an n-butyl group, an s-butyl group, a t-butyl group, and an isobutyl group. In particular, a hydrogen atom, a methyl group, an ethyl group, or a phenyl group is more preferable. From the availability of raw materials, a hydrogen atom or a methyl group is preferable.

The above-described "m1" represents 0 to 23, "m2" represents 0 to 23, and "m1" and "m2" satisfy 23 ≥ m1+m2 ≥ 2. Here, "m1" and "m2" each represent an average repeating number. The upper limit of "m1" and "m2" is 23, and from the viewpoint of storage stability at low temperature, "m1" and "m2" more preferably satisfy 9 ≤ m1+m2 ≤ 13.

Preferable examples of the monomer represented by the general formula (5') include the following, but are not limited thereto.

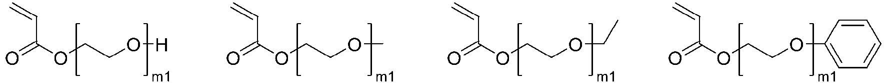

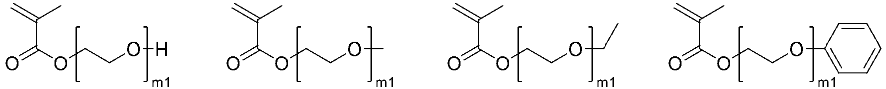

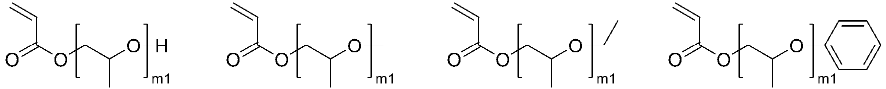

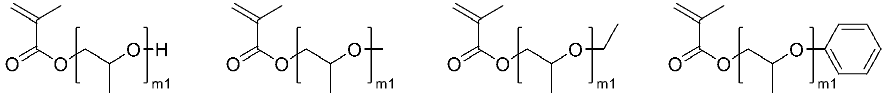

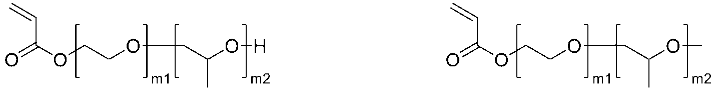

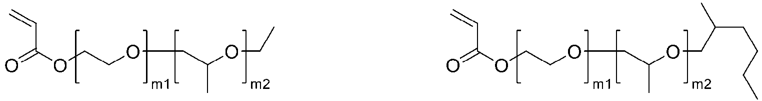

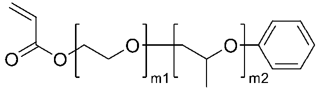

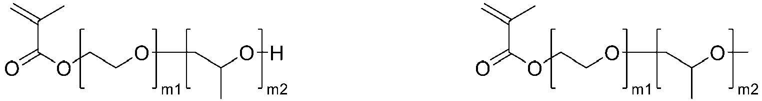

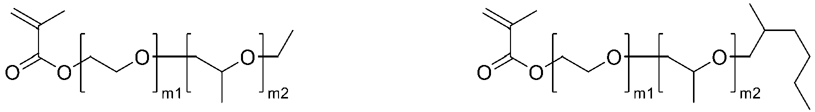

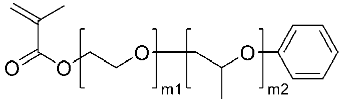

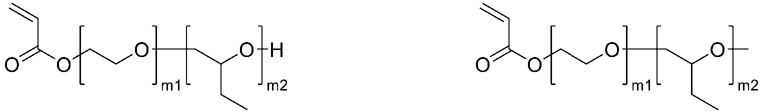

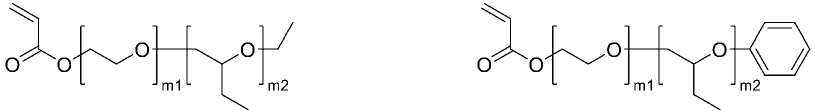

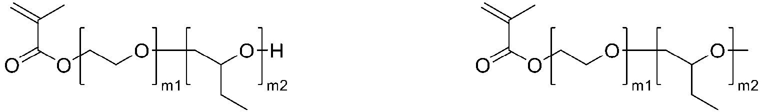

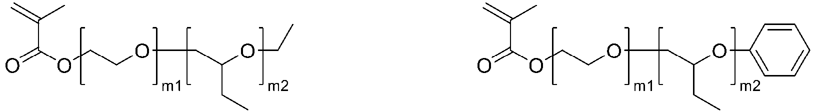

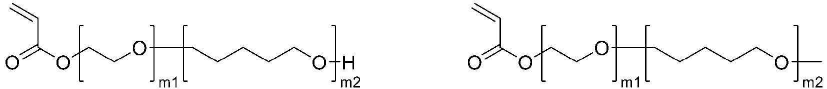

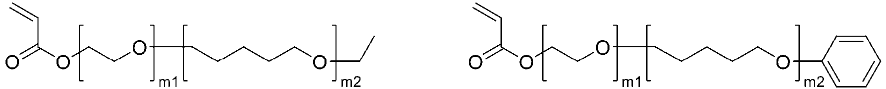

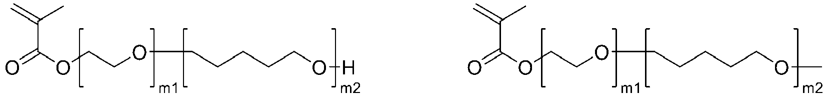

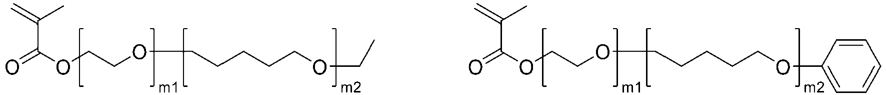

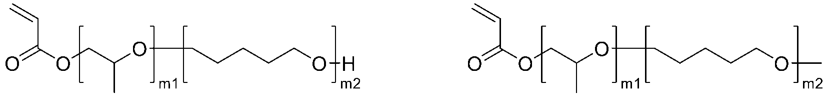

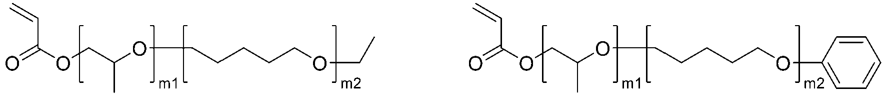

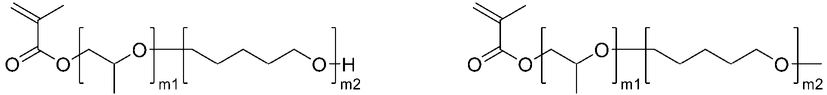

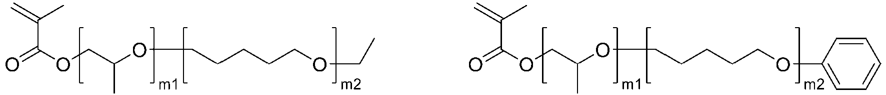

In the formulae, "m1" and "m2" are as defined above.

### <<Method for Synthesizing Polymer>>

The polymers (B), (B1), and (B2) used in the present invention can be synthesized using a monomer represented by the formula (1'), (2'), or (5'). Specifically, a polymer can be obtained by polymerizing the unsaturated bond of the monomer by using a method such as radical polymerization as shown in the following reaction formulae.

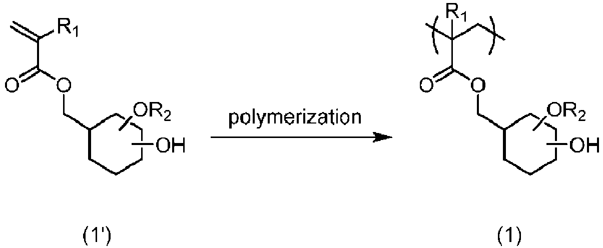

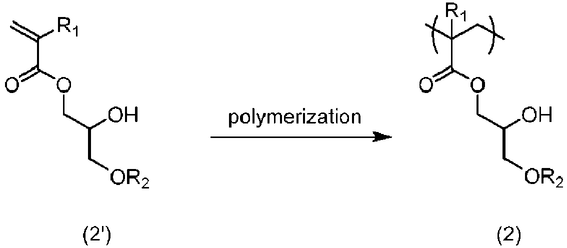

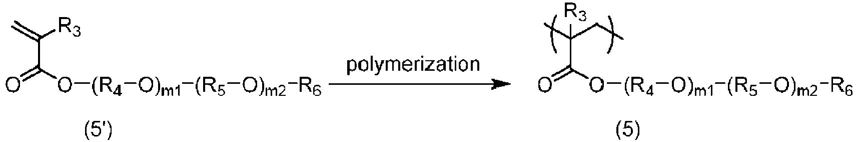

When the polymer is to be obtained by radical polymerization, examples of synthesis methods include a method of blending the monomers at a favorable content ratio in accordance with the required performance of the polymer, dissolving the monomers in an organic solvent, and then adding a radical polymerization initiator and heating for polymerization.

Examples of the organic solvent used for the polymerization include toluene, benzene, tetrahydrofuran (THF), diethyl ether, dioxane, cyclohexane, cyclopentane, methyl ethyl ketone (MEK), propylene glycol monomethyl ether acetate (PGMEA), and γ-butyrolactone (GBL). However, the organic solvent is not limited thereto.

Examples of the radical polymerization initiator used for the polymerization include 2,2'-azobisisobutyronitrile (AIBN), 2,2'-azobis(2,4-dimethylvaleronitrile), dimethyl-2,2'-azobis(2-methylpropionate), 1,1'-azobis(1-acetoxy-1-phenylethane), benzoyl peroxide, and lauroyl peroxide. However, the radical polymerization initiator is not limited thereto.

The amount of these radical polymerization initiators to be added is selected according to the degree of polymerization and molecular weight of the polymer, and is preferably 0.01 to 25 mol% relative to the total amount of the monomers to be polymerized.

These polymerization initiators may be added to the monomer solution and supplied to a reaction vessel, or an initiator solution may be prepared separately from the monomer solution, and each solution may be supplied to the reaction vessel independently. The polymerization reaction may progress due to radicals generated from the initiator during waiting time and an ultra-high-molecular-weight polymer may be generated, and therefore, from the viewpoint of quality control, the monomer solution and the initiator solution are preferably each prepared independently and added dropwise.

In addition, for adjusting the molecular weight, a known chain transfer agent, such as dodecyl mercaptan and 2-mercaptoethanol, may also be used. In this case, the amount of these chain transfer agents to be added is preferably 0.01 to 20 mol% relative to the total amount of the monomer to be polymerized.

The polymerization temperature is selected according to the decomposition temperature of the radical polymerization initiator and so forth, and is preferably 50 to 150°C, more preferably 60 to 100°C. In addition, the reaction time is preferably 2 to 24 hours, and from the viewpoint of production efficiency, more preferably 2 to 18 hours.

As for the polymer obtained by the above-described polymerization method, a reaction solution obtained by the polymerization reaction may be a final product. Alternatively, a powder obtained via a purification step, such as a reprecipitation method in which the polymerization solution is added into a poor solvent to obtain a powder, may be treated as a final product. From the viewpoints of operation efficiency and quality stabilization, the powder obtained in the purification step is preferably dissolved in a solvent to form a polymer solution to be operated as a final product.

Specific examples of the solvent used in this case include solvents described in paragraphs [0144] to [0145] in JP2008-111103A, and specifically include: ketones, such as cyclohexanone and methyl-2-n-pentylketone; alcohols, such as 3-methoxybutanol, 3-methyl-3-methoxybutanol, 1-methoxy-2-propanol, and 1-ethoxy-2-propanol; ethers, such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters, such as PGMEA, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; lactones, such as GBL; alcohols, such as diacetone alcohol (DAA); alcoholic solvents having a high boiling point, such as diethylene glycol, propylene glycol, glycerin, 1,4-butanediol, and 1,3-butanediol; and mixed solvents thereof.

The concentration of the polymer in the solution of the polymer solution is preferably 0.1 to 60 mass%, more preferably 1 to 50 mass%. If the concentration is too high, viscosity is increased, and handling property is degraded. Meanwhile, if the concentration is too low, the degree of freedom in the range of film thicknesses is narrowed when a surfactant is added to the final product.

### <<Filtration of Polymer>>

The polymer solution is preferably filtered using a filter. Filtration using a filter can remove foreign matters and gel, which may cause film-formation failure, and is effective in terms of quality stabilization.

Examples of the material of the filter to be used in the filtration using a filter include a fluorocarbon, cellulose, nylon, polyester, and hydrocarbon. Besides the above, a filter formed with a fluorocarbon, so-called Teflon(R), a hydrocarbon, such as polyethylene and polypropylene, or nylon can be suitably used. A pore size of the filter can be appropriately selected depending on target cleanliness, and is preferably 100 nm or smaller, and more preferably 20 nm or smaller. One of these filters may be used alone, or a plurality of these filters may be used in combination. As for the filtration method, the solution may be passed through the filter once, but the solution is preferably circulated to be filtered a plurality of times. In the step for producing the polymer solution, the filtration step may be performed in any order any number of times, but the reaction solution after the polymerization reaction, the polymer solution, or both thereof are preferably filtered.

### <<Constitution of Polymer>>

The monomers represented by the formulae (1') and (2') and the monomer represented by the formula (5') can also be used for the polymer (B) in combination. By appropriately selecting these monomers in accordance with the properties of the silicon-containing composition to which the polymer (B) is to be applied, the desired film-formability and performance adjustment can be achieved.

In the case of a copolymer, when the proportion of repeating units represented by the general formula (1) or (2) is X and the proportion of repeating units represented by (5) is Y, and X+Y=1, it is preferable that X is 0.5 or more and Y is less than 0.5, and it is more preferable that X is 0.6 or more. When the proportions are as described, the copolymer sufficiently exhibits a function as a surfactant, and a highly versatile silicon-containing composition can be realized.

### <<Molecular Weight of Polymer>>

The polymer (B) preferably has a weight-average molecular weight of 1,500 to 30,000, more preferably 3,000 to 25,000, and further preferably 5,000 to 23,000. When the weight-average molecular weight is controlled in such ranges, a surface active effect can be exhibited stably, and a silicon-containing film excellent in film-formability and filling property can be formed. Furthermore, the contact angle on the surface of a film after film formation can be controlled to be in an appropriate range, and it is possible to form a silicon-containing film suitable for use in a reverse patterning process or a nanoimprinting process.

The polymer (B) preferably has a molecular weight distribution (Mw/Mn) of 1.0 to 5.0, more preferably 1.1 to 3.0.

### <<Amount of Polymer to Be Added>>

The inventive silicon-containing composition can contain 0.01 to 2 parts by mass (that is, 0.01 to 2% in weight percentage) of the polymer (B) when the amount of (A) the thermosetting silicon-containing resin used is considered as 100 parts by mass. When a silicon-containing composition containing the polymer (B) in such an amount is applied, it is possible to obtain a silicon-containing film excellent in in-plane uniformity after film formation.

### <<Other Surfactants>>

Incidentally, the inventive silicon-containing composition can contain a surfactant other than the polymer (B) as necessary. As such a surfactant, specifically, a material disclosed in paragraph (0185) of JP2009-126940A can be contained.

### [(C) Solvent]

The inventive silicon-containing composition contains (C) a solvent. The solvent is preferably an alcohol-based solvent. Particularly preferable examples include monoalkyl ether derivatives of ethylene glycol, diethylene glycol, triethylene glycol, propylene glycol, dipropylene glycol, butanediol, etc. Specifically, preferable are ethylene glycol monomethyl ether, ethylene glycol monoethyl ether, ethylene glycol monopropyl ether, propylene glycol monomethyl ether, propylene glycol monoethyl ether, propylene glycol monopropyl ether, butanediol monomethyl ether, butanediol monoethyl ether, butanediol monopropyl ether, diacetone alcohol, etc.

Furthermore, a non-alcohol-based solvent can also be added as an adjuvant solvent. Examples of the adjuvant solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, and cyclopentyl methyl ether. However, the adjuvant solvent is not limited thereto.

Furthermore, the inventive silicon-containing composition may contain water in (C) the solvent. When water is contained, the electric charge of the silanol groups in the thermosetting silicon-containing resin is stabilized, and it is possible to suppress the condensation reaction of silanol groups. As a result, reactions, such as gelation, and change in performance can be suppressed from production until actual use, and a silicon-containing composition having favorable storage stability can be provided.

The water content in (C) the solvent can be more than 0 mass% and less than 50 mass%, particularly preferably 0.3 to 30 mass%, and further preferably 0.5 to 20 mass%.

The total amount of (C) the solvent used is preferably 100 to 100,000 parts by mass, particularly preferably 200 to 50,000 parts by mass, based on 100 parts by mass of (A) the thermosetting silicon-containing resin (Sx), being the base polymer.

### [(D) Curing Catalyst]

The inventive silicon-containing composition can further contain (D) a curing catalyst. Examples of curing catalysts include compounds represented by the following general formula (Xc).

LₐₓH_{bx}A (Xc)

In the formula, L represents lithium, sodium, potassium, rubidium, cesium, sulfonium, iodonium, phosphonium, or ammonium; A represents a non-nucleophilic counter ion; "ax" represents an integer of 1 or more; "bx" represents 0 or an integer of 1 or more; and ax+bx is the valence of the non-nucleophilic counter ion.

Specific examples of (Xc) include sulfonium salts of the following general formula (Xc-1), iodonium salts of (Xc-2), phosphonium salts of (Xc-3), ammonium salts of (Xc-4), alkaline metal salts, etc.

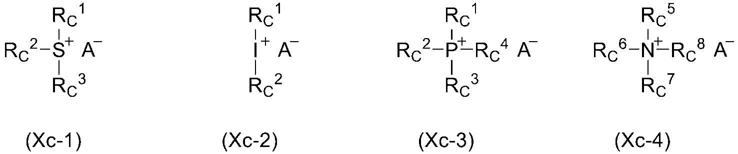

In the formulae, R_{C}¹, R_{C}², R_{C}³, and R_{C}⁴ each represent a linear, branched, or cyclic alkyl group, alkenyl group, oxoalkyl group, or oxoalkenyl group having 1 to 12 carbon atoms, a substituted or unsubstituted aryl group having 6 to 20 carbon atoms, or an aralkyl group or aryloxoalkyl group having 7 to 12 carbon atoms; part or all of the hydrogen atoms of these groups are optionally substituted with an alkoxy group or the like. R_{C}⁵, R_{C}⁶, R_{C}⁷, and R_{C}⁸ are identical to R_{C}¹, R_{C}², R_{C}³, and R_{C}⁴, but may also be a hydrogen atom. A⁻represents a non-nucleophilic counter ion. R_{C}² and R_{C}³ may form a ring, and when a ring is formed, R_{C}² and R_{C}³ each represent an alkylene group having 1 to 6 carbon atoms. R_{C}⁵ and R_{C}⁶ and R_{C}⁵, R_{C}⁶, and R_{C}⁷ may form a ring, and when a ring is formed, R_{C}⁵ and R_{C}⁶ and R_{C}⁵, R_{C}⁶, and R_{C}⁷ each represent an alkylene group having 3 to 10 carbon atoms.

R_{C}¹, R_{C}², R_{C}³, R_{C}⁴, R_{C}⁵, R_{C}⁶, R_{C}⁷, and R_{C}⁸ may be identical to or different from one another. Specifically, examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, etc. Examples of groups including cyclic alkyl groups include a cyclopentyl group, a cyclohexyl group, a cycloheptyl group, a cyclopropylmethyl group, a 4-methylcyclohexyl group, a cyclohexylmethyl group, a norbornyl group, an adamantyl group, etc. Examples of the alkenyl group include a vinyl group, an allyl group, a propenyl group, a butenyl group, a hexenyl group, a cyclohexenyl group, etc. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, etc. Examples of the aryl group include a phenyl group, a naphthyl group, etc. Examples of alkoxyphenyl groups include a p-methoxyphenyl group, an m-methoxyphenyl group, an o-methoxyphenyl group, an ethoxyphenyl group, a p-tert-butoxyphenyl group, an m-tert-butoxyphenyl group, etc. Examples of alkylphenyl groups include a 2-methylphenyl group, a 3-methylphenyl group, a 4-methylphenyl group, an ethylphenyl group, a 4-tert-butylphenyl group, a 4-butylphenyl group, a dimethylphenyl group, etc. Examples of alkylnaphthyl groups include a methylnaphthyl group, an ethylnaphthyl group, etc. Examples of alkoxynaphthyl groups include a methoxynaphthyl group, an ethoxynaphthyl group, etc. Examples of dialkylnaphthyl groups include a dimethylnaphthyl group, a diethylnaphthyl group, etc. Examples of dialkoxynaphthyl groups include a dimethoxynaphthyl group, a diethoxynaphthyl group, etc. Examples of the aralkyl group include a benzyl group, a phenylethyl group, a phenethyl group, etc. Examples of the aryloxoalkyl group include a 2-phenyl-2-oxoethyl group, a 2-(1-naphthyl)-2-oxoethyl group, a 2-(2-naphthyl)-2-oxoethyl group, etc.

Specific examples of the non-nucleophilic counter ion A⁻ include monovalent ions, such as hydroxide ion, formate ion, acetate ion, propionate ion, butanoate ion, pentanoate ion, hexanoate ion, heptanoate ion, octanoate ion, nonanoate ion, decanoate ion, oleate ion, stearate ion, linoleate ion, linolenate ion, benzoate ion, phthalate ion, isophthalate ion, terephthalate ion, salicylate ion, trifluoroacetate ion, monochloroacetate ion, dichloroacetate ion, trichloroacetate ion, fluoride ion, chloride ion, bromide ion, iodide ion, nitrate ion, nitrite ion, chlorate ion, bromate ion, methanesulfonate ion, paratoluenesulfonate ion, and monomethylsulfate ion; monovalent or divalent ions such as oxalate ion, malonate ion, methylmalonate ion, ethylmalonate ion, propylmalonate ion, butylmalonate ion, dimethylmalonate ion, diethylmalonate ion, succinate ion, methylsuccinate ion, glutarate ion, adipate ion, itaconate ion, maleate ion, fumarate ion, citraconate ion, citrate ion, carbonate ion, sulfate ion, etc.

Specific examples of the sulfonium salt (Xc-1) include triphenylsulfonium formate, triphenylsulfonium acetate, triphenylsulfonium propionate, triphenylsulfonium butanoate, triphenylsulfonium benzoate, triphenylsulfonium phthalate, triphenylsulfonium isophthalate, triphenylsulfonium terephthalate, triphenylsulfonium salicylate, triphenylsulfonium trifluoromethanesulfonate, triphenylsulfonium trifluoroacetate, triphenylsulfonium monochloroacetate, triphenylsulfonium dichloroacetate, triphenylsulfonium trichloroacetate, triphenylsulfonium hydroxide, triphenylsulfonium nitrate, triphenylsulfonium chloride, triphenylsulfonium bromide, triphenylsulfonium oxalate, triphenylsulfonium malonate, triphenylsulfonium methylmalonate, triphenylsulfonium ethylmalonate, triphenylsulfonium propylmalonate, triphenylsulfonium butylmalonate, triphenylsulfonium dimethylmalonate, triphenylsulfonium diethylmalonate, triphenylsulfonium succinate, triphenylsulfonium methylsuccinate, triphenylsulfonium glutarate, triphenylsulfonium adipate, triphenylsulfonium itaconate, triphenylsulfonium maleate, triphenylsulfonium fumarate, triphenylsulfonium citraconate, triphenylsulfonium citrate, triphenylsulfonium carbonate, bistriphenylsulfonium oxalate, bistriphenylsulfonium maleate, bistriphenylsulfonium fumarate, bistriphenylsulfonium citraconate, bistriphenylsulfonium citrate, bistriphenylsulfonium carbonate, etc.

Specific examples of the iodonium salt (Xc-2) include diphenyliodonium formate, diphenyliodonium acetate, diphenyliodonium propionate, diphenyliodonium butanoate, diphenyliodonium benzoate, diphenyliodonium phthalate, diphenyliodonium isophthalate, diphenyliodonium terephthalate, diphenyliodonium salicylate, diphenyliodonium trifluoromethanesulfonate, diphenyliodonium trifluoroacetate, diphenyliodonium monochloroacetate, diphenyliodonium dichloroacetate, diphenyliodonium trichloroacetate, diphenyliodonium hydroxide, diphenyliodonium nitrate, diphenyliodonium chloride, diphenyliodonium bromide, diphenyliodonium iodide, diphenyliodonium oxalate, diphenyliodonium maleate, diphenyliodonium fumarate, diphenyliodonium citraconate, diphenyliodonium citrate, diphenyliodonium carbonate, bisdiphenyliodonium oxalate, bisdiphenyliodonium maleate, bisdiphenyliodonium fumarate, bisdiphenyliodonium citraconate, bisdiphenyliodonium citrate, bisdiphenyliodonium carbonate, etc.

Specific examples of the phosphonium salt (Xc-3) include tetraethylphosphonium formate, tetraethylphosphonium acetate, tetraethylphosphonium propionate, tetraethylphosphonium butanoate, tetraethylphosphonium benzoate, tetraethylphosphonium phthalate, tetraethylphosphonium isophthalate, tetraethylphosphonium terephthalate, tetraethylphosphonium salicylate, tetraethylphosphonium trifluoromethanesulfonate, tetraethylphosphonium trifluoroacetate, tetraethylphosphonium monochloroacetate, tetraethylphosphonium dichloroacetate, tetraethylphosphonium trichloroacetate, tetraethylphosphonium hydroxide, tetraethylphosphonium nitrate, tetraethylphosphonium chloride, tetraethylphosphonium bromide, tetraethylphosphonium iodide, tetraethylphosphonium oxalate, tetraethylphosphonium maleate, tetraethylphosphonium fumarate, tetraethylphosphonium citraconate, tetraethylphosphonium citrate, tetraethylphosphonium carbonate, bistetraethylphosphonium oxalate, bistetraethylphosphonium maleate, bistetraethylphosphonium fumarate, bistetraethylphosphonium citraconate, bistetraethylphosphonium citrate, bistetraethylphosphonium carbonate, tetraphenylphosphonium formate, tetraphenylphosphonium acetate, tetraphenylphosphonium propionate, tetraphenylphosphonium butanoate, tetraphenylphosphonium benzoate, tetraphenylphosphonium phthalate, tetraphenylphosphonium isophthalate, tetraphenylphosphonium terephthalate, tetraphenylphosphonium salicylate, tetraphenylphosphonium trifluoromethanesulfonate, tetraphenylphosphonium trifluoroacetate, tetraphenylphosphonium monochloroacetate, tetraphenylphosphonium dichloroacetate, tetraphenylphosphonium trichloroacetate, tetraphenylphosphonium hydroxide, tetraphenylphosphonium nitrate, tetraphenylphosphonium chloride, tetraphenylphosphonium bromide, tetraphenylphosphonium iodide, tetraphenylphosphonium oxalate, tetraphenylphosphonium maleate, tetraphenylphosphonium fumarate, tetraphenylphosphonium citraconate, tetraphenylphosphonium citrate, tetraphenylphosphonium carbonate, bistetraphenylphosphonium oxalate, bistetraphenylphosphonium maleate, bistetraphenylphosphonium fumarate, bistetraphenylphosphonium citraconate, bistetraphenylphosphonium citrate, bistetraphenylphosphonium carbonate, etc.

Specific examples of the ammonium salt (Xc-4) include tetramethylammonium formate, tetramethylammonium acetate, tetramethylammonium propionate, tetramethylammonium butanoate, tetramethylammonium benzoate, tetramethylammonium phthalate, tetramethylammonium isophthalate, tetramethylammonium terephthalate, tetramethylammonium salicylate, tetramethylammonium trifluoromethanesulfonate, tetramethylammonium trifluoroacetate, tetramethylammonium monochloroacetate, tetramethylammonium dichloroacetate, tetramethylammonium trichloroacetate, tetramethylammonium hydroxide, tetramethylammonium nitrate, tetramethylammonium chloride, tetramethylammonium bromide, tetramethylammonium iodide, tetramethylammonium monomethylsulfate, tetramethylammonium oxalate, tetramethylammonium malonate, tetramethylammonium maleate, tetramethylammonium fumarate, tetramethylammonium citraconate, tetramethylammonium citrate, tetramethylammonium carbonate, bistetramethylammonium oxalate, bistetramethylammonium malonate, bistetramethylammonium maleate, bistetramethylammonium fumarate, bistetramethylammonium citraconate, bistetramethylammonium citrate, bistetramethylammonium carbonate, tetraethylammonium formate, tetraethylammonium acetate, tetraethylammonium propionate, tetraethylammonium butanoate, tetraethylammonium benzoate, tetraethylammonium phthalate, tetraethylammonium isophthalate, tetraethylammonium terephthalate, tetraethylammonium salicylate, tetraethylammonium trifluoromethanesulfonate, tetraethylammonium trifluoroacetate, tetraethylammonium monochloroacetate, tetraethylammonium dichloroacetate, tetraethylammonium trichloroacetate, tetraethylammonium hydroxide, tetraethylammonium nitrate, tetraethylammonium chloride, tetraethylammonium bromide, tetraethylammonium iodide, tetraethylammonium monomethylsulfate, tetraethylammonium oxalate, tetraethylammonium malonate, tetraethylammonium maleate, tetraethylammonium fumarate, tetraethylammonium citraconate, tetraethylammonium citrate, tetraethylammonium carbonate, bistetraethylammonium oxalate, bistetraethylammonium malonate, bistetraethylammonium maleate, bistetraethylammonium fumarate, bistetraethylammonium citraconate, bistetraethylammonium citrate, bistetraethylammonium carbonate, tetrapropylammonium formate, tetrapropylammonium acetate, tetrapropylammonium propionate, tetrapropylammonium butanoate, tetrapropylammonium benzoate, tetrapropylammonium phthalate, tetrapropylammonium isophthalate, tetrapropylammonium terephthalate, tetrapropylammonium salicylate, tetrapropylammonium trifluoromethanesulfonate, tetrapropylammonium trifluoroacetate, tetrapropylammonium monochloroacetate, tetrapropylammonium dichloroacetate, tetrapropylammonium trichloroacetate, tetrapropylammonium hydroxide, tetrapropylammonium nitrate, tetrapropylammonium chloride, tetrapropylammonium bromide, tetrapropylammonium iodide, tetrapropylammonium monomethylsulfate, tetrapropylammonium oxalate, tetrapropylammonium malonate, tetrapropylammonium maleate, tetrapropylammonium fumarate, tetrapropylammonium citraconate, tetrapropylammonium citrate, tetrapropylammonium carbonate, bistetrapropylammonium oxalate, bistetrapropylammonium malonate, bistetrapropylammonium maleate, bistetrapropylammonium fumarate, bistetrapropylammonium citraconate, bistetrapropylammonium citrate, bistetrapropylammonium carbonate, tetrabutylammonium formate, tetrabutylammonium acetate, tetrabutylammonium propionate, tetrabutylammonium butanoate, tetrabutylammonium benzoate, tetrabutylammonium phthalate, tetrabutylammonium isophthalate, tetrabutylammonium terephthalate, tetrabutylammonium salicylate, tetrabutylammonium trifluoromethanesulfonate, tetrabutylammonium trifluoroacetate, tetrabutylammonium monochloroacetate, tetrabutylammonium dichloroacetate, tetrabutylammonium trichloroacetate, tetrabutylammonium hydroxide, tetrabutylammonium nitrate, tetrabutylammonium chloride, tetrabutylammonium bromide, tetrabutylammonium iodide, tetrabutylammonium methanesulfonate, tetrabutylammonium monomethylsulfate, tetrabutylammonium oxalate, tetrabutylammonium malonate, tetrabutylammonium maleate, tetrabutylammonium fumarate, tetrabutylammonium citraconate, tetrabutylammonium citrate, tetrabutylammonium carbonate, bistetrabutylammonium oxalate, bistetrabutylammonium malonate, bistetrabutylammonium maleate, bistetrabutylammonium fumarate, bistetrabutylammonium citraconate, bistetrabutylammonium citrate, bistetrabutylammonium carbonate, etc.

Specific examples of the alkaline metal salt include lithium formate, lithium acetate, lithium propionate, lithium butanoate, lithium benzoate, lithium phthalate, lithium isophthalate, lithium terephthalate, lithium salicylate, lithium trifluoromethanesulfonate, lithium trifluoroacetate, lithium monochloroacetate, lithium dichloroacetate, lithium trichloroacetate, lithium hydroxide, lithium nitrate, lithium chloride, lithium bromide, lithium iodide, lithium methanesulfonate, lithium hydrogen oxalate, lithium hydrogen malonate, lithium hydrogen maleate, lithium hydrogen fumarate, lithium hydrogen citraconate, lithium hydrogen citrate, lithium hydrogen carbonate, lithium oxalate, lithium malonate, lithium maleate, lithium fumarate, lithium citraconate, lithium citrate, lithium carbonate, sodium formate, sodium acetate, sodium propionate, sodium butanoate, sodium benzoate, sodium phthalate, sodium isophthalate, sodium terephthalate, sodium salicylate, sodium trifluoromethanesulfonate, sodium trifluoroacetate, sodium monochloroacetate, sodium dichloroacetate, sodium trichloroacetate, sodium hydroxide, sodium nitrate, sodium chloride, sodium bromide, sodium iodide, sodium methanesulfonate, sodium hydrogen oxalate, sodium hydrogen malonate, sodium hydrogen maleate, sodium hydrogen fumarate, sodium hydrogen citraconate, sodium hydrogen citrate, sodium hydrogen carbonate, sodium oxalate, sodium malonate, sodium maleate, sodium fumarate, sodium citraconate, sodium citrate, sodium carbonate, potassium formate, potassium acetate, potassium propionate, potassium butanoate, potassium benzoate, potassium phthalate, potassium isophthalate, potassium terephthalate, potassium salicylate, potassium trifluoromethanesulfonate, potassium trifluoroacetate, potassium monochloroacetate, potassium dichloroacetate, potassium trichloroacetate, potassium hydroxide, potassium nitrate, potassium chloride, potassium bromide, potassium iodide, potassium methanesulfonate, potassium hydrogen oxalate, potassium hydrogen malonate, potassium hydrogen maleate, potassium hydrogen fumarate, potassium hydrogen citraconate, potassium hydrogen citrate, potassium hydrogen carbonate, potassium oxalate, potassium malonate, potassium maleate, potassium fumarate, potassium citraconate, potassium citrate, potassium carbonate, etc.

As (D) the curing catalyst, the inventive silicon-containing composition may contain a polysiloxane (Xc-10) having an ammonium salt, a sulfonium salt, a phosphonium salt, or an iodonium salt as part of the structure.

The (Xc-10) is synthesized by subjecting a hydrolysable monomer represented by the following general formula (Xm) to hydrolysis condensation.

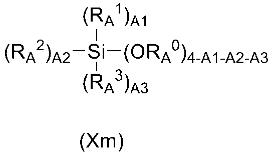

In the formula, R_{A}⁰ represents a hydrocarbon group having 1 to 6 carbon atoms; at least one of R_{A}¹, R_{A}², and R_{A}³ represents an organic group having the ammonium salt, the sulfonium salt, the phosphonium salt, or the iodonium salt; the other(s) of R_{A}¹, R_{A}², and R_{A}³ represent a hydrogen atom or a monovalent organic group having 1 to 30 carbon atoms; and A1, A2, and A3 each represent 0 or 1, given that 1 ≤ A1+A2+A3 ≤ 3.

Specific examples of R_{A}⁰ include a methyl group, an ethyl group, an n-propyl group, an iso-propyl group, an n-butyl group, an iso-butyl group, a sec-butyl group, a tert-butyl group, an n-pentyl group, a cyclopentyl group, an n-hexyl group, a cyclohexyl group, and a phenyl group.

Specific examples of the general formula (Xm) include a compound represented by the following general formula (Xm-1), having a sulfonium salt as part of the structure. Note that, in the following formula, (Si) is depicted to show a bonding site to Si.

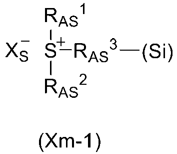

In the formula, R_{AS}¹ and R_{AS}² each represent a linear, branched, or cyclic alkyl group, alkenyl group, oxoalkyl group, or oxoalkenyl group each having 1 to 20 carbon atoms, a substituted or unsubstituted aryl group having 6 to 20 carbon atoms, or an aralkyl group or aryloxyalkyl group each having 7 to 20 carbon atoms, and each is a monovalent organic group in which part or all of the hydrogen atoms of these groups are optionally substituted with an alkoxy group, an amino group, an alkylamino group, a halogen atom, etc. R_{AS}¹ and R_{AS}² may form a ring together with the sulfur atom bonded thereto, and when a ring is formed, R_{AS}¹ and R_{AS}² each represent an alkylene group having 1 to 6 carbon atoms. R_{AS}³ represents a linear, branched, or cyclic alkylene group or alkenylene group each having 1 to 20 carbon atoms, or a substituted or unsubstituted arylene group or aralkylene group each having 6 to 20 carbon atoms, and represents a divalent organic group in which part or all of the hydrogen atoms of these groups are optionally substituted with an alkoxy group, an amino group, an alkylamino group, etc. R_{AS}¹ to R_{AS}³ may have an oxygen atom or a nitrogen atom in the chain or ring thereof. X_{S}⁻ represents a non-nucleophilic counter ion.

Examples of X_{S}⁻ include hydroxide ion, fluoride ion, chloride ion, bromide ion, iodide ion, formate ion, acetate ion, propionate ion, butanoate ion, pentanoate ion, hexanoate ion, heptanoate ion, octanoate ion, nonanoate ion, decanoate ion, oleate ion, stearate ion, linoleate ion, linolenate ion, benzoate ion, p-methylbenzoate ion, p-t-butylbenzoate ion, phthalate ion, isophthalate ion, terephthalate ion, salicylate ion, trifluoroacetate ion, monochloroacetate ion, dichloroacetate ion, trichloroacetate ion, nitrate ion, chlorate ion, perchlorate ion, bromate ion, iodate ion, methanesulfonate ion, benzenesulfonate ion, toluenesulfonate ion, monomethylsulfate ion, hydrogen sulfate ion, oxalate ion, malonate ion, methylmalonate ion, ethylmalonate ion, propylmalonate ion, butylmalonate ion, dimethylmalonate ion, diethylmalonate ion, succinate ion, methylsuccinate ion, glutarate ion, adipate ion, itaconate ion, maleate ion, fumarate ion, citraconate ion, citrate ion, carbonate ion, etc.

Specific examples of the cation moiety of the compound represented by the general formula (Xm-1) include the following ions. Note that, in the following formulae, (Si) is depicted to show a bonding site to Si.

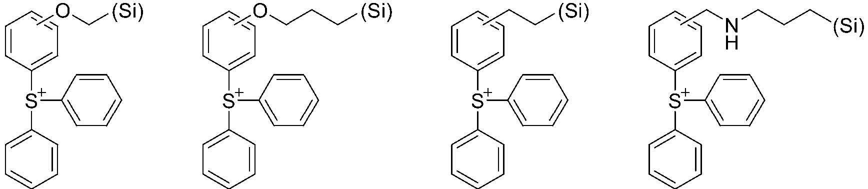

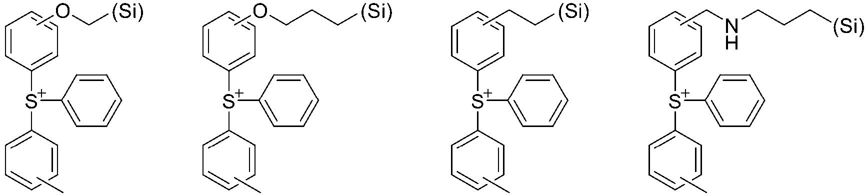

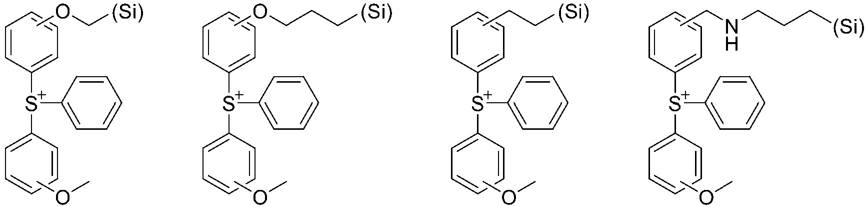

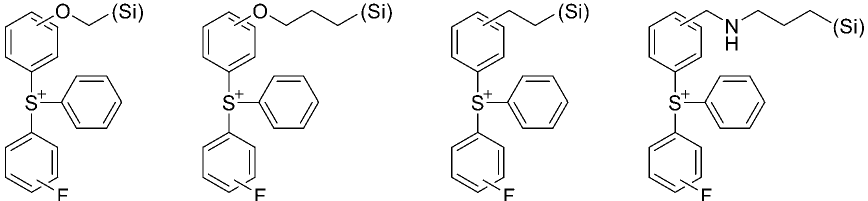

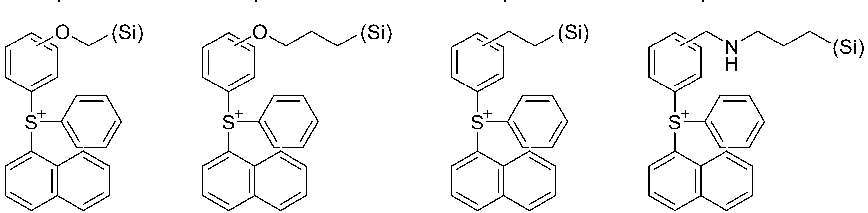

Specific examples of the general formula (Xm) include compounds represented by the following general formula (Xm-2), having an iodonium salt as part of the structure. Note that, in the following formulae, (Si) is depicted to show a bonding site to Si.

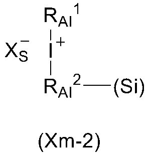

In the formula, R_{AI}¹ represents a linear, branched, or cyclic alkyl group, alkenyl group, oxoalkyl group, or oxoalkenyl group each having 1 to 20 carbon atoms, a substituted or unsubstituted aryl group having 6 to 20 carbon atoms, or an aralkyl group or an aryloxoalkyl group each having 7 to 20 carbon atoms, and is a monovalent organic group in which part or all of the hydrogen atoms of these groups are optionally substituted with an alkoxy group, an amino group, an alkylamino group, a halogen atom, etc. R_{AI}² represents a linear, branched, or cyclic alkylene group or alkenylene group each having 1 to 20 carbon atoms, or a substituted or unsubstituted arylene group or aralkylene group each having 6 to 20 carbon atoms, and is a divalent organic group in which part or all of the hydrogen atoms of these groups are optionally substituted with an alkoxy group, an amino group, an alkylamino group, etc. R_{AI}¹ and R_{AI}² may have an oxygen atom or a nitrogen atom in the chain or ring thereof. X_{S}⁻ represents a non-nucleophilic counter ion identical to that described above.

Specific examples of the cation moiety of the compound represented by the general formula (Xm-2) include the following ions. Note that, in the following formulae, (Si) is depicted to show a bonding site to Si.

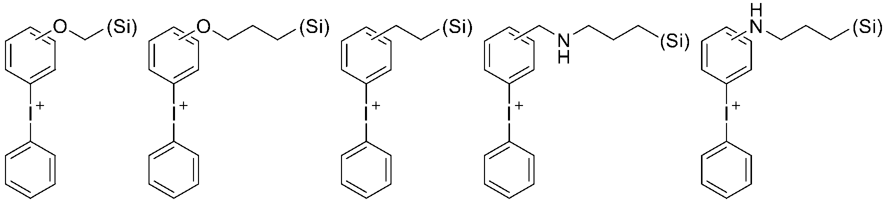

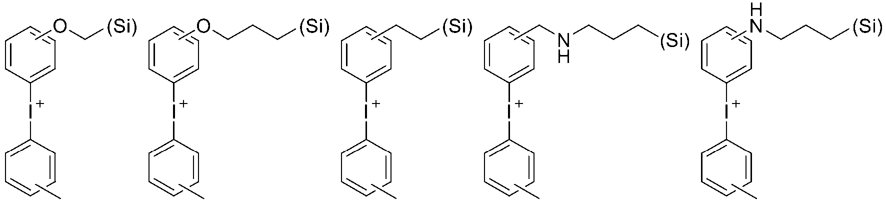

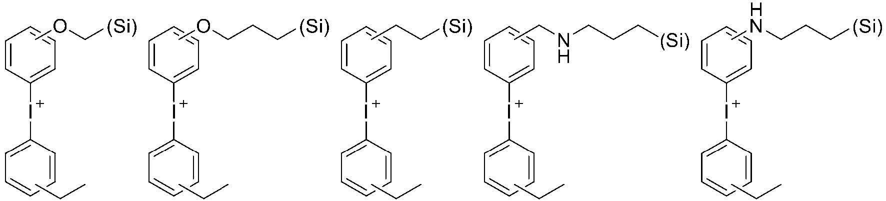

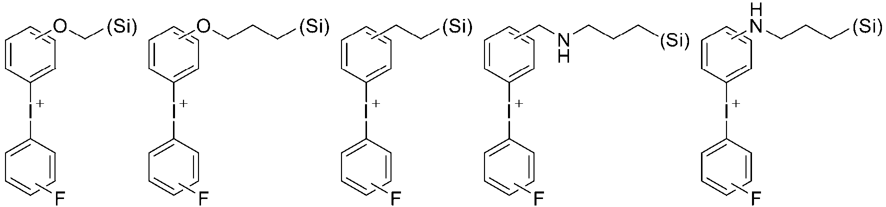

Specific examples of the general formula (Xm) include compounds represented by the following general formula (Xm-3), having a phosphonium salt as part of the structure. Note that, in the following formulae, (Si) is depicted to show a bonding site to Si.

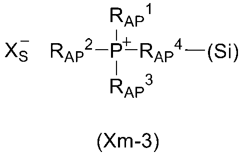

In the formula, R_{AP}¹, R_{AP}², and R_{AP}³ each represent a linear, branched, or cyclic alkyl group, alkenyl group, oxoalkyl group, or oxoalkenyl group each having 1 to 20 carbon atoms, a substituted or unsubstituted aryl group having 6 to 20 carbon atoms, or an aralkyl group or an aryloxoalkyl group each having 7 to 20 carbon atoms, and part or all of the hydrogen atoms of these groups are optionally substituted with an alkoxy group, an amino group, an alkylamino group, a halogen atom, etc. Moreover, R_{AP}¹ and R_{AP}² may form a ring together with the phosphorus atom bonded thereto, and when a ring is formed, R_{AP}¹ and R_{AP}² each represent an alkylene group having 1 to 6 carbon atoms. R_{AP}⁴ represents a linear, branched, or cyclic alkylene group or alkenylene group each having 1 to 20 carbon atoms, or a substituted or unsubstituted arylene group or aralkylene group each having 6 to 20 carbon atoms, and part or all of the hydrogen atoms of these groups are optionally substituted with an alkoxy group, an amino group, an alkylamino group, etc. R_{AP}¹ to R_{AP}⁴ may have an oxygen atom or a nitrogen atom in the chain or ring thereof. X_{S}⁻ represents a non-nucleophilic counter ion identical to that described above.

Specific examples of the cation moiety of the compound represented by the general formula (Xm-3) include the following ions. Note that, in the following formulae, (Si) is depicted to show a bonding site to Si.

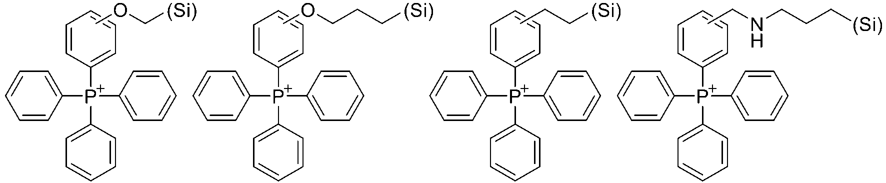

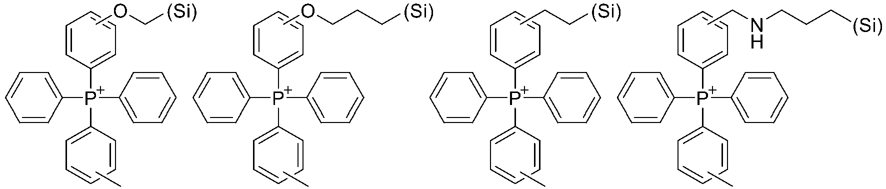

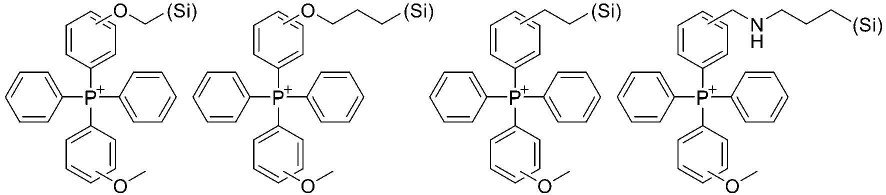

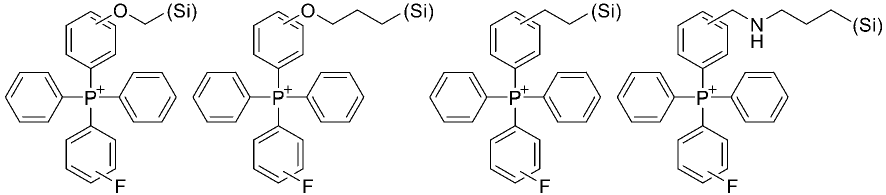

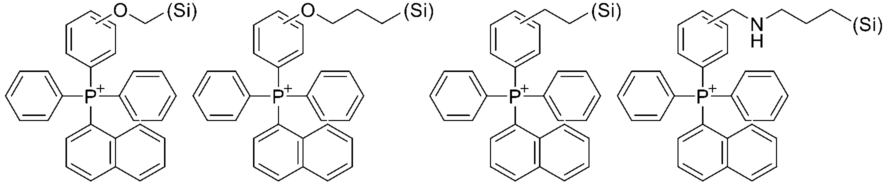

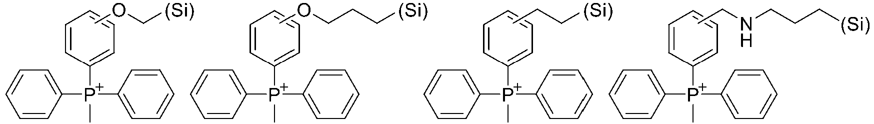

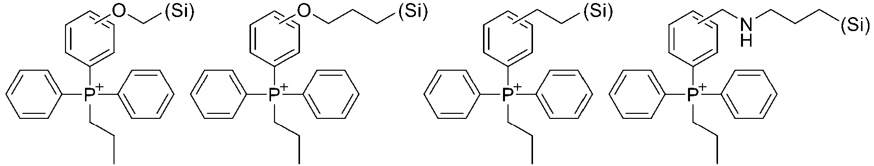

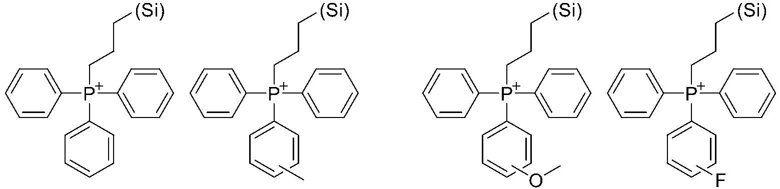

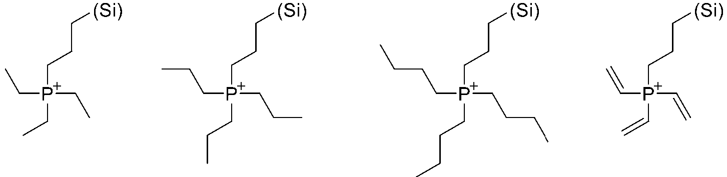

Specific examples of the general formula (Xm) include compounds represented by the following general formula (Xm-4), having an ammonium salt as part of the structure. Note that, in the following formulae, (Si) is depicted to show a bonding site to Si.

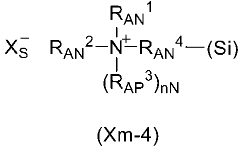

In the formula, R_{AN}¹, R_{AN}², and R_{AN}³ each represent a hydrogen atom or a monovalent organic group, such as a linear, branched, or cyclic alkyl group, alkenyl group, oxoalkyl group, or oxoalkenyl group each having 1 to 20 carbon atoms, a substituted or unsubstituted aryl group having 6 to 20 carbon atoms, or an aralkyl group or aryloxyalkyl group each having 7 to 20 carbon atoms, and part or all of the hydrogen atoms of these groups are optionally substituted with an alkoxy group, an amino group, an alkylamino group, etc. Moreover, R_{AN}¹ and R_{AN}² may form a ring together with the nitrogen atom bonded thereto, and when a ring is formed, R_{AN}¹ and R_{AN}² each represent an alkylene group having 1 to 6 carbon atoms or a cyclic heterocyclic ring or heteroaromatic ring containing nitrogen. R_{AN}⁴ represents a divalent organic group, such as a linear, branched, or cyclic alkylene group or alkenylene group each having 1 to 23 carbon atoms, or a substituted or unsubstituted arylene group or aralkylene group each having 6 to 29 carbon atoms, part or all of the hydrogen atoms of these groups are optionally substituted with an alkoxy group, an amino group, an alkylamino group, etc. In the case where R_{AN}¹ and R_{AN}², or R_{AN}¹ and R_{AN}⁴ form a cyclic structure which further contains unsaturated nitrogen, n_{N}=0; in the other cases, n_{N}=1. R_{AN}⁴ may have an oxygen atom or a nitrogen atom in the chain or ring thereof. X_{S}⁻ represents a non-nucleophilic counter ion identical to that described above.

Among the compounds represented by the general formula (Xm-4), specific examples of the cation moiety of compounds in which R_{AN}¹ and R_{AN}², and R_{AN}¹ and R_{AN}⁴ do not form a ring include the following ions. Note that, in the following formulae, (Si) is depicted to show a bonding site to Si.

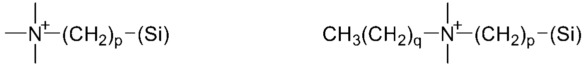

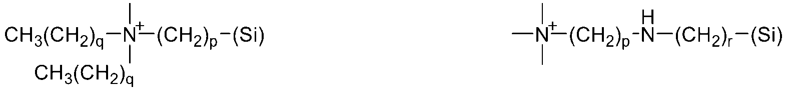

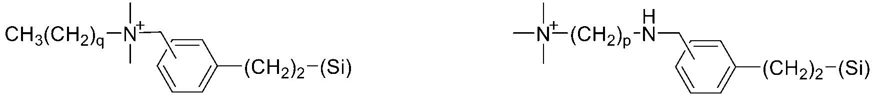

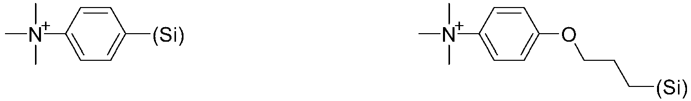

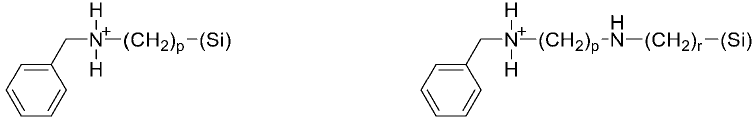

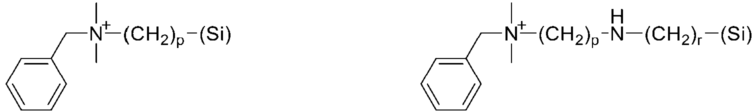

In the formulae, "p", "q", and "r" each represent an integer of 1 to 20.

Among the compounds represented by the general formula (Xm-4), specific examples of the cation moiety of compounds in which R_{AN}¹ and R_{AN}², or R_{AN}¹ and R_{AN}⁴ form a ring include the following ions. Note that, in the following formulae, (Si) is depicted to show a bonding site to Si.

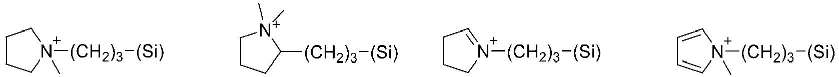

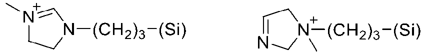

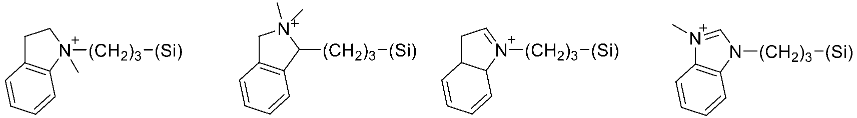

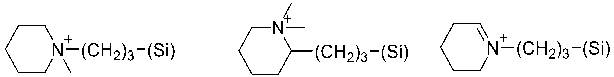

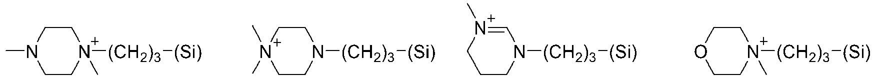

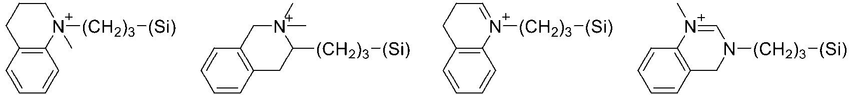

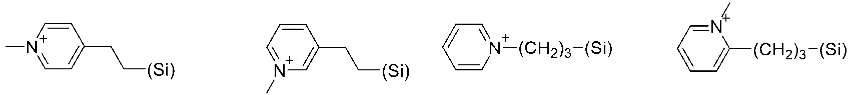

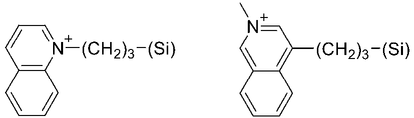

The compound represented by the formula (Xc-10) can be synthesized by hydrolysis condensation of the formulae (Xm-1), (Xm-2), (Xm-3), and (Xm-4). In this event, it is possible to add a hydrolysable monomer represented by (Sm) and a hydrolysable metal compound (Mm) represented by (Mm) and perform a condensation reaction. The reaction conditions may be similar to those in the method for synthesizing the thermally crosslinkable polysiloxane (Sx).

The molecular weight of the silicon-containing compound (Xc-10) to be obtained can be adjusted not only through the selection of the monomers but also by controlling the reaction conditions during the polymerization, and is preferably 100,000 or less, more preferably 200 to 50,000, and further preferably 300 to 30,000. When the weight-average molecular weight is 100,000 or less, the generation of foreign matters or coating spots does not occur, and this is preferable.

One of the curing catalysts represented by the general formulae (Xc-1), (Xc-2), (Xc-3), (Xc-4), and (Xc-10) can be used, or two or more thereof can be used in combination. The curing catalyst is preferably added in an amount of 0.01 to 50 parts by mass, more preferably 0.1 to 40 parts by mass, based on 100 parts by mass of (A) the thermosetting silicon-containing resin (Sx).

By using the curing catalyst, it is possible to promote the formation of siloxane bonds when the thermosetting silicon-containing resin cures, and a dense silicon-containing film that is highly densely crosslinked can be formed efficiently.

### [(E) Organic Compound Having Boiling Point of 150°C or Higher]

The inventive silicon-containing composition can further contain (E) an organic compound having a boiling point of 150°C or higher.

Specific examples of (E) the organic compound having a boiling point of 150°C or higher include 1-hexanol, 1-heptanol, 1-octanol, 1-nonanol, 1-decanol, 1-undecanol, 2-ethylhexanol, cyclohexanol, 2-butoxyethanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, gamma-butyrolactone, ethylene glycol monobutyl ether, ethylene glycol monobenzyl ether, ethylene glycol dibutyl ether, ethylene glycol dibenzyl ether, diethylene glycol monobutyl ether, diethylene glycol benzyl ether, triethylene glycol monobenzyl ether, tetraethylene glycol monobenzyl ether, tripropylene glycol monomethyl ether, diacetone alcohol, n-nonyl acetate, ethylene glycol monoethyl ether acetate, 1,2-diacetoxyethane, 1-acetoxy-2-methoxyethane, 1,2-diacetoxypropane, diethylene glycol monomethyl ether acetate, diethylene glycol monoethyl ether acetate, diethylene glycol mono-n-butyl ether acetate, propylene glycol monomethyl ether acetate, propylene glycol monopropyl ether acetate, propylene glycol monobutyl ether acetate, dipropylene glycol monomethyl ether acetate, dipropylene glycol monoethyl ether acetate, etc. However, the organic compound is not limited thereto.

(E) the organic compound having a boiling point of 150°C or higher is preferably contained in an amount of 50 to 300 parts by mass (that is, 50 to 300% in weight percentage) when the amount of (A) the thermosetting silicon-containing material used is considered as 100 parts by mass. When (E) the organic compound having a boiling point of 150°C or higher is contained, sufficient thermal flowability can be achieved at the time of film formation with the silicon-containing composition, and a silicon-containing film excellent in filling and planarizing properties can be formed. At the same time, the organic compound does not remain in the film after baking, and there is no risk of adversely affecting the physical properties of the film.

### [Other Components]

### <<Organic Acid>>

To improve the stability of the inventive silicon-containing composition, it is preferable to add a monovalent, divalent, or polyvalent organic acid having 1 to 30 carbon atoms.

Examples of the acid added in this event include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, citric acid, etc. Particularly, oxalic acid, maleic acid, formic acid, acetic acid, propionic acid, citric acid, etc. are preferable.

To maintain the stability of the silicon-containing composition, a mixture of two or more acids may be used. The organic acid can be contained in an amount of 0.001 to 25 parts by mass, preferably 0.01 to 15 parts by mass, more preferably 0.1 to 5 parts by mass, when the amount of (A) the thermosetting silicon-containing resin contained in the composition is considered as 100 parts by mass. Alternatively, the organic acid can be converted to the pH of the composition and blended in such an amount that, preferably, 0 ≤ pH ≤ 7, more preferably, 0.3 ≤ pH ≤ 6.5, and further preferably, 0.5 ≤ pH ≤ 6.

### <<Photo-Acid Generator>>

The inventive silicon-containing composition may also contain a photo-acid generator. As the photo-acid generator used in the present invention, it is possible to add, specifically, the materials described in paragraphs (0160) to (0179) of JP2009-126940A.

### <<Stabilizer>>

The inventive silicon-containing composition may also contain a stabilizer. As the stabilizer used in the present invention, a monohydric, dihydric, or polyhydric alcohol having a cyclic ether substituent can be contained. Particularly, adding a stabilizer shown in paragraphs (0181) to (0184) of JP2009-126940A enables stability improvement of the silicon-containing composition.

### [Patterning Process]

In the following, a reverse patterning process using the inventive silicon-containing composition will be described.

### <<Reverse Patterning Employing Multilayer Resist Process>>

A first embodiment of the inventive patterning process is a patterning process including the steps of:
(I) forming an organic underlayer film on a body to be processed;
(II) forming a silicon-containing resist middle layer film on the organic underlayer film by using a composition for forming a silicon-containing resist middle layer film;
(III) forming a resist upper layer film on the silicon-containing resist middle layer film by using a resist upper layer film composition including a photoresist composition;
(IV) forming a circuit pattern in the resist upper layer film;
(V) transferring the pattern to the silicon-containing resist middle layer film by etching while using the resist upper layer film having the formed circuit pattern as a mask;
(VI) transferring the pattern to the organic underlayer film by etching while using the silicon-containing resist middle layer film having the transferred pattern as a mask;
(VII) coating and filling the organic underlayer film having the transferred pattern by using the inventive silicon-containing composition; and
(VIII) removing unnecessary portions from a silicon-containing film formed in the step (VII), and then removing the organic underlayer film by etching to form a silicon-containing pattern.

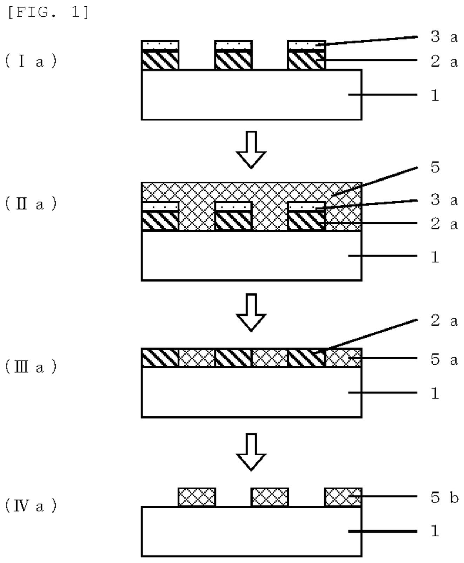

In the following, an example of an embodiment of the present invention will be described with reference to FIG. 1. However, the inventive patterning process is not limited to the example of FIG. 1, and can also be carried out by a method other than this patterning process.

The first embodiment (FIG. 1) of the inventive patterning process includes the steps of:
(Ia) forming a pattern 2a of an organic underlayer film and a pattern 3a of a silicon-containing resist middle layer film on a body 1 to be processed;
(IIa) coating and filling the pattern 2a of the organic underlayer film and the pattern 3a of the silicon-containing resist middle layer film by using the inventive silicon-containing composition to form a silicon-containing film 5;
(IIIa) removing unnecessary portions from the formed silicon-containing film 5 to obtain a silicon-containing film 5a after the removal; and
(IVa) removing the pattern 2a of the organic underlayer film to form a pattern 5b of the silicon-containing film on the body to be processed.

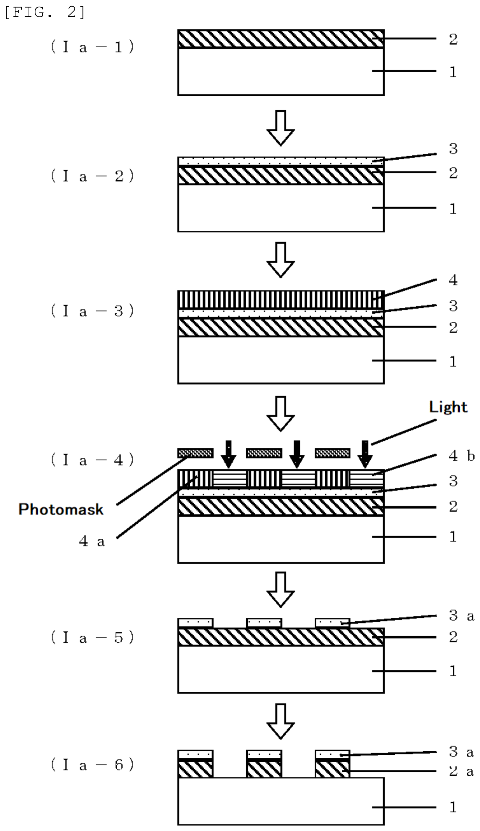

In the first embodiment of the patterning process, it is also possible to form a pattern of an organic underlayer film and, by using a CVD method, a silicon-containing resist middle layer film on a body to be processed. That is, the first embodiment can also be a patterning process including the steps of:
(I) forming an organic underlayer film on a body to be processed;
(II) forming a silicon-containing resist middle layer film on the organic underlayer film by using a CVD method;
(III) forming a resist upper layer film by using a resist upper layer film composition including a photoresist composition applied to the silicon-containing resist middle layer film;
(IV) forming a circuit pattern in the resist upper layer film;
(V) transferring the pattern to the silicon-containing resist middle layer film by etching while using the resist upper layer film having the formed circuit pattern as a mask;
(VI) transferring the pattern to the organic underlayer film by dry etching while using the silicon-containing resist middle layer film having the transferred pattern as a mask;
(VII) coating and filling the organic underlayer film having the transferred pattern by using the inventive silicon-containing composition; and
(VIII) removing unnecessary portions from a silicon-containing film formed in the step (VII), and then removing the organic underlayer film by etching to form a silicon-containing pattern. In the following, an example of an embodiment of the present invention will be described with reference to FIG. 2.

In the first embodiment (FIG. 1) of the reverse patterning process of the present invention, the pattern 2a of the organic underlayer film and the pattern 3a of the silicon-containing resist middle layer film are formed on the body 1 to be processed in the first step (FIG. 2). This step includes the steps of:
(Ia-1) forming an organic underlayer film 2 on a body 1 to be processed by using a coating-type organic underlayer film material;
(Ia-2) forming a silicon-containing resist middle layer film 3 on the organic underlayer film 2 by using a coating-type silicon-containing resist middle layer film material by using a CVD method or an ALD method;
(Ia-3) forming a resist upper layer film 4 on the silicon-containing resist middle layer film 3 by using a photoresist material;
(Ia-4) forming a circuit pattern 4a in the resist upper layer film by performing exposure via a photomask or direct writing with electron beam and then performing development;
(Ia-5) transferring the pattern to the silicon-containing resist middle layer film by dry etching while using the circuit pattern 4a of the resist upper layer film having the formed circuit pattern as a mask to form a pattern 3a; and
(Ia-6) transferring the pattern to the organic underlayer film by dry etching while using the pattern 3a of the silicon-containing resist middle layer film having the transferred pattern as a mask to form a pattern 2a.

In the step (Ia-1), an organic underlayer film 2 is formed on a body 1 to be processed by using a coating-type organic underlayer film material. As the coating-type organic underlayer film material, an organic film material to which many aromatic rings or many multiple bonds have been introduced is suitably used for enhancing resistance to dry etching.

It is desirable to form a film of the coating-type organic underlayer film material on the body to be processed by a spin-coating method, and then perform heating (baking) to promote the evaporation of the organic solvent and the crosslinking reaction. By baking, mixing with the silicon-containing resist middle layer film can be prevented. The baking temperature is preferably 80 to 600°C, and the baking time is preferably 10 to 600 seconds. To reduce heat damage to the device, baking at 400°C or lower is preferable, although this depends on the structure of the device to be manufactured. The film thickness is preferably 5 nm to 50,000 nm, further preferably 10 to 1000 nm, and more preferably 10 to 800 nm.

The atmosphere during the baking may be air, but by performing the baking under an inert gas, such as nitrogen and argon, oxidation of the organic underlayer film can be prevented. To prevent oxidation, oxygen concentration needs to be controlled, and is preferably 1000 ppm or less, more preferably 100 ppm or less (volumetric basis).

In the step (Ia-2), a silicon-containing resist middle layer film 3 is formed on the organic underlayer film 2 formed in the step (Ia-1) by using a coating-type silicon-containing resist middle layer film material by using a CVD method or an ALD method.

As the coating-type silicon-containing resist middle layer film material, a polysiloxane-based middle layer film material is suitably used. In the case of ArF exposure, when many aromatic groups are introduced into the organic underlayer film to enhance etching selectivity relative to the substrate, the k-value is increased, and as a result, substrate reflection is increased. However, by controlling the k-value of the silicon-containing resist middle layer film to an appropriate value, reflection can be suppressed, and the substrate reflection can be reduced to 0.5% or less. As the silicon-containing resist middle layer film having an antireflective effect, a polysiloxane is preferably used which has anthracene for KrF and F₂ exposure, or a phenyl group or a light-absorbing group having a silicon-silicon bond for ArF exposure in a pendant structure, and which has been synthesized by crosslinking with an acid or heat.

After the coating-type silicon-containing resist middle layer film material is applied by spin-coating onto the organic underlayer film formed in the step (Ia-1), the solvent is evaporated. Subsequently, it is desirable to perform heating (baking) to promote the crosslinking reaction, and as a result, mixing with the resist film can be prevented. The baking temperature is preferably 50 to 500°C, and the baking time is preferably 10 to 300 seconds. To reduce heat damage to the device, baking at 400°C or lower is preferable, although this depends on the structure of the device to be manufactured. The film thickness is preferably 5 to 200 nm, more preferably 10 to 100 nm.

As the silicon-containing resist middle layer film formed by a CVD method or an ALD method, an inorganic hard mask middle layer film selected from a silicon oxide film, a silicon nitride film, and a silicon oxynitride film (SiON film) is used, and a SiON film, having a high function as an antireflective film, is the most preferably used. Examples of methods for forming these films are disclosed in JP2002-334869A, WO2004/066377A1, etc. The film thickness is preferably 5 to 200 nm, more preferably 10 to 100 nm.

On the silicon-containing resist middle layer film, an organic antireflective film (BARC) or an adhesive film may be used before forming the resist upper layer film. Compositions for the antireflective film and the adhesive film used in this event are not particularly limited, and known materials can be used. In addition, film formation is performed by a known method using spinner or a coater.

Particularly, when a SiON film is used as the silicon-containing resist middle layer film, by also using an antireflective film (BARC), the antireflective effects of the two layers make it possible to suppress the reflection even in liquid immersion exposure at a high NA exceeding 1.0. Furthermore, it is also possible to reduce trailing of the resist upper layer film pattern immediately above the SiON film.

In the step (Ia-3), a resist upper layer film 4 is formed on the silicon-containing resist middle layer film 3 formed in the step (Ia-2) by using a photoresist material. The photoresist material may be either a positive type or a negative type, and a known photoresist composition that is normally used can be used.

In the case of a resist composition for ArF, it is possible to use, as a base resin, a poly(meth)acrylic resin, a COMA (Cyclo Olefin Maleic Anhydride) resin, a COMA-(meth)acryl hybrid resin, a ROMP (Ring Opening Metathesis Polymerization) resin, a polynorbornene resin, etc. In particular, a resist composition containing a poly(meth)acrylic resin ensures etching resistance by introducing an alicyclic skeleton into a side chain, and therefore, resolution performance is better than other types of resins.

In this step, after a film of the photoresist material is formed by spin-coating, pre-baking is preferably performed at 60 to 180°C for 10 to 300 seconds. The thickness of the resist film is not particularly limited, but is preferably 30 to 500 nm, particularly preferably 50 to 400 nm.

In the step (Ia-4), a circuit pattern 4a of the resist upper layer film is formed by performing exposure via a photomask or direct writing with electron beam and then performing development. In this step, exposure is performed according to a conventional method, and then post-exposure baking (PEB) is performed, followed by development, to obtain a resist pattern.

Examples of exposure light include high-energy beams having wavelengths of 300 nm or less, specifically, far-ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray of 3 to 20 nm (EUV), electron beam (EB), ion beam, X-ray, etc.

After exposure, post-exposure baking (PEB) is performed as necessary. For example, heating is performed under conditions of 70 to 200°C for an optimized time.

In a positive patterning process, development is performed using an alkaline developer after performing the exposure, and the resist film in exposed portions 4b is removed to obtain a positive resist pattern. As the alkaline developer, for example, an aqueous solution of tetramethylammonium hydroxide (TMAH) or the like can be used. Examples of development conditions include room temperature to 50°C and a time of 10 seconds to 600 seconds, but are not limited to these conditions.

In a negative patterning process, organic solvent development is performed after performing the exposure, and the resist upper layer film in unexposed portions is removed to obtain a negative resist pattern. Specific examples of the organic solvent to be used for the development include 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, amyl acetate, butenyl acetate, isoamyl acetate, propyl formate, butyl formate, isobutyl formate, amyl formate, isoamyl formate, methyl valerate, methyl pentenoate, methyl crotonate, ethyl crotonate, methyl lactate, ethyl lactate, propyl lactate, butyl lactate, isobutyl lactate, amyl lactate, isoamyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate, and it is possible to use a developer containing, as a component, one or more selected from the above. It is preferable to use a developer in which the total amount of the one or more developer components is 50 mass% or more from the viewpoint of improving pattern collapse and so forth. Examples of development conditions include room temperature to 50°C and a time of 10 seconds to 600 seconds, but are not limited to these conditions.

In the step (Ia-5), the pattern is transferred to the silicon-containing resist middle layer film 3 by dry etching while using the circuit pattern 4a of the resist upper layer film formed in the step (Ia-4) as a mask to form a pattern 3a of the silicon-containing resist middle layer film. The dry etching is preferably performed using a fluorocarbon-based gas. The silicon-containing resist middle layer film can be removed easily with a fluorocarbon-based gas, but the resist upper layer film has high etching resistance to a fluorocarbon-based gas, and therefore, it is possible to suppress film thickness loss of the resist film during etching. Specific examples of the fluorocarbon-based gas include difluoromethane, tetrafluoromethane, perfluoropropane, perfluorocyclobutane, and trifluoromethane. Besides these, a halogen-based gas, such as chlorine, can also be used.

In the step (Ia-6), the pattern is transferred to the organic underlayer film 2 by dry etching while using the pattern 3a of the silicon-containing resist middle layer film formed in the step (Ia-5) as a mask to form a pattern 2a of the organic underlayer film. The silicon-containing resist middle layer film has high etching resistance to oxygen gas or hydrogen gas, and therefore, it is preferable to use an etching gas mainly containing oxygen gas or hydrogen gas. Thus, the pattern of the silicon-containing resist middle layer film is transferred as the organic underlayer film pattern.

In the most-advanced fine processing, in association with the thinning of the pattern width of resist films, the thinning of resist films for suppressing pattern collapse cannot be avoided.
However, by using an organic underlayer film on the body to be processed, a silicon-containing middle layer film thereon, and furthermore, a resist film thereon, and appropriately controlling the selectivity of the dry etching rates of these materials, fine processing of the substrate can be realized. That is, by using a fluorocarbon-based gas, which has a low etching rate regarding the resist film and has a high etching rate regarding the silicon-containing resist middle layer film, the silicon-containing middle layer film can be processed. Furthermore, by using an oxygen-based gas, which has a low etching rate regarding the silicon-containing resist middle layer film and has a high etching rate regarding the organic underlayer film, as an etching gas, the organic underlayer film can be processed.

According to the first embodiment (FIG. 1) of the reverse patterning process of the present invention, in the second step (IIa), the pattern 2a of the organic underlayer film formed in the first step and the pattern 3a of the silicon-containing resist middle layer film are coated and filled with the inventive silicon-containing composition to cover the space portions of the pattern with a silicon-containing film 5.

In this step, the inventive silicon-containing composition is applied by spin-coating onto the pattern 2a of the organic underlayer film formed in the first step and the pattern 3a of the silicon-containing resist middle layer film, and then the solvent is evaporated. Subsequently, it is desirable to perform heating (baking) to promote the crosslinking reaction, and as a result, the filling property of the silicon-containing composition can be improved. The baking temperature is preferably 50 to 500°C, and the baking time is preferably 10 to 300 seconds. To reduce heat damage to the device, baking at 400°C or lower is preferable, although this depends on the structure of the device to be manufactured. The film thickness is preferably 5 to 200 nm, more preferably 10 to 100 nm.

According to the first embodiment (FIG. 1) of the reverse patterning process of the present invention, in the third step (IIIa), unnecessary portions are removed from the silicon-containing film 5 formed in the second step. In this step, dry etching using a fluorocarbon-based gas is suitably used, and etching is performed until the top part of the pattern organic underlayer film pattern 2a formed in the first step is exposed. In this event, the pattern 3a of the silicon-containing resist middle layer film used as a mask when processing the organic underlayer film in the step (Ia-6) is also removed. Specific examples of the fluorocarbon-based gas include difluoromethane, tetrafluoromethane, perfluoropropane, perfluorocyclobutane, and trifluoromethane.

According to the first embodiment (FIG. 1) of the reverse patterning process of the present invention, in the fourth step (IVa), the organic underlayer film pattern 2a is removed to form a pattern 5b of the silicon-containing film on the body to be processed. In this step, dry etching using oxygen gas or hydrogen gas is suitably used, and etching is performed until the organic underlayer film is completely removed.

When forming the pattern in the resist upper layer film, it is preferable to use a patterning process using a lithography using light having a wavelength of 10 nm or more and 300 nm or less, a direct writing with electron beam, nanoimprinting, or a combination thereof.

### <<Patterning Employing Metal Nitride Film>>

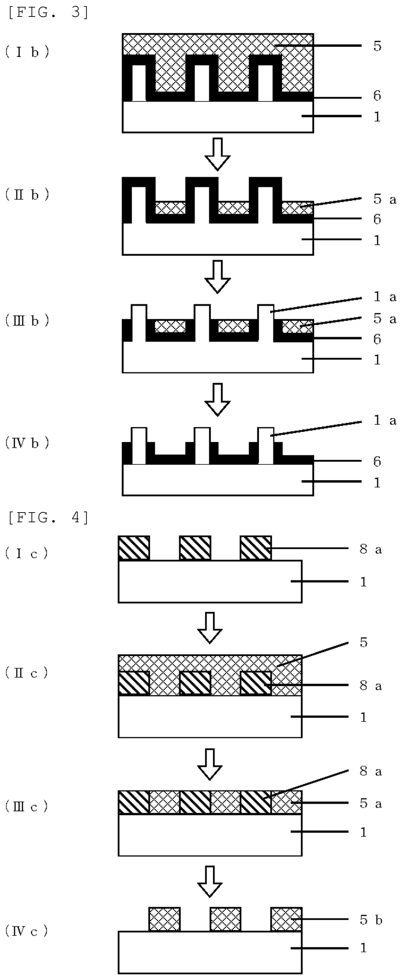

A second embodiment of the inventive patterning process is a patterning process including the steps of:
(I) coating and filling a pattern of a body to be processed covered with a metal nitride film by using the inventive silicon-containing composition;
(II) partially removing unnecessary portions from a silicon-containing film formed in the step (I);
(III) processing the body to be processed covered with the metal nitride film while using the silicon-containing film remaining as a mask; and
(IV) removing the silicon-containing film remaining after substrate processing. In the following, an example of an embodiment of the present invention will be described with reference to FIG. 3.

The second embodiment (FIG. 3) of the inventive patterning process includes the steps of:
(Ib) coating a pattern of a body 1 to be processed covered with a metal nitride film 6 by using the inventive silicon-containing composition to fill the pattern with a silicon-containing film 5;
(IIb) partially removing unnecessary portions from the formed silicon-containing film 5 to obtain a silicon-containing film 5a after the removal;
(IIIb) processing the body 1a to be processed covered with the metal nitride film 6 while using the silicon-containing film 5a remaining as a mask; and
(IVb) removing the silicon-containing film remaining after substrate processing.

According to the second embodiment (FIG. 3) of the inventive patterning process, in the first step (Ib), a pattern of a body 1 to be processed covered with a metal nitride film 6 is coated and filled with the inventive silicon-containing composition to cover the space portions of the pattern with a silicon-containing film 5.

In this step, the inventive silicon-containing composition is applied by spin-coating onto a body 1 to be processed covered with a metal nitride film 6, and then the solvent is evaporated. Subsequently, it is desirable to perform heating (baking) to promote the crosslinking reaction, and as a result, the filling property of the silicon-containing composition can be improved. The baking temperature is preferably 50 to 500°C, and the baking time is preferably 10 to 300 seconds. To reduce heat damage to the device, baking at 400°C or lower is preferable, although this depends on the structure of the device to be manufactured. The film thickness is preferably 5 to 200 nm, more preferably 10 to 100 nm.

According to the second embodiment (FIG. 3) of the inventive patterning process, in the second step (IIb), unnecessary portions are partially removed from the silicon-containing film 5 formed in the first step to obtain a silicon-containing film 5a after the removal. In this step, dry etching using a fluorocarbon-based gas is suitably used, and etching is performed until part of the pattern of the body to be processed covered with the metal nitride film is exposed. Specific examples of the fluorocarbon-based gas include difluoromethane, tetrafluoromethane, perfluoropropane, perfluorocyclobutane, and trifluoromethane.

According to the second embodiment (FIG. 3) of the inventive patterning process, in the third step (IIIb), the body 1a to be processed covered with the metal nitride film 6 is processed while using the silicon-containing film 5a remaining after the second step as a mask. Examples of the chemical solution used for the processing include SC1 (a mixed solution of ammonia water, hydrogen peroxide solution, and water), SC2 (a mixed solution of hydrochloric acid, hydrogen peroxide solution, and water), SPM (a mixed solution of sulfuric acid and hydrogen peroxide solution), etc., but are not limited thereto. The silicon-containing film remaining after the second step has sufficient resistance to chemical solutions, and therefore, the metal nitride film covered with the silicon-containing film is not affected by the processing with a chemical solution.

According to the second embodiment (FIG. 3) of the inventive patterning process, in the fourth step (IVb), the silicon-containing film 5a remaining after the substrate processing in the third step is removed. In this step, dry etching using a fluorocarbon-based gas is suitably used, and etching is performed until part of the pattern of the body to be processed covered with the metal nitride film is exposed. Specific examples of the fluorocarbon-based gas include difluoromethane, tetrafluoromethane, perfluoropropane, perfluorocyclobutane, and trifluoromethane.

### <<Reverse Patterning Employing Nanoimprinting Method>>

A third embodiment of the inventive patterning process is a patterning process including the steps of:
(I) forming a pattern of an organic film by a nanoimprinting method on a body to be processed;
(II) coating and filling the organic film having the pattern transferred by using the inventive silicon-containing composition;
(III) removing unnecessary portions from a silicon-containing film formed in the step (II); and
(IV) removing the organic film by etching to form a silicon-containing pattern on the body to be processed. In the following, an example of an embodiment of the present invention will be described with reference to FIG. 4.

The third embodiment (FIG. 4) of the reverse patterning process of the present invention includes the steps of:
(Ic) forming a pattern 8a of a layer for transferring a pattern to (organic film), formed by a nanoimprinting method, on a body 1 to be processed;
(IIc) coating the pattern 8a of the organic film with the inventive silicon-containing composition to fill the pattern with a silicon-containing film 5;
(IIIc) removing unnecessary portions from the formed silicon-containing film to obtain a silicon-containing film 5a after the removal; and
(IVc) removing the pattern 8a of the layer for transferring a pattern to (organic film) to form a pattern 5b of the silicon-containing film on the body to be processed.

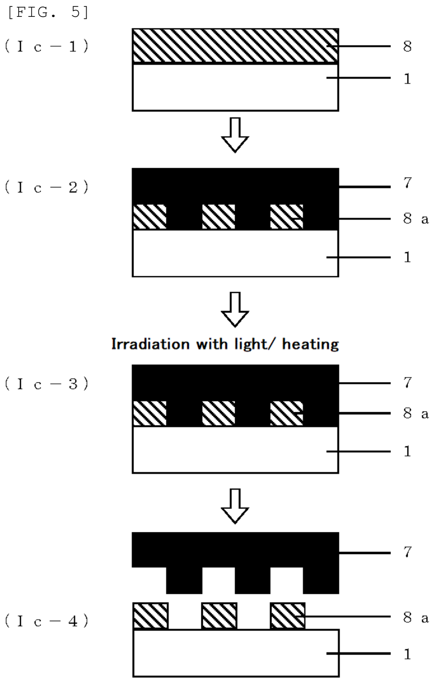

According to the third embodiment (FIG. 4) of the reverse patterning process of the present invention, in the first step (FIG. 5), (Ic) a pattern 8a of a layer for transferring a pattern to (organic film) is formed by a nanoimprinting method on a body 1 to be processed. This step includes the steps of:
(Ic-1) forming a layer 8 for transferring a pattern to (organic film) constituted by a photo-curing composition or a thermosetting composition for nanoimprinting lithography on a body 1 to be processed;
(Ic-2) pressing a mold 7 onto the layer 8 for transferring a pattern to (organic film);
(Ic-3) exposing or heating the layer 8 for transferring a pattern to (organic film); and
(Ic-4) removing the mold 7 from the layer for transferring a pattern to to form a pattern 8a of the layer for transferring a pattern to (organic film).

In the step (Ic-1), a layer 8 for transferring a pattern to (organic film) constituted by a photo-curing composition or a thermosetting composition for nanoimprinting lithography is formed on a body 1 to be processed. In this step, a photo-curing composition for nanoimprinting lithography is applied onto a body to be processed by an ink jet method, a dip coating method, an air knife coating method, a curtain coating method, a wire bar coating method, a gravure coating method, an extrusion coating method, a spin coating method, a slit scan method, etc. The film thickness of the layer for transferring a pattern to varies depending on the purpose for which the layer is used, but can be 10 to 1,000 nm.

In the step (Ic-2), a mold 7 with a pattern is pressed onto the layer 8 for transferring a pattern to. The pattern is transferred to the layer for transferring a pattern to by the pressing with the mold 7. The material of the mold used is not particularly limited as long as it has the predetermined strength and durability. Specifically, examples of the material include PMMA, polycarbonate resin, glass, and quartz, but are not limited thereto. The pressure on pressing is preferably 0.1 to 50 MPa, particularly preferably 0.1 to 20 MPa. The time of the pressing is preferably 0.1 to 300 seconds, particularly preferably 0.1 to 120 seconds.

In the step (Ic-3), when a photo-curing reaction is applied, the layer for transferring a pattern to, subjected to the pressing step, is exposed through a transparent mold 7 to perform a photo-curing reaction. As the light used for the photo-curing, it is possible to use a charged particle beam etc., such as visible light, ultraviolet ray, far-ultraviolet ray, X-ray, and electron beam. When a thermosetting reaction is applied, the layer for transferring a pattern to, subjected to the pressing step, is heated to perform a thermosetting reaction. The thermosetting is preferably performed using a hot plate, an oven, a furnace, etc. under conditions of an inert atmosphere, such as nitrogen or argon, or under reduced pressure at a temperature of 40 to 200°C.

In the step (Ic-4), the mold 7 is removed from the layer 8 for transferring a pattern to, and thus, a desired organic film pattern 8a can be formed in the layer for transferring a pattern to.

According to the third embodiment (FIG. 4) of the reverse patterning process of the present invention, in the second step (IIc), the pattern 8a of the organic film formed in the first step is coated and filled with the inventive silicon-containing composition to cover the space portions of the pattern with a silicon-containing film 5. In this step, a step similar to the step (IIa) of the first embodiment is applied.

According to the third embodiment (FIG. 4) of the reverse patterning process of the present invention, in the third step (IIIc), unnecessary portions are removed from the silicon-containing film 5 formed in the second step. In this step, a step similar to the step (IIIa) of the first embodiment is applied.

According to the third embodiment (FIG. 4) of the reverse patterning process of the present invention, in the fourth step (IVc), the pattern 8a of the organic film is removed to form a pattern (5b) of the silicon-containing film on the body 1 to be processed. In this step, a step similar to the step (IVa) of the first embodiment is applied.

### [Body to Be Processed]

As the body to be processed used in the reverse patterning process of the present invention, a semiconductor device substrate, a metal film, a metal carbide film, a metal oxide film, a metal nitride film, a metal oxycarbide film, or a metal oxynitride film can be used. Specifically, a substrate of Si, α-Si, p-Si, SiO₂, SiN, SiON, SiOC, TiN, Cr, CrO, CrON, MoSi, W, WSi, Cu, Al, Al-Si, etc., the substrate having the above-described metal film or the like formed thereon as a layer to be processed, etc. can be used, and normally, one having a thickness of 50 to 10,000 nm, in particular, 100 to 5,000 nm, is used.

As the metal constituting the body to be processed, it is preferable to use silicon, titanium, tungsten, hafnium, zirconium, chromium, germanium, copper, silver, gold, aluminum, indium, gallium, arsenic, palladium, iron, tantalum, iridium, molybdenum, cobalt, or an alloy thereof.

### EXAMPLES

Hereinafter, the present invention will be specifically described with reference to Synthesis Examples, Examples, and Comparative Examples. However, the present invention is not limited by the Examples. Note that, in the following examples, "%" means "mass%". Analysis regarding molecular weight was carried out by gel permeation chromatography (GPC) using a RI or UV detector and using tetrahydrofuran as an eluent, and weight-average molecular weight (Mw) and number-average molecular weight (Mn) were determined in terms of polystyrene by using polystyrene as a reference substance, and dispersity (Mw/Mn) was calculated therefrom.

### [Synthesis Example]

### <1. Silicon-Containing Resin>

### [Silicon-Containing Resin Synthesis Example 1]

To a mixture of methanol (120 g), 10% nitric acid (0.1 g), and deionized water (60 g), a mixture of Monomer 101 (30.6 g), Monomer 102 (38.1 g), and Monomer 110 (5.9 g), shown below, was added (molar ratio=40/50/10), and the mixture was maintained for 12 hours at 23°C to perform hydrolysis condensation. After completion of the reaction, propylene glycol ethyl ether (PGEE) (600 g) was added thereto. The water used in the hydrolysis condensation and by-produced alcohol were distilled off under reduced pressure to obtain 440 g of a solution of a silicon-containing resin (SP-1) in PGEE (compound concentration 10%). The molecular weight of the obtained resin was Mw=1,900 in terms of polystyrene. The results are shown in Table 1 below.

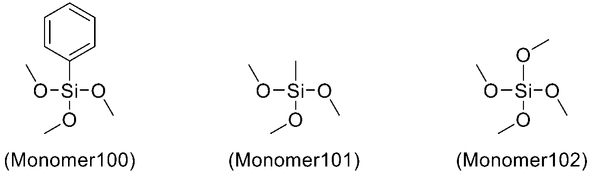

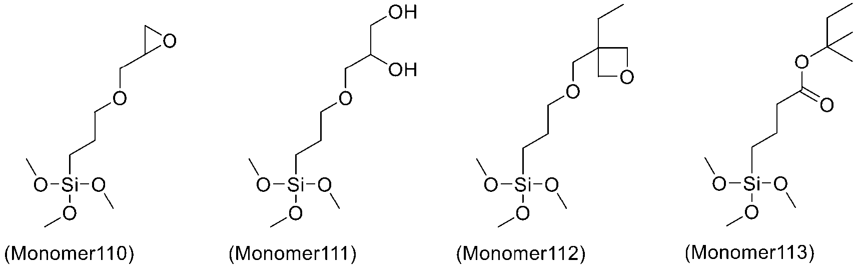

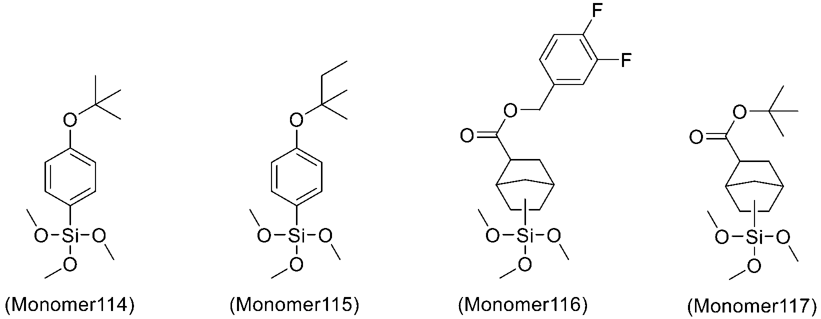

### [Silicon-Containing Resin Synthesis Examples 2 to 19]

Synthesis was carried out under the same conditions as in Silicon-Containing Resin Synthesis Example 1 by using the hydrolysable monomers shown in Table 1 below to obtain target silicon-containing resins (SP-2) to (SP-18).

**[Table 1]**

| Silicon-containing resin name | Hydrolysable monomer number/used proportion (mol%) | | | | | Mw |
|---|---|---|---|---|---|---|
| SP-1 | 101 (40) | 102 (50) | 110 (10) | | | 1,900 |
| SP-2 | 100 (5) | 101 (45) | 102 (50) | | | 1,300 |
| SP-3 | 100 (5) | 101 (40) | 102 (50) | 110 (2) | 111 (3) | 1,900 |
| SP-4 | 101 (45) | 102 (50) | 112 (3) | 115 (2) | | 1,600 |
| SP-5 | 100 (5) | 101 (40) | 102 (50) | 113 (2) | 115 (3) | 1,300 |
| SP-6 | 100 (5) | 101 (40) | 102 (50) | 114 (5) | | 1,500 |
| SP-7 | 100 (5) | 101 (40) | 102 (50) | 112 (2) | 116 (3) | 1,300 |
| SP-8 | 100 (5) | 101 (40) | 102 (50) | 116 (5) | | 1,300 |
| SP-9 | 100 (5) | 101 (40) | 102 (50) | 117 (5) | | 1,500 |
| SP-10 | 100 (5) | 101 (40) | 102 (50) | 116 (2) | 117 (3) | 1,100 |
| SP-11 | 100 (20) | 101 (10) | 102 (70) | | | 1,800 |
| SP-12 | 100 (10) | 101 (10) | 102 (70) | 110 (10) | | 1,500 |
| SP-13 | 100 (10) | 101 (10) | 102 (70) | 110 (4) | 111 (6) | 1,700 |
| SP-14 | 100 (10) | 101 (10) | 102 (70) | 112 (6) | 115 (4) | 1,500 |
| SP-15 | 100 (10) | 101 (10) | 102 (70) | 113 (4) | 115 (6) | 1,700 |
| SP-16 | 100 (10) | 101 (10) | 102 (70) | 114 (10) | | 1,700 |
| SP-17 | 101 (30) | 102 (70) | | | | 1,800 |
| SP-18 | 101 (50) | 102 (50) | | | | 1,900 |

### <2. Polymer for Surfactant>

### [Polymer Synthesis Example 1]

Propylene glycol monomethyl ether acetate (PGMEA) (10.0 g) was heated and stirred under a nitrogen atmosphere at 80°C. A mixture of Monomer (M-1) (3.60 g/15.0 mmol), shown below, dimethyl-2,2-azobis(2-methylpropionate) (0.173 g/0.75 mmol), and PGMEA (15g) was added dropwise thereto over 4 hours. The mixture was further heated and stirred for 16 hours, and then cooled to room temperature to obtain a solution of the target Polymer (P-1) in PGMEA. As a result of analysis, it was found that the polymer (P-1) had a weight-average molecular weight (Mw) of 12,900 and a dispersity of (Mw/Mn) 1.45. The results are shown in Table 2.

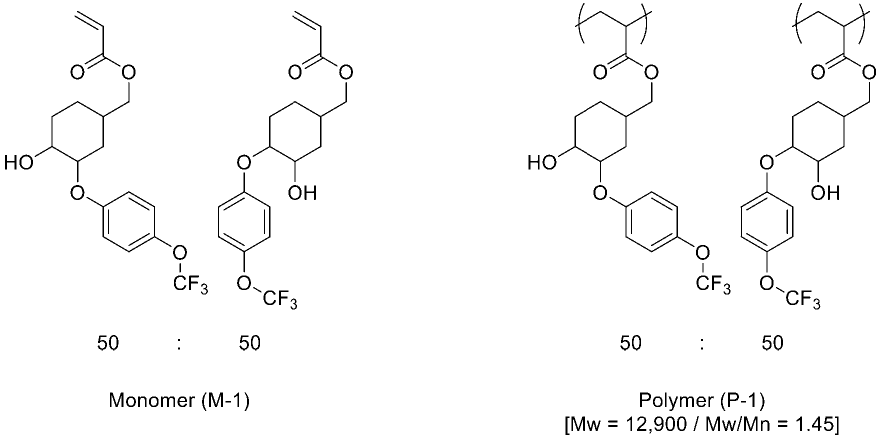

### [Polymer Synthesis Examples 2 to 24]

Polymerization was performed using the following Monomers (M-2) to (M-17) under the same conditions as in Polymer Synthesis Example 1 to obtain solutions of the following Polymers (P-2) to (P-24) in PGMEA. The weight-average molecular weight (Mw) and the dispersity (Mw/Mn) determined by GPC are also shown in the formulae. The results are shown in Table 2 below.

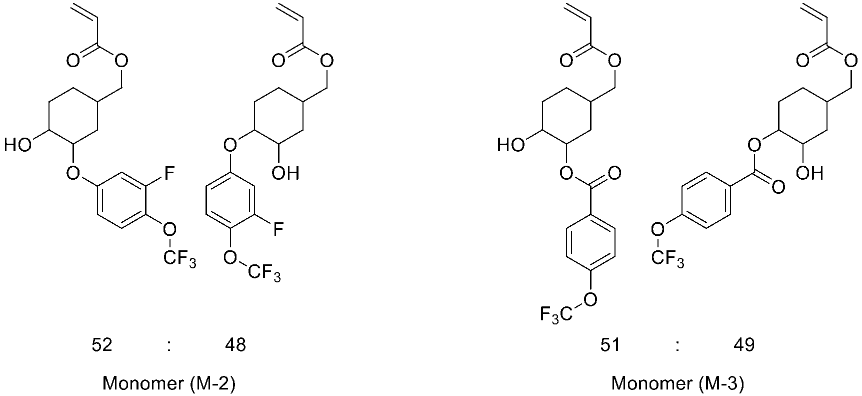

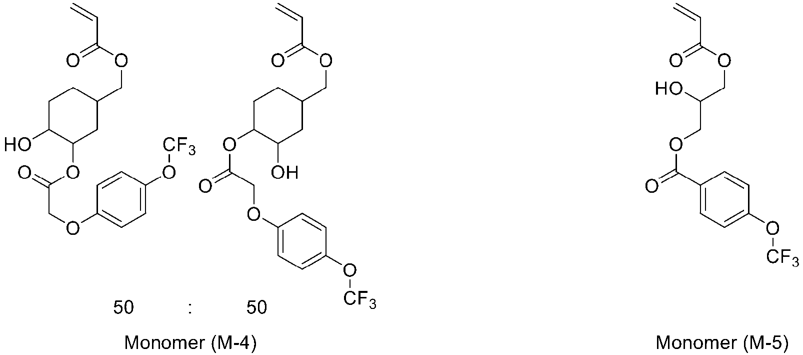

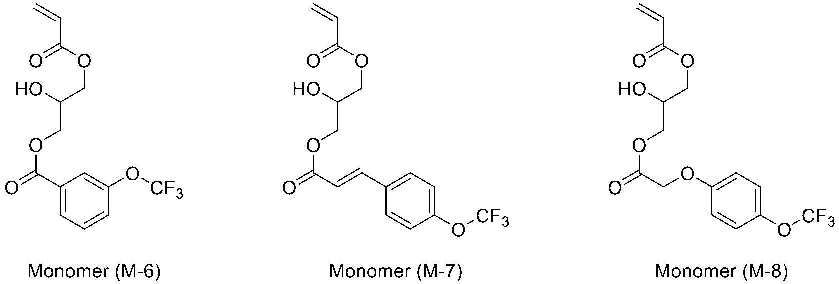

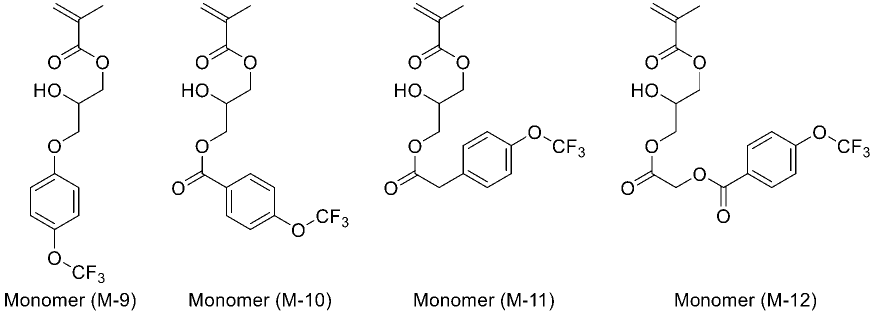

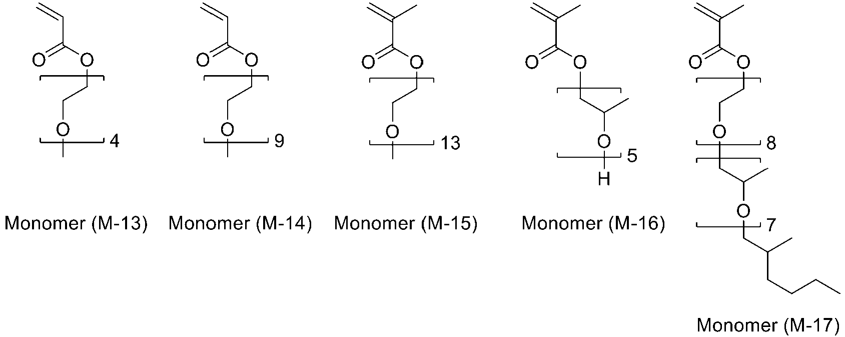

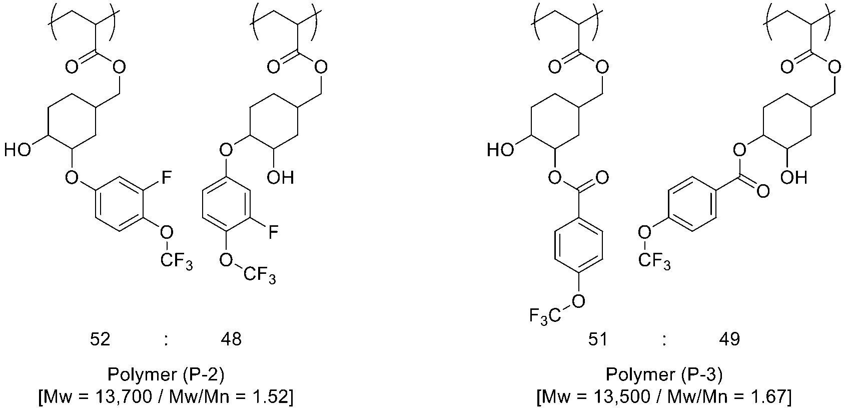

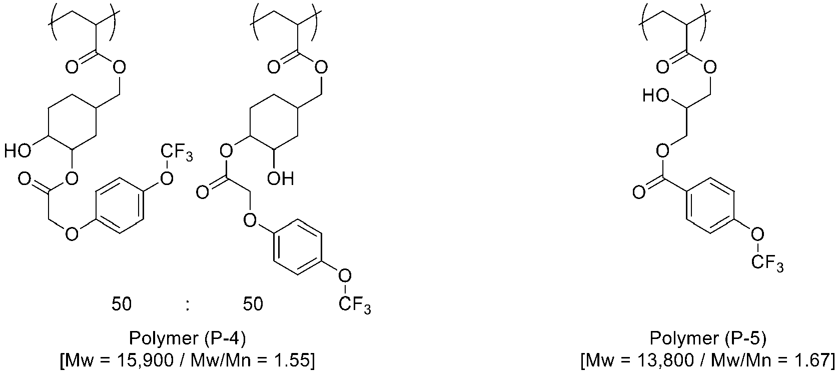

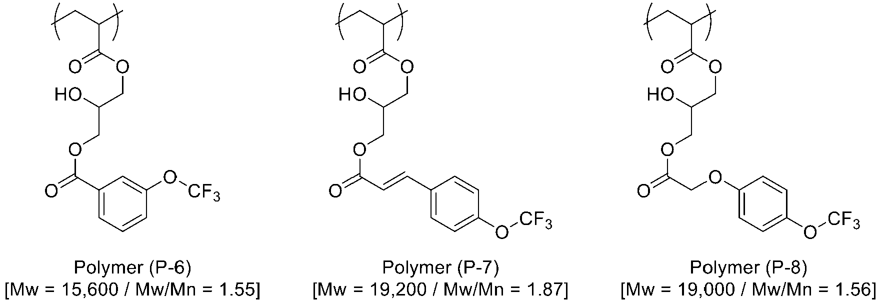

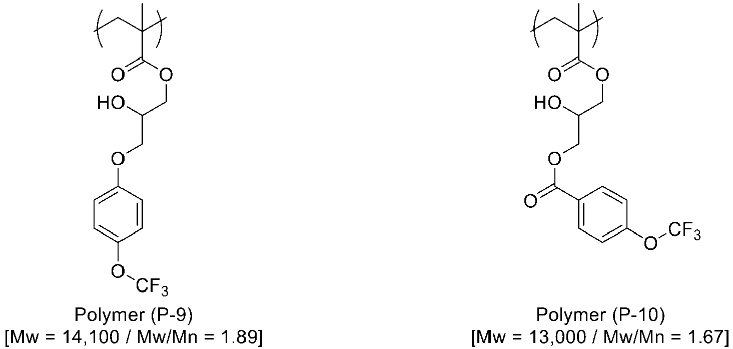

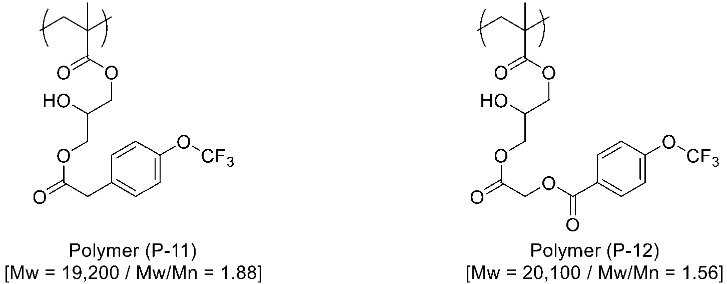

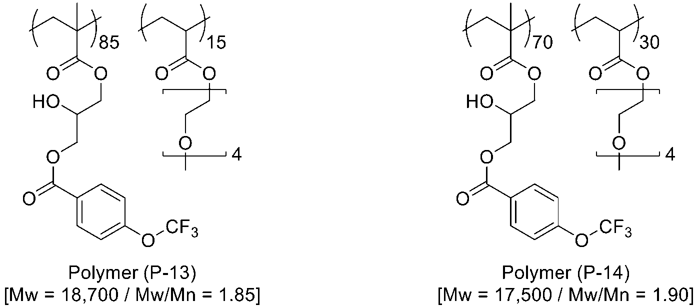

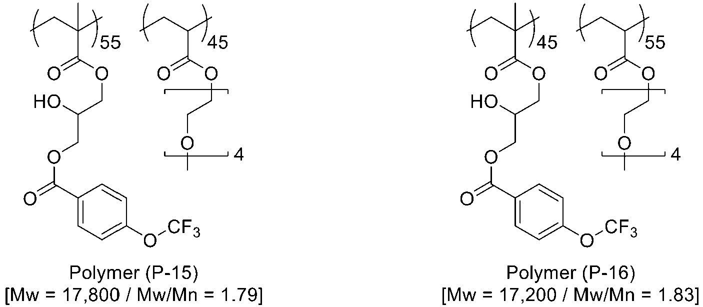

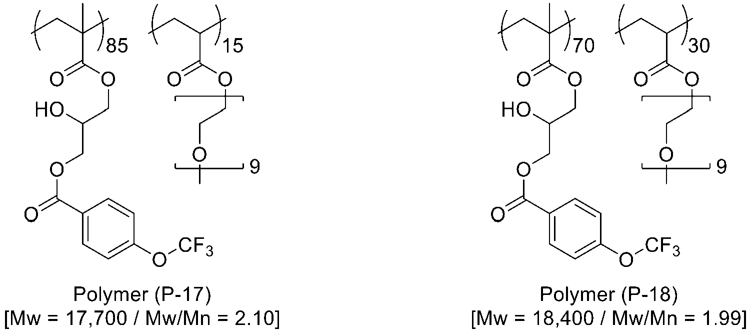

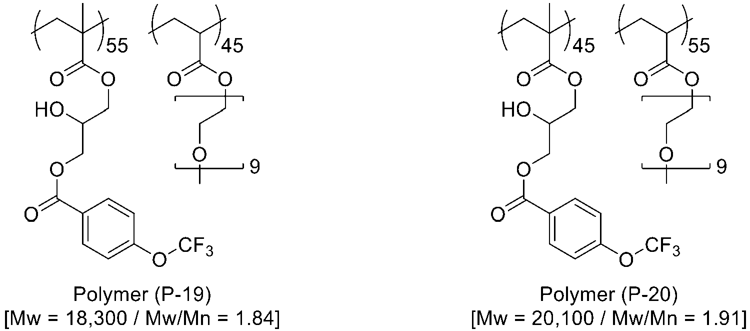

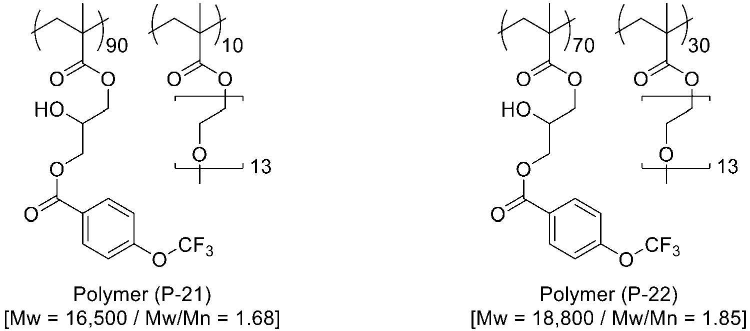

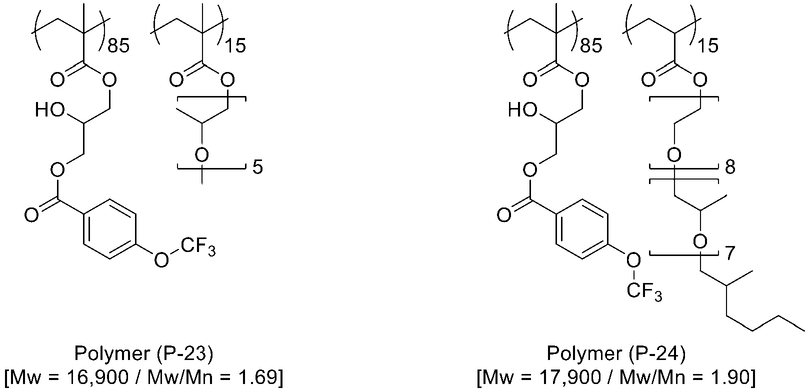

**[Table 2]**

| Polymer name | Monomer name | | Composition ratio | Mw | Mw/Mn |
|---|---|---|---|---|---|
| P-1 | M-1 | | 100 | 12,900 | 1.45 |
| P-2 | M-2 | | 100 | 13,700 | 1.52 |
| P-3 | M-3 | | 100 | 13,500 | 1.67 |
| P-4 | M-4 | | 100 | 15,900 | 1.55 |
| P-5 | M-5 | | 100 | 13,800 | 1.67 |
| P-6 | M-6 | | 100 | 15,600 | 1.55 |
| P-7 | M-7 | | 100 | 19,200 | 1.87 |
| P-8 | M-8 | | 100 | 19,000 | 1.56 |
| P-9 | M-9 | | 100 | 14,100 | 1.89 |
| P-10 | M-10 | | 100 | 13,000 | 1.67 |
| P-11 | M-11 | | 100 | 19,200 | 1.88 |
| P-12 | M-12 | | 100 | 20,100 | 1.56 |
| P-13 | M-9 | M-13 | 85:15 | 18,700 | 1.85 |
| P-14 | M-9 | M-13 | 70:30 | 17,500 | 1.90 |
| P-15 | M-9 | M-13 | 55:45 | 17,800 | 1.79 |
| P-16 | M-9 | M-13 | 45:55 | 17,200 | 1.83 |
| P-17 | M-9 | M-14 | 85:15 | 17,700 | 2.10 |
| P-18 | M-9 | M-14 | 70:30 | 18,400 | 1.99 |
| P-19 | M-9 | M-14 | 55:45 | 18,300 | 1.84 |
| P-20 | M-9 | M-14 | 45:55 | 20,100 | 1.91 |
| P-21 | M-9 | M-15 | 90:10 | 16,500 | 1. 68 |
| P-22 | M-9 | M-15 | 70:30 | 18,800 | 1.85 |
| P-23 | M-9 | M-16 | 85:15 | 16,900 | 1.69 |
| P-24 | M-9 | M-17 | 85:15 | 17,900 | 1.90 |

### <3. Comparative Polymer>

### [Comparative Polymer Synthesis Examples 1 to 7]

Polymerization was performed using the following Monomers (RM-1) to (RM-8) under the same conditions as in Polymer Synthesis Example 1 to obtain solutions of the following Polymers (R-1) to (R-7) in PGMEA. The weight-average molecular weight (Mw) and the dispersity (Mw/Mn) determined by GPC are also shown in the formulae. The results are shown in Table 3.

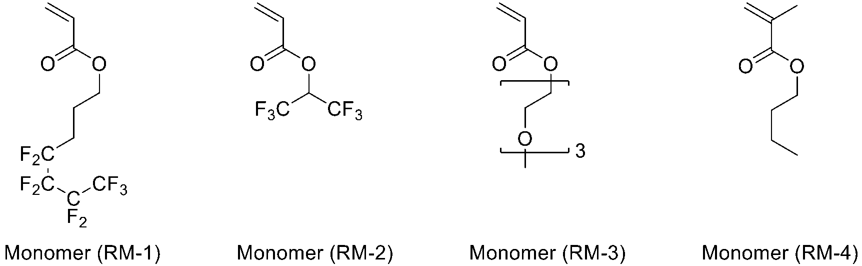

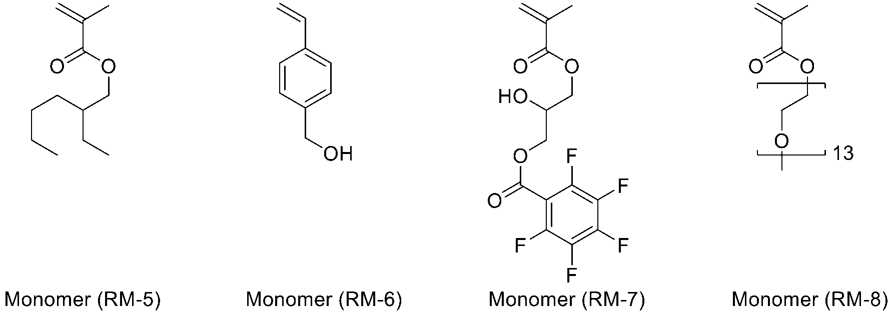

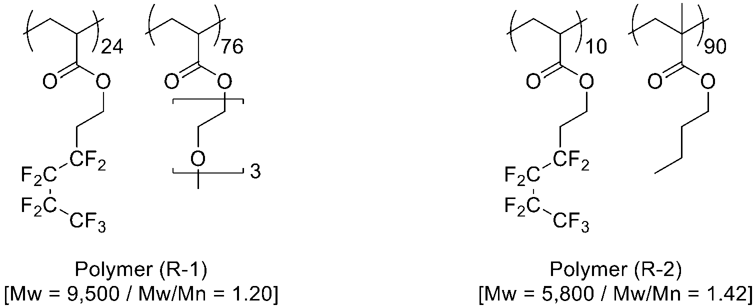

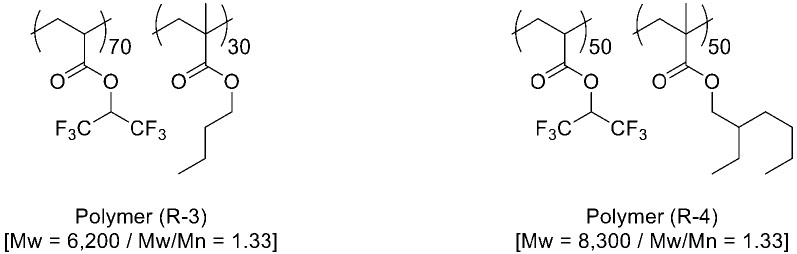

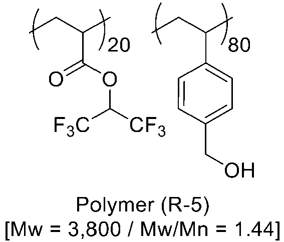

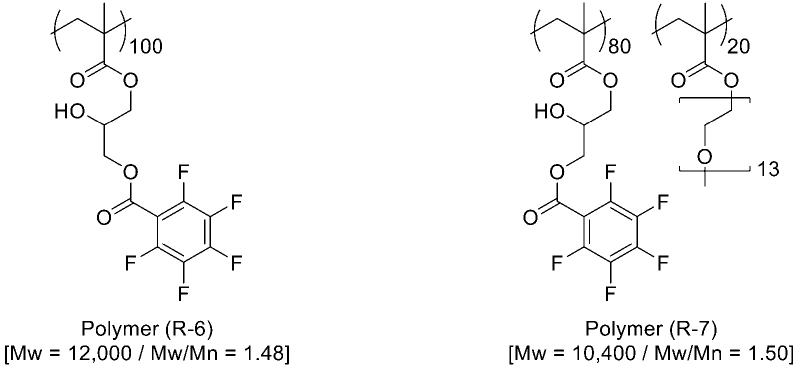

**[Table 3]**

| Polymer name | Monomer name | | Composition ratio | Mw | Mw/Mn |
|---|---|---|---|---|---|
| R-1 | RM-1 | RM-3 | 24:76 | 9,500 | 1.20 |
| R-2 | RM-1 | RM-4 | 10:90 | 5,800 | 1.42 |
| R-3 | RM-2 | RM-4 | 70:30 | 6,200 | 1.33 |
| R-4 | RM-2 | RM-5 | 50:80 | 3,800 | 1.44 |
| R-5 | RM-5 | RM-6 | 20:76 | 13,800 | 1.67 |
| R-6 | RM-7 | | 100 | 15,600 | 1.55 |
| R-7 | RM-7 | RM-8 | 80:20 | 10,400 | 1.50 |

### [Preparation Examples of Silicon-Containing Composition]

The silicon-containing resins (SP-1) to (SP-18) obtained in the Synthesis Examples, the polymers (P-1) to (P-24), the comparative polymers (R-1) to (R-7), a curing catalyst, photo-acid generators (PAG-1 to -7 shown in Table 8), and an acid were used in the proportions (parts by mass) shown in parentheses in Tables 4 to 7 below. The components were mixed in a mixed solvent of propylene glycol ethyl ether (PGEE/100 parts) and water (10 parts) and filtered through a 0.1-µm filter made of fluorinated resin. Thus, silicon-containing composition solutions were prepared as Sol-1 to -74 respectively.

**[Table 4]**

| Composition number | Silicon-containing resin | Polymer | Curing catalyst | Photo-acid generator | Acid |
|---|---|---|---|---|---|
| Sol 1 | SP-1 (1.0) | P-1 (0.01) | TPS-NO₃ (0.01) | - | Maleic acid (0.01) |
| Sol 2 | SP-2 (1.0) | P-2 (0.01) | TPS-NO₃ (0.01) | - | Maleic acid (0.01) |
| Sol 3 | SP-3 (1.0) | P-3 (0.01) | TPS-NO₃ (0.01) | - | Maleic acid (0.01) |
| Sol 4 | SP-4 (1.0) | P-4 (0.01) | TPS-NO₃ (0.01) | - | Maleic acid (0.01) |
| Sol 5 | SP-5 (1.0) | P-5 (0.01) | TPS-NO₃ (0.01) | - | Maleic acid (0.01) |
| Sol 6 | SP-6 (1.0) | P-6 (0.01) | TPS-NO₃ (0.01) | - | Maleic acid (0.01) |
| Sol 7 | SP-7 (1.0) | P-7 (0.01) | TPS-NO₃ (0.01) | - | Maleic acid (0.01) |
| Sol 8 | SP-8 (1.0) | P-8 (0.01) | TPS-NO₃ (0.01) | - | Maleic acid (0.01) |
| Sol 9 | SP-9 (1.0) | P-9 (0.01) | TPS-NO₃ (0.01) | - | Maleic acid (0.01) |
| Sol 10 | SP-10 (1.0) | P-10 (0.01) | TPS-NO₃ (0.01) | - | Maleic acid (0.01) |
| Sol 11 | SP-11 (1.0) | P-11 (0.01) | TPS-NO₃ (0.01) | - | Maleic acid (0.01) |
| Sol 12 | SP-12 (1.0) | P-12 (0.01) | TPS-NO₃ (0.01) | - | Maleic acid (0.01) |
| Sol 13 | SP-13 (1.0) | P-13 (0.01) | TPS-NO₃ (0.01) | - | Maleic acid (0.01) |
| Sol 14 | SP-14 (1.0) | P-14 (0.01) | TPS-NO₃ (0.01) | - | Maleic acid (0.01) |
| Sol 15 | SP-15 (1.0) | P-15 (0.01) | TPS-NO₃ (0.01) | - | Maleic acid (0.01) |
| Sol 16 | SP-16 (1.0) | P-16 (0.01) | TPS-NO₃ (0.01) | - | Maleic acid (0.01) |
| Sol 17 | SP-17 (1.0) | P-17 (0.01) | TPS-NO₃ (0.01) | - | Maleic acid (0.01) |
| Sol 18 | SP-18 (1.0) | P-18 (0.01) | TPS-NO₃ (0.01) | - | Maleic acid (0.01) |
| Sol 19 | SP-1 (1.0) | P-19 (0.01) | TPS-NO₃ (0.01) | - | Maleic acid (0.01) |
| Sol 20 | SP-2 (1.0) | P-20 (0.01) | TPS-NO₃ (0.01) | - | Maleic acid (0.01) |

**[Table 5]**

| Composition number | Silicon-containing resin | Polymer | Curing catalyst | Photo-acid generator | Acid |
|---|---|---|---|---|---|
| Sol 21 | SP-3 (1.0) | P-21 (0.01) | TPS-NO₃ (0.01) | - | Maleic acid (0.01) |
| Sol 22 | SP-4 (1.0) | P-22 (0.01) | TPS-NO₃ (0.01) | - | Maleic acid (0.01) |
| Sol 23 | SP-5 (1.0) | P-23 (0.01) | TPS-NO₃ (0.01) | - | Maleic acid (0.01) |
| Sol 24 | SP-6 (1.0) | P-24 (0.01) | TPS-NO₃ (0.01) | - | Maleic acid (0.01) |
| Sol 25 | SP-1 (1.0) | P-1 (0.01) | QBA-NO₃ (0.01) | - | Maleic acid (0.01) |
| Sol 26 | SP-2 (1.0) | P-2 (0.01) | QBA-NO₃ (0.01) | - | Maleic acid (0.01) |
| Sol 27 | SP-3 (1.0) | P-3 (0.01) | QBA-NO₃ (0.01) | - | Maleic acid (0.01) |
| Sol 28 | SP-4 (1.0) | P-4 (0.01) | QBA-NO₃ (0.01) | - | Maleic acid (0.01) |
| Sol 29 | SP-5 (1.0) | P-5 (0.01) | QBA-NO₃ (0.01) | - | Maleic acid (0.01) |
| Sol 30 | SP-6 (1.0) | P-6 (0.01) | QBA-NO₃ (0.01) | - | Maleic acid (0.01) |
| Sol 31 | SP-7 (1.0) | P-7 (0.01) | QBA-NO₃ (0.01) | - | Maleic acid (0.01) |
| Sol 32 | SP-8 (1.0) | P-8 (0.01) | QBA-NO₃ (0.01) | - | Maleic acid (0.01) |
| Sol 33 | SP-9 (1.0) | P-9 (0.01) | QBA-NO₃ (0.01) | - | Maleic acid (0.01) |
| Sol 34 | SP-10 (1.0) | P-10 (0.01) | QBA-NO₃ (0.01) | - | Maleic acid (0.01) |
| Sol 35 | SP-11 (1.0) | P-11 (0.01) | QBA-NO₃ (0.01) | - | Maleic acid (0.01) |
| Sol 36 | SP-12 (1.0) | P-12 (0.01) | QBA-NO₃ (0.01) | - | Maleic acid (0.01) |
| Sol 37 | SP-13 (1.0) | P-13 (0.01) | QBA-NO₃ (0.01) | - | Maleic acid (0.01) |
| Sol 38 | SP-14 (1.0) | P-14 (0.01) | QBA-NO₃ (0.01) | - | Maleic acid (0.01) |
| Sol 39 | SP-15 (1.0) | P-15 (0.01) | QBA-NO₃ (0.01) | - | Maleic acid (0.01) |
| Sol 40 | SP-16 (1.0) | P-16 (0.01) | QBA-NO₃ (0.01) | - | Maleic acid (0.01) |

**[Table 6]**

| Composition number | Silicon-containing resin | Polymer | Curing catalyst | Photo-acid generator | Acid |
|---|---|---|---|---|---|
| Sol 41 | SP-17 (1.0) | P-17 (0.01) | QBA-NO₃ (0.01) | - | Maleic acid (0.01) |
| Sol 42 | SP-18 (1.0) | P-18 (0.01) | QBA-NO₃ (0.01) | - | Maleic acid (0.01) |
| Sol 43 | SP-1 (1.0) | P-19 (0.01) | QBA-NO₃ (0.01) | - | Maleic acid (0.01) |
| Sol 44 | SP-2 (1.0) | P-20 (0.01) | QBA-NO₃ (0.01) | - | Maleic acid (0.01) |
| Sol 45 | SP-3 (1.0) | P-21 (0.01) | QBA-NO₃ (0.01) | - | Maleic acid (0.01) |
| Sol 46 | SP-4 (1.0) | P-22 (0.01) | QBA-NO₃ (0.01) | - | Maleic acid (0.01) |
| Sol 47 | SP-5 (1.0) | P-23 (0.01) | QBA-NO₃ (0.01) | - | Maleic acid (0.01) |
| Sol 48 | SP-6 (1.0) | P-24 (0.01) | QBA-NO₃ (0.01) | - | Maleic acid (0.01) |
| Sol 49 | SP-1 (1.0) | P-1 (0.01) | TPS-NO₃ (0.01) | PAG-1 (0.01) | Maleic acid (0.01) |
| Sol 50 | SP-2 (1.0) | P-2 (0.01) | TPS-NO₃ (0.01) | PAG-1 (0.01) | Maleic acid (0.01) |
| Sol 51 | SP-3 (1.0) | P-3 (0.01) | TPS-NO₃ (0.01) | PAG-2 (0.01) | Maleic acid (0.01) |
| Sol 52 | SP-4 (1.0) | P-4 (0.01) | TPS-NO₃ (0.01) | PAG-2 (0.01) | Maleic acid (0.01) |
| Sol 53 | SP-5 (1.0) | P-5 (0.01) | TPS-NO₃ (0.01) | PAG-3 (0.01) | Maleic acid (0.01) |
| Sol 54 | SP-6 (1.0) | P-6 (0.01) | TPS-NO₃ (0.01) | PAG-3 (0.01) | Maleic acid (0.01) |
| Sol 55 | SP-7 (1.0) | P-7 (0.01) | TPS-NO₃ (0.01) | PAG-4 (0.01) | Maleic acid (0.01) |
| Sol 56 | SP-8 (1.0) | P-8 (0.01) | TPS-NO₃ (0.01) | PAG-4 (0.01) | Maleic acid (0.01) |
| Sol 57 | SP-9 (1.0) | P-9 (0.01) | TPS-NO₃ (0.01) | PAG-5 (0.01) | Maleic acid (0.01) |
| Sol 58 | SP-10 (1.0) | P-10 (0.01) | TPS-NO₃ (0.01) | PAG-5 (0.01) | Maleic acid (0.01) |
| Sol 59 | SP-11 (1.0) | P-11 (0.01) | TPS-NO₃ (0.01) | PAG-6 (0.01) | Maleic acid (0.01) |
| Sol 60 | SP-12 (1.0) | P-12 (0.01) | TPS-NO₃ (0.01) | PAG-6 (0.01) | Maleic acid (0.01) |

**[Table 7]**

| Composition number | Silicon-containing resin | Polymer | Curing catalyst | Photo-acid generator | Acid |
|---|---|---|---|---|---|
| Sol 61 | SP-13 (1.0) | P-13 (0.01) | TPS-NO₃ (0.01) | PAG-7 (0.01) | Maleic acid (0.01) |
| Sol 62 | SP-14 (1.0) | P-14 (0.01) | TPS-NO₃ (0.01) | PAG-7 (0.01) | Maleic acid (0.01) |
| Sol 63 | SP-1 (1.0) | P-1 (0.01) | TPS-TFA (0.01) | - | Maleic acid (0.01) |
| Sol 64 | SP-2 (1.0) | P-2 (0.01) | TPS-TFA (0.01) | - | Maleic acid (0.01) |
| Sol 65 | SP-3 (1.0) | P-3 (0.01) | TPS-TFA (0.01) | - | Maleic acid (0.01) |
| Sol 66 | SP-4 (1.0) | P-4 (0.01) | TPS-TFA (0.01) | - | Maleic acid (0.01) |
| Sol 67 | SP-5 (1.0) | P-5 (0.01) | TPS-TFA (0.01) | - | Maleic acid (0.01) |
| Sol 68 | SP-1 (1.0) | R-1 (0.01) | TPS-NO₃ (0.01) | | Maleic acid (0.01) |
| Sol 69 | SP-2 (1.0) | R-2 (0.01) | TPS-NO₃ (0.01) | | Maleic acid (0.01) |
| Sol 70 | SP-3 (1.0) | R-3 (0.01) | TPS-NO₃ (0.01) | | Maleic acid (0.01) |
| Sol 71 | SP-4 (1.0) | R-4 (0.01) | TPS-NO₃ (0.01) | | Maleic acid (0.01) |
| Sol 72 | SP-5 (1.0) | R-5 (0.01) | TPS-NO₃ (0.01) | | Maleic acid (0.01) |
| Sol 73 | SP-6 (1.0) | R-6 (0.01) | TPS-NO₃ (0.01) | | Maleic acid (0.01) |
| Sol 74 | SP-7 (1.0) | R-7 (0.01) | TPS-NO₃ (0.01) | | Maleic acid (0.01) |

| | | | | | |
|---|---|---|---|---|---|
| [0329] TPS-NO₃: triphenylsulfonium nitrate QBA-NO₃: tetrabutylammonium nitrate TPS-TFA: triphenylsulfonium trifluoroacetate | | | | | |

**[Table 8]**

| PAG number | Structure |
|---|---|
| 1 | 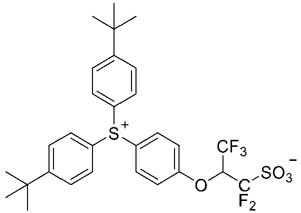 |
| 2 | 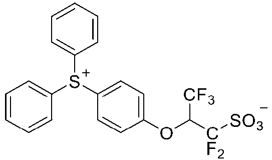 |
| 3 | 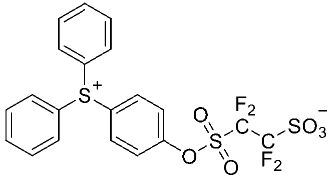 |
| 4 | 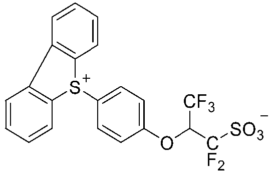 |
| 5 | 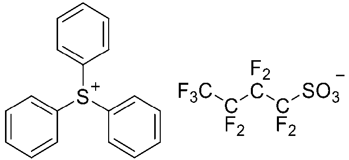 |
| 6 | 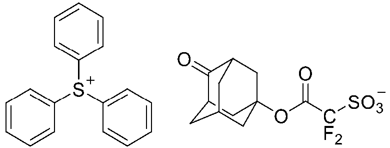 |
| 7 | 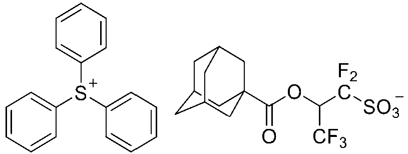 |

### [Three-Layer Patterning Example]

A silicon wafer was spin-coated with ODL-102, available from Shin-Etsu Chemical Co., Ltd., to form a film having a thickness of 200 nm. A film of SHB-A940, available from Shin-Etsu Chemical Co., Ltd., was formed thereon with a thickness of 20 nm. Subsequently, a film of an ArF resist solution SAIL-X108 for positive development, available from Shin-Etsu Chemical Co., Ltd., was formed so as to have a thickness of 100 nm, and furthermore, a film of IOC-301, available from Shin-Etsu Chemical Co., Ltd., was formed on the photoresist film so as to have a thickness of 50 nm.

Subsequently, these films were exposed with an ArF immersion exposure apparatus (manufactured by ASML Holding N.V., XT-1900i, NA 1.35, σ 0.97/0.77, 35° polarized dipole illumination), and baked (PEB) at 100°C for 60 seconds. Development was performed with a 2.38 mass% aqueous solution of tetramethylammonium hydroxide (TMAH) for 30 seconds to obtain a 40-nm 1:1 positive line-and-space pattern.

Using an etching apparatus Telius SP, manufactured by Tokyo Electron Limited, dry etching of (pattern transfer to) the silicon-containing resist underlayer film was performed under the conditions (1) shown in Table 9 below while using the obtained resist pattern as a mask. Subsequently, dry etching of (pattern transfer to) the organic underlayer film was performed under the conditions (2) shown in Table 9 below while using the obtained silicon-containing resist underlayer film pattern as a mask.

**[Table 9]**

| | Conditions (1) | Conditions (2) |
|---|---|---|
| Chamber pressure (Pa) | 10.0 | 2.0 |
| RF power (W) | 1,500 | 500 |
| Gas flow rate (mL/min) | CF₄ gas: 75 | Ar gas: 75 |
| | O₂ gas: 15 | O₂ gas: 45 |
| Treatment time (sec) | 15 | 120 |

### [Filling Property Evaluation Example]

To the organic underlayer film pattern obtained in the above, each of the silicon-containing composition solutions Sol-1 to -74 was respectively applied by spin-coating, and then baked at 250°C for 1 minute to form a film with a thickness of 120 nm.

Subsequently, the cross-sectional profile was observed by cross-sectional SEM measurement after film formation, and it was observed whether or not the inside of the pattern was filled with the silicon-containing composition without gaps. The results are shown in Tables 10 and 11. In this manner, it was observed that the films of the silicon-containing compositions Sol-1 to -67, which contained the polymers (P-1) to (P-24), being the component (B) of the present invention, were successfully formed in the patterns without gaps being generated, and that filling property was favorable. On the other hand, in the cases of the silicon-containing compositions Sol-68 to -74, which contained the comparative polymers (R-1) to (R-7), gaps were generated in parts of the patterns, and filling property was poor.

It was also observed that filling property regarding the pattern of the titanium nitride film formed on the silicon wafer and the pattern of the organic film formed on the silicon wafer by the nanoimprinting method also had similar results to the above. The results are shown in Tables 10 and 11.

### [Flatness Evaluation Example]

Film thicknesses in the part of the silicon-containing film formed in the above having the smallest film thickness and the part of the film having the greatest film thickness were measured, and as a result, it was found that when the silicon-containing compositions Sol-1 to -67 were used, the difference in film thicknesses was kept low, and the flatness of the silicon-containing film was favorable. On the other hand, when the silicon-containing compositions Sol-68 to -74 were used, it was not possible to keep the difference in film thicknesses low, and flatness was poor. The results are shown in Tables 10 and 11.

It was also observed that flatness regarding the pattern of the titanium nitride film formed on the silicon wafer and the pattern of the organic film formed on the silicon wafer by the nanoimprinting method also had similar results to the above. The results are shown in Tables 10 and 11.

### [Pattern Reversal Example]

Regarding the silicon-containing films of the silicon-containing compositions Sol-1 to -67 formed in the above, dry etching of the silicon-containing film was performed using an etching apparatus Telius SP, manufactured by Tokyo Electron Limited under the conditions (1) shown in Table 9 to expose the organic underlayer film pattern. After that, the organic underlayer film was removed using OK73 thinner (manufactured by TOKYO OHKA KOGYO CO., LTD.). As shown in Tables 10 and 11, it was observed that a favorable pattern of the inventive silicon-containing composition was successfully formed on the substrate.

**[Table 10]**

| Composition number | Filling property | Flatness | Pattern reversal | Nanoimprinting property |
|---|---|---|---|---|
| Sol 1 | Good | Good | Good | Good |
| Sol 2 | Good | Good | Good | Good |
| Sol 3 | Good | Good | Good | Good |
| Sol 4 | Good | Good | Good | Good |
| Sol 5 | Good | Good | Good | Good |
| Sol 6 | Good | Good | Good | Good |
| Sol 7 | Good | Good | Good | Good |
| Sol 8 | Good | Good | Good | Good |
| Sol 9 | Good | Good | Good | Good |
| Sol 10 | Good | Good | Good | Good |
| Sol 11 | Good | Good | Good | Good |
| Sol 12 | Good | Good | Good | Good |
| Sol 13 | Good | Good | Good | Good |
| Sol 14 | Good | Good | Good | Good |
| Sol 15 | Good | Good | Good | Good |
| Sol 16 | Good | Good | Good | Good |
| Sol 17 | Good | Good | Good | Good |
| Sol 18 | Good | Good | Good | Good |
| Sol 19 | Good | Good | Good | Good |
| Sol 20 | Good | Good | Good | Good |
| Sol 21 | Good | Good | Good | Good |
| Sol 22 | Good | Good | Good | Good |
| Sol 23 | Good | Good | Good | Good |
| Sol 24 | Good | Good | Good | Good |
| Sol 25 | Good | Good | Good | Good |
| Sol 26 | Good | Good | Good | Good |
| Sol 27 | Good | Good | Good | Good |
| Sol 28 | Good | Good | Good | Good |
| Sol 29 | Good | Good | Good | Good |
| Sol 30 | Good | Good | Good | Good |
| Sol 31 | Good | Good | Good | Good |
| Sol 32 | Good | Good | Good | Good |
| Sol 33 | Good | Good | Good | Good |
| Sol 34 | Good | Good | Good | Good |
| Sol 35 | Good | Good | Good | Good |
| Sol 36 | Good | Good | Good | Good |
| Sol 37 | Good | Good | Good | Good |
| Sol 38 | Good | Good | Good | Good |
| Sol 39 | Good | Good | Good | Good |
| Sol 40 | Good | Good | Good | Good |

**[Table 11]**

| Composition number | Filling property | Flatness | Pattern reversal | Nanoimprinting property |
|---|---|---|---|---|
| Sol 41 | Good | Good | Good | Good |
| Sol 42 | Good | Good | Good | Good |
| Sol 43 | Good | Good | Good | Good |
| Sol 44 | Good | Good | Good | Good |
| Sol 45 | Good | Good | Good | Good |
| Sol 46 | Good | Good | Good | Good |
| Sol 47 | Good | Good | Good | Good |
| Sol 48 | Good | Good | Good | Good |
| Sol 49 | Good | Good | Good | Good |
| Sol 50 | Good | Good | Good | Good |
| Sol 51 | Good | Good | Good | Good |
| Sol 52 | Good | Good | Good | Good |
| Sol 53 | Good | Good | Good | Good |
| Sol 54 | Good | Good | Good | Good |
| Sol 55 | Good | Good | Good | Good |
| Sol 56 | Good | Good | Good | Good |
| Sol 57 | Good | Good | Good | Good |
| Sol 58 | Good | Good | Good | Good |
| Sol 59 | Good | Good | Good | Good |
| Sol 60 | Good | Good | Good | Good |
| Sol 61 | Good | Good | Good | Good |
| Sol 62 | Good | Good | Good | Good |
| Sol 63 | Good | Good | Good | Good |
| Sol 64 | Good | Good | Good | Good |
| Sol 65 | Good | Good | Good | Good |
| Sol 66 | Good | Good | Good | Good |
| Sol 67 | Good | Good | Good | Good |
| Sol 68 | Poor | Poor | - | Poor |
| Sol 69 | Poor | Poor | - | Poor |
| Sol 70 | Poor | Poor | - | Poor |
| Sol 71 | Poor | Poor | - | Poor |
| Sol 72 | Poor | Poor | - | Poor |
| Sol 73 | Poor | Poor | - | Poor |
| Sol 74 | Poor | Poor | - | Poor |

From the results of the above Tables 10 and 11, as Examples, silicon-containing compositions Sol-1 to -67, containing the polymers (P-1) to (P-24), being the component (B) of the present invention, had good results regarding all of filling property, flatness, pattern reversal, and nanoimprinting property. On the other hand, the silicon-containing compositions Sol-68 to -74, containing the comparative polymers (R-1) to (R-7), all had poor filling property, poor flatness, and poor nanoimprinting property, and it was not possible to evaluate pattern reversal.

The present description includes the following embodiments.
[1]: A silicon-containing composition, comprising:
   (A) a thermosetting silicon-containing resin having a weight-average molecular weight of 1,000 to 3,000; (B) a polymer having one or both of repeating units represented by the following general formulae (1) and (2); and (C) a solvent, 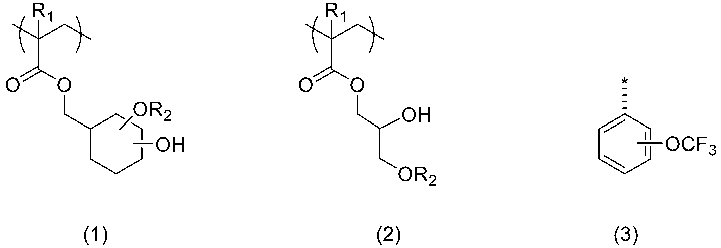
      wherein in the formula (1), R₁ represents a hydrogen atom or a methyl group, R₂ represents a saturated or unsaturated monovalent organic group having 2 to 50 carbon atoms and has at least one benzene ring structure represented by the formula (3) containing a trifluoromethoxy group as a substituent, and the substituents OR₂ and OH group on the cyclohexane ring are on adjacent carbon atoms on the cyclohexane ring,
      in the formula (2), R₁ represents a hydrogen atom or a methyl group, and R₂ represents a saturated or unsaturated monovalent organic group having 2 to 50 carbon atoms and has at least one benzene ring structure represented by the formula (3) including a trifluoromethoxy group as a substituent, and
      the formula (3) is a partial structure contained in the R₂ and optionally contains a substituent besides the trifluoromethoxy group, "*" represents an attachment point in a structure in the R₂, and two or more kinds of structures represented by the formula (3) or two or more identical structures represented by the formula (3) are optionally contained in the R₂.
[2]: The silicon-containing composition according to [1], wherein the R₂ in the general formulae (1) and (2) contains any of structures represented by the following formulae (4), 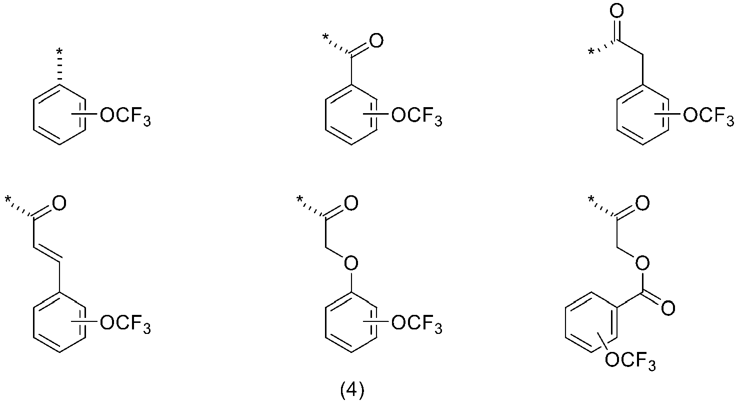 wherein "*" represents an attachment point in a structure in the R₂.
[3]: The silicon-containing composition according to [1] or [2], wherein (B) the polymer is a copolymer (B2) having repeating units of one or both of the general formulae (1) and (2) and the following (5), 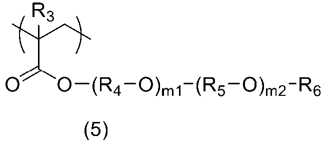 wherein R₃ represents a hydrogen atom or a methyl group; R₄ and R₅ each represent a linear or branched divalent alkylene group having 1 to 4 carbon atoms; R₆ represents a hydrogen atom, an alkyl group having 1 to 4 carbon atoms, or a phenyl group; and "m1" and "m2" each represent an integer of 0 to 23 and satisfy 23 ≥ m1+m2 ≥ 2.
[4]: The silicon-containing composition according to any one of [1] to [3], wherein (B) the polymer has a weight-average molecular weight of 1,500 to 30,000.
[5]: The silicon-containing composition according to any one of [1] to [4], wherein a weight percentage of (B) the polymer relative to (A) the thermosetting silicon-containing resin is 0.01 to 2%.
[6]: The silicon-containing composition according to any one of [1] to [5], further comprising (D) a curing catalyst.
[7]: The silicon-containing composition according to any one of [1] to [6], further comprising (E) an organic compound having a boiling point of 150°C or higher.
[8]: The silicon-containing composition according to [7], wherein a weight percentage of (E) the organic compound having a boiling point of 150°C or higher relative to (A) the thermosetting silicon-containing resin is 50 to 300%.
[9]: The silicon-containing composition according to any one of [1] to [8], wherein (C) the solvent contains water.
[10]: A patterning process comprising the steps of:
   (I) forming an organic underlayer film on a body to be processed;
   (II) forming a silicon-containing resist middle layer film on the organic underlayer film by using a composition for forming a silicon-containing resist middle layer film;
   (III) forming a resist upper layer film on the silicon-containing resist middle layer film by using a resist upper layer film composition comprising a photoresist composition;
   (IV) forming a circuit pattern in the resist upper layer film;
   (V) transferring the pattern to the silicon-containing resist middle layer film by etching while using the resist upper layer film having the formed circuit pattern as a mask;
   (VI) transferring the pattern to the organic underlayer film by etching while using the silicon-containing resist middle layer film having the transferred pattern as a mask;
   (VII) coating and filling the organic underlayer film having the transferred pattern by using the silicon-containing composition according to any one of [1] to [9]; and
   (VIII) removing unnecessary portions from a silicon-containing film formed in the step (VII), and then removing the organic underlayer film by etching to form a silicon-containing pattern.
[11]: A patterning process comprising the steps of:
   (I) forming an organic underlayer film on a body to be processed;
   (II) forming a silicon-containing resist middle layer film on the organic underlayer film by using a CVD method;
   (III) forming a resist upper layer film by using a resist upper layer film composition comprising a photoresist composition applied to the silicon-containing resist middle layer film;
   (IV) forming a circuit pattern in the resist upper layer film;
   (V) transferring the pattern to the silicon-containing resist middle layer film by etching while using the resist upper layer film having the formed circuit pattern as a mask;
   (VI) transferring the pattern to the organic underlayer film by dry etching while using the silicon-containing resist middle layer film having the transferred pattern as a mask;
   (VII) coating and filling the organic underlayer film having the transferred pattern by using the silicon-containing composition according to any one of [1] to [9]; and
   (VIII) removing unnecessary portions from a silicon-containing film formed in the step (VII), and then removing the organic underlayer film by etching to form a silicon-containing pattern.
[12]: A patterning process comprising the steps of:
   (I) coating and filling a pattern of a body to be processed covered with a metal nitride film by using the silicon-containing composition according to any one of [1] to [9];
   (II) partially removing unnecessary portions from a silicon-containing film formed in the step (I);
   (III) processing the body to be processed covered with the metal nitride film while using the silicon-containing film remaining as a mask; and
   (IV) removing the silicon-containing film remaining after substrate processing.
[13]: A patterning process comprising the steps of:
   (I) forming a pattern of an organic film by a nanoimprinting method on a body to be processed;
   (II) coating and filling the organic film having the pattern transferred by using the silicon-containing composition according to any one of [1] to [9];
   (III) removing unnecessary portions from a silicon-containing film formed in the step (II); and
   (IV) removing the organic film by etching to form a silicon-containing pattern on the body to be processed.
[14]: The patterning process according to any one of [10] to [13], wherein the body to be processed is a semiconductor device substrate, a metal film, a metal carbide film, a metal oxide film, a metal nitride film, a metal oxycarbide film, or a metal oxynitride film.
[15]: The patterning process according to any one of [10] to [14], wherein the metal constituting the body to be processed is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.
[16]: The patterning process according to any one of [10] to [15], wherein, in the step of forming the pattern in the resist upper layer film, the pattern is formed by using a lithography using light having a wavelength of 10 nm or more and 300 nm or less, a direct writing with electron beam, nanoimprinting, or a combination thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A silicon-containing composition, comprising:
(A) a thermosetting silicon-containing resin having a weight-average molecular weight of 1,000 to 3,000; (B) a polymer having one or both of repeating units represented by the following general formulae (1) and (2); and (C) a solvent, 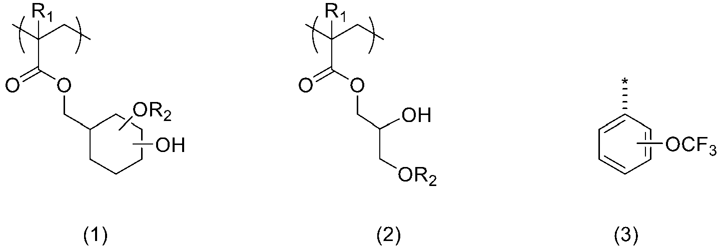
wherein in the formula (1), R₁ represents a hydrogen atom or a methyl group, R₂ represents a saturated or unsaturated monovalent organic group having 2 to 50 carbon atoms and has at least one benzene ring structure represented by the formula (3) containing a trifluoromethoxy group as a substituent, and the substituents OR₂ and OH group on the cyclohexane ring are on adjacent carbon atoms on the cyclohexane ring,
in the formula (2), R₁ represents a hydrogen atom or a methyl group, and R₂ represents a saturated or unsaturated monovalent organic group having 2 to 50 carbon atoms and has at least one benzene ring structure represented by the formula (3) including a trifluoromethoxy group as a substituent, and
the formula (3) is a partial structure contained in the R₂ and optionally contains a substituent besides the trifluoromethoxy group, "*" represents an attachment point in a structure in the R₂, and two or more kinds of structures represented by the formula (3) or two or more identical structures represented by the formula (3) are optionally contained in the R₂.

2. The silicon-containing composition according to claim 1, wherein the R₂ in the general formulae (1) and (2) contains any of structures represented by the following formulae (4), 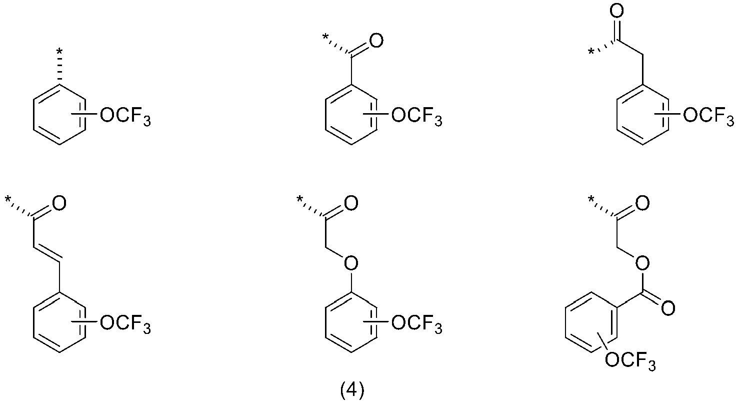 wherein "*" represents an attachment point in a structure in the R₂.

3. The silicon-containing composition according to claim 1 or 2, wherein (B) the polymer is a copolymer (B2) having repeating units of one or both of the general formulae (1) and (2) and the following (5), 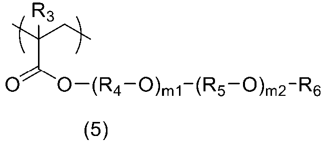 wherein R₃ represents a hydrogen atom or a methyl group; R₄ and R₅ each represent a linear or branched divalent alkylene group having 1 to 4 carbon atoms; R₆ represents a hydrogen atom, an alkyl group having 1 to 4 carbon atoms, or a phenyl group; and "m1" and "m2" each represent an integer of 0 to 23 and satisfy 23 ≥ m1+m2 ≥ 2.

4. The silicon-containing composition according to any one of claims 1 to 3, wherein (B) the polymer has a weight-average molecular weight of 1,500 to 30,000.

5. The silicon-containing composition according to any one of claims 1 to 4, wherein a weight percentage of (B) the polymer relative to (A) the thermosetting silicon-containing resin is 0.01 to 2%.

6. The silicon-containing composition according to any one of claims 1 to 5, further comprising (D) a curing catalyst.

7. The silicon-containing composition according to any one of claims 1 to 6, further comprising (E) an organic compound having a boiling point of 150°C or higher.

8. The silicon-containing composition according to claim 7, wherein a weight percentage of (E) the organic compound having a boiling point of 150°C or higher relative to (A) the thermosetting silicon-containing resin is 50 to 300%.

9. The silicon-containing composition according to any one of claims 1 to 8, wherein (C) the solvent contains water.

10. A patterning process comprising the steps of:
(I) forming an organic underlayer film on a body to be processed;
(II) forming a silicon-containing resist middle layer film on the organic underlayer film by using a composition for forming a silicon-containing resist middle layer film;
(III) forming a resist upper layer film on the silicon-containing resist middle layer film by using a resist upper layer film composition comprising a photoresist composition;
(IV) forming a circuit pattern in the resist upper layer film;
(V) transferring the pattern to the silicon-containing resist middle layer film by etching while using the resist upper layer film having the formed circuit pattern as a mask;
(VI) transferring the pattern to the organic underlayer film by etching while using the silicon-containing resist middle layer film having the transferred pattern as a mask;
(VII) coating and filling the organic underlayer film having the transferred pattern by using the silicon-containing composition according to any one of claims 1 to 9; and
(VIII) removing unnecessary portions from a silicon-containing film formed in the step (VII), and then removing the organic underlayer film by etching to form a silicon-containing pattern.

11. A patterning process comprising the steps of:
(I) forming an organic underlayer film on a body to be processed;
(II) forming a silicon-containing resist middle layer film on the organic underlayer film by using a CVD method;
(III) forming a resist upper layer film by using a resist upper layer film composition comprising a photoresist composition applied to the silicon-containing resist middle layer film;
(IV) forming a circuit pattern in the resist upper layer film;
(V) transferring the pattern to the silicon-containing resist middle layer film by etching while using the resist upper layer film having the formed circuit pattern as a mask;
(VI) transferring the pattern to the organic underlayer film by dry etching while using the silicon-containing resist middle layer film having the transferred pattern as a mask;
(VII) coating and filling the organic underlayer film having the transferred pattern by using the silicon-containing composition according to any one of claims 1 to 9; and
(VIII) removing unnecessary portions from a silicon-containing film formed in the step (VII), and then removing the organic underlayer film by etching to form a silicon-containing pattern.

12. A patterning process comprising the steps of:
(I) coating and filling a pattern of a body to be processed covered with a metal nitride film by using the silicon-containing composition according to any one of claims 1 to 9;
(II) partially removing unnecessary portions from a silicon-containing film formed in the step (I);
(III) processing the body to be processed covered with the metal nitride film while using the silicon-containing film remaining as a mask; and
(IV) removing the silicon-containing film remaining after substrate processing.

13. A patterning process comprising the steps of:
(I) forming a pattern of an organic film by a nanoimprinting method on a body to be processed;
(II) coating and filling the organic film having the pattern transferred by using the silicon-containing composition according to any one of claims 1 to 9;
(III) removing unnecessary portions from a silicon-containing film formed in the step (II); and
(IV) removing the organic film by etching to form a silicon-containing pattern on the body to be processed.

14. The patterning process according to any one of claims 10 to 13, wherein the body to be processed is a semiconductor device substrate, a metal film, a metal carbide film, a metal oxide film, a metal nitride film, a metal oxycarbide film, or a metal oxynitride film, and
prefereably wherein the metal constituting the body to be processed is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

15. The patterning process according to any one of claims 10 to 14, wherein, in the step of forming the pattern in the resist upper layer film, the pattern is formed by using a lithography using light having a wavelength of 10 nm or more and 300 nm or less, a direct writing with electron beam, nanoimprinting, or a combination thereof.
